# EUROPEAN PATENT APPLICATION

(11) **EP 4 827 024 A1**
(43) Date of publication of application: **21.10.2026**
(21) Application number: 25742260.0
(22) Date of filing: 17.01.2025
(51) Int. Cl.: H04L 1/00, H04L 1/20

(54) **METHOD AND DEVICE FOR ENCODING AND DECODING DATA IN COMMUNICATION OR BROADCASTING SYSTEM**

(30) Priority: 18.01.2024 KR 20240007949; 23.02.2024 KR 20240026737
(71) Applicant: Samsung Electronics Co., Ltd., Suwon-si, Gyeonggi-do 16677 (KR)
(72) Inventor: MYUNG, Seho, Suwon-si, Gyeonggi-do 16677 (KR); JANG, Min, Suwon-si, Gyeonggi-do 16677 (KR); LEE, Donghun, Suwon-si, Gyeonggi-do 16677 (KR); HAN, Donghwa, Suwon-si, Gyeonggi-do 16677 (KR)
(74) Representative: Gulde & Partner
(86) International application number: PCT/KR2025/000983
(87) International publication number: WO 2025/155121

(57) **Abstract**

The present disclosure relates to a method performed by a transmitter in a communication system, the method including: determining a number of input bits; determining a base matrix; determining a lifting size (Z) based on at least one of the number of the input bits or the base matrix; determining a parity check matrix based on at least one of the base matrix or the lifting size (Z); and determining an encoded bit by performing encoding based on the parity check matrix and the input bits, wherein the base matrix is one of a plurality of base matrices, the plurality of matrices having a same size, wherein a first base matrix and a second base matrix included in the plurality of base matrices include core matrices of different sizes, and wherein the core matrices include a submatrix corresponding to the input bits and a matrix corresponding to a part of parity bits in the base matrix.

## Description

### [Technical Field]

The present disclosure relates to a method and device for encoding and decoding data in a communication or broadcasting system.

### [Background Art]

Considering the development of wireless communication from generation to generation, the technologies have been developed mainly for services targeting humans, such as voice calls, multimedia services, and data services. Following the commercialization of 5G (5th-generation) communication systems, it is expected that the number of connected devices will exponentially grow. Increasingly, these will be connected to communication networks. Examples of connected things may include vehicles, robots, drones, home appliances, displays, smart sensors connected to various infrastructures, construction machines, and factory equipment. Mobile devices are expected to evolve in various form-factors, such as augmented reality glasses, virtual reality headsets, and hologram devices. In order to provide various services by connecting hundreds of billions of devices and things in the 6G (6th-generation) era, there have been ongoing efforts to develop improved 6G communication systems. For these reasons, 6G communication systems are referred to as beyond-5G systems.

6G communication systems, which are expected to be commercialized around 2030, will have a peak data rate of tera (1,000 giga)-level bps and a radio latency less than 100µsec, and thus will be 50 times as fast as 5G communication systems and have the 1/10 radio latency thereof.

In order to accomplish such a high data rate and an ultra-low latency, it has been considered to implement 6G communication systems in a terahertz band (for example, 95GHz to 3THz bands). It is expected that, due to severer path loss and atmospheric absorption in the terahertz bands than those in mmWave bands introduced in 5G, technologies capable of securing the signal transmission distance (that is, coverage) will become more crucial. It is necessary to develop, as major technologies for securing the coverage, radio frequency (RF) elements, antennas, novel waveforms having a better coverage than orthogonal frequency division multiplexing (OFDM), beamforming and massive multiple input multiple output (MIMO), full dimensional MIMO (FD-MIMO), array antennas, and multiantenna transmission technologies such as large-scale antennas. In addition, there has been ongoing discussion on new technologies for improving the coverage of terahertz-band signals, such as metamaterial-based lenses and antennas, orbital angular momentum (OAM), and reconfigurable intelligent surface (RIS).

Moreover, in order to improve the spectral efficiency and the overall network performances, the following technologies have been developed for 6G communication systems: a full-duplex technology for enabling an uplink transmission and a downlink transmission to simultaneously use the same frequency resource at the same time; a network technology for utilizing satellites, high-altitude platform stations (HAPS), and the like in an integrated manner; an improved network structure for supporting mobile base stations and the like and enabling network operation optimization and automation and the like; a dynamic spectrum sharing technology via collision avoidance based on a prediction of spectrum usage; an use of artificial intelligence (AI) in wireless communication for improvement of overall network operation by utilizing AI from a designing phase for developing 6G and internalizing end-to-end AI support functions; and a next-generation distributed computing technology for overcoming the limit of UE computing ability through reachable super-high-performance communication and computing resources (such as mobile edge computing (MEC), clouds, and the like) over the network. In addition, through designing new protocols to be used in 6G communication systems, developing mechahnisms for implementing a hardware-based security environment and safe use of data, and developing technologies for maintaining privacy, attempts to strengthen the connectivity between devices, optimize the network, promote softwarization of network entities, and increase the openness of wireless communications are continuing.

It is expected that research and development of 6G communication systems in hyper-connectivity, including person to machine (P2M) as well as machine to machine (M2M), will allow the next hyper-connected experience. Particularly, it is expected that services such as truly immersive extended reality (XR), high-fidelity mobile hologram, and digital replica could be provided through 6G communication systems. In addition, services such as remote surgery for security and reliability enhancement, industrial automation, and emergency response will be provided through the 6G communication system such that the technologies could be applied in various fields such as industry, medical care, automobiles, and home appliances.

### [Disclosure]

### [Technical Problem]

The present disclosure provides algebraic characteristics that a parity check matrix of a Low Density Parity Check (LDPC) code must satisfy to reduce decoding latency and lower encoding complexity. Additionally, it provides an efficient encoding and decoding method and device using an LDPC code having the algebraic characteristics.

The present disclosure provides algebraic characteristics that a parity check matrix of an LDPC code must satisfy to reduce the Block Error Rate (BLER). Additionally, it provides an efficient encoding and decoding method and device using an LDPC code having the algebraic characteristics.

The present disclosure provides algebraic characteristics that a parity check matrix of an LDPC code must satisfy to simultaneously reduce decoding latency, encoding complexity, and BLER by appropriately combining the algebraic characteristics. Additionally, it provides an efficient encoding and decoding method and device using an LDPC code having the combined algebraic characteristics.

The present disclosure provides a method for variably applying LDPC encoding bit puncturing to support a trade-off between coding performance and decoding latency. Additionally, it provides an efficient encoding and decoding method and device that supports the variable puncturing method.

### [Technical Solution]

A method for transmitting data by a base station or terminal in a communication system according to one embodiment of the present disclosure may include: performing LDPC encoding of data bits based on a base matrix and/or a parity check matrix; applying rate matching to the encoded bits; modulating the rate-matched encoded bits; and transmitting the modulated signal through a transmitting device, wherein a part of the data bits is excluded from or included in the encoded bits is variably determined according to a configuration of the system.

A method for receiving data by a base station or terminal in a communication system according to one embodiment of the present disclosure may include: receiving a modulated signal corresponding to at least a part of bits encoded through a receiving device; performing demodulation to determine values for decoding based on the received signal; performing LDPC decoding based on the determined values and a base matrix and/or a parity check matrix; and appropriately applying rate dematching to the LDPC decoded result; and determining data bits from the rate dematching, wherein a part of the data bits is excluded from or included in the encoded bits is variably determined according to a configuration of the system.

In a method performed by a transmitter in a communication system according to one embodiment of the present disclosure, the method includes: determining a number of input bits; determining a base matrix based on the number of the input bits; determining a lifting size (Z) based on at least one of the number of the input bits or the base matrix; determining a parity check matrix based on at least one of the base matrix or the lifting size (Z); determining an encoded bit by performing encoding based on the parity check matrix and the input bits; and transmitting at least a part of the encoded bits to a receiver, wherein, if a first configuration is indicated, a first length input bit of the input bits is not included in the encoding bit, and, if a second configuration is indicated, a second length input bit of the input bits is not included in the encoding bit, and the second length is 0 or smaller than the first length.

In a method performed by a receiver in a communication system according to one embodiment of the present disclosure, the method includes : receiving a signal corresponding to at least a part of encoded bits; determining a number of input bits based on the signal; determining a base matrix based on the number of the input bits; determining a lifting size (Z) based on at least one of the number of the input bits or the base matrix; determining a parity check matrix based on at least one of the base matrix or the lifting size (Z); and performing decoding of the signal based on the parity check matrix, wherein, if a first configuration is indicated, a first length input bit of the input bits is not included in the encoding bit, and, if a second configuration is indicated, a second length input bit of the input bits is not included in the encoding bit, and the second length is 0 or smaller than the first length.

A transmitting apparatus in a communication system according to one embodiment of the present disclosure includes a transmitter and a controller coupled with the transmitter and configured to: determine a number of input bits; determine a base matrix based on the number of the input bits; determine a lifting size (Z) based on at least one of the number of the input bits or the base matrix; determine a parity check matrix based on at least one of the base matrix or the lifting size (Z); determine an encoded bit by performing encoding based on the parity check matrix and the input bits; and transmit at least a part of the encoding bits to a receiver, wherein, if a first configuration is indicated, a first length input bit of the input bits is not included in the encoding bit, and, if a second configuration is indicated, a second length input bit of the input bits is not included in the encoding bit, and the second length is 0 or smaller than the first length.

A receiving apparatus in a communication system according to one embodiment of the present disclosure includes a receiver and a controller coupled with the transmitter and configured to: receive a signal corresponding to at least a part of encoded bits; determine a number of input bits based on the signal; determine the base matrix based on the number of the input bits; determine a lifting size (Z) based on at least one of the number of the input bits or the base matrix; determine a parity check matrix based on at least one of the base matrix or the lifting size (Z); and perform decoding of the signal based on the parity check matrix, wherein, if a first configuration is indicated, a first length input bit of the input bits is not included in the encoding bit, and, if a second configuration is indicated, a second length input bit of the input bits is not included in the encoding bit, and the second length is 0 or smaller than the first length.

A method performed by a transmitter in a communication system according to one embodiment of the present disclosure, the method includes: determining a number of input bits; determining the base matrix; determining a lifting size (Z) based on at least one of the number of the input bits or the base matrix; determining a parity check matrix based on at least one of the base matrix or the lifting size (Z); and determining an encoded bit by performing encoding based on the parity check matrix and the input bits, wherein the base matrix is one of a plurality of base matrices, the plurality of base matrices having a same size, wherein a first base matrix and a second base matrix included in the plurality of base matrices include core matrices of different sizes, and wherein the core matrices include a submatrix corresponding to the input bits and a matrix corresponding to a part of parity bits in the base matrix.

Additionally, a method performed by a receiver in a communication system according to one embodiment of the present disclosure, the method includes: receiving a signal corresponding to input bits; demodulating the signal to determine values for decoding; identifying a number of the input bits based on the signal; determining a base matrix; determining a lifting size (Z) based on at least one of the number of the input bits or the base matrix; determining a parity check matrix based on at least one of the base matrix or the lifting size (Z); and performing decoding based on the parity check matrix and the values, wherein the base matrix is one of a plurality of base matrices, the plurality of base matrices having a same size, wherein a first base matrix and a second base matrix included in the plurality of base matrices include core matrices of different sizes, and wherein the core matrices include a submatrix corresponding to the input bits and a matrix corresponding to a part of parity bits in the base matrix.

Additionally, a transmitter in a communication system according to one embodiment of the present disclosure includes a transceiver and controller coupled with the transceiver and configured to: determine a number of input bits; determine a base matrix; determine a lifting size (Z) based on at least one of the number of the input bits or the base matrix; determine a parity check matrix based on at least one of the base matrix or the lifting size (Z); and determine an encoded bit by performing encoding based on the parity check matrix and the input bits, wherein the base matrix is one of a plurality of base matrices, the plurality of base matrices having a same size, wherein a first base matrix and a second base matrix included in the plurality of base matrices include core matrices of different sizes, and wherein the core matrices include a submatrix corresponding to the input bits and a matrix corresponding to a part of parity bits in the base matrix.

Additionally, a receiver in a communication system according to one embodiment of the present disclosure includes a transceiver and a controller coupled with the transceiver and configured to: receive a signal corresponding to input bits; demodulate the signal to determine values for decoding; identify a number of the input bits based on the signal; determine a base matrix; determine a lifting size (Z) based on at least one of the number of the input bits or the base matrices; determine a parity check matrix based on at least one of the base matrix or the lifting size (Z); and perform decoding based on the parity check matrix and the values, wherein the base matrix is one of a plurality of base matrices, the plurality of base matrices having a same size and a first base matrix and a second base matrix included in the plurality of base matrices include core matrices of different sizes, and wherein the core matrices include a submatrix corresponding to input bits and a matrix corresponding to a part of parity bits in the base matrix.

### [Advantageous Effects]

The present disclosure applies a method that variably applies the puncturing of the data bits when determining the encoding bits. The present disclosure can support an efficient LDPC encoding method and device by enabling the variable application of a method that maximizes coding gain or minimizes decoding latency depending on the conditions of the system.

### [Description of Drawings]

FIG. 1 is a structural diagram of a systematic LDPC codeword.
FIG. 2 is a diagram illustrating the graph representation method of an LDPC code.
FIG. 3a is an example diagram illustrating the cycle characteristics of a QC-LDPC code.
FIG. 3b is an example diagram illustrating the cycle characteristics of a QC-LDPC code.
FIG. 4 is a transport block structure diagram according to one embodiment of the present disclosure.
FIG. 5 is an exemplary diagram of an LDPC encoding process according to one embodiment of the present disclosure.
FIG. 6 is an exemplary diagram of an LDPC decoding process according to one embodiment of the present disclosure.
FIG. 7 is a block diagram of a transmitting device according to one embodiment of the present disclosure.
FIG. 8 is a block diagram of a receiving device according to one embodiment of the present disclosure.
FIG. 9 is a structural diagram of an LDPC decoding unit according to one embodiment of the present disclosure.
FIG. 10 is an example diagram of the structure of the parity check matrix of an LDPC code.
FIG. 11a is an example of a parity check matrix for an LDPC code satisfying the characteristics proposed in the present disclosure.
FIG. 11b is an example of a parity check matrix for an LDPC code satisfying the characteristics proposed in the present disclosure.
FIG. 12a is an example diagram illustrating cycle characteristics in a submatrix of a parity check matrix for an LDPC code satisfying the characteristics proposed in the present disclosure.
FIG. 12b is an example diagram illustrating cycle characteristics in a submatrix of a parity check matrix for an LDPC code satisfying the characteristics proposed in the present disclosure.
FIG. 12c is an example diagram illustrating cycle characteristics in a submatrix of a parity check matrix for an LDPC code satisfying the characteristics proposed in the present disclosure.

### [Mode for Invention]

Hereinafter, preferred embodiments of the present disclosure are described in detail with reference to the accompanying drawings. Furthermore, in describing the present disclosure, if it is determined that a detailed description of related known functions or configurations might unnecessarily obscure the essence of the present disclosure, such detailed description is omitted. Additionally, the terms described below are defined considering their functions in the present disclosure, and these may vary depending on the intentions or practices of the user or operator. Therefore, their definitions should be based on the content throughout this specification.

The main gist of the present disclosure may be applied to other systems having a similar technical background with slight modifications without significantly departing from the scope of the present disclosure, which will be judgeable by those skilled in the art to which the present disclosure pertains. For reference, the term communication system generally includes the meaning of a broadcasting system, but in the present disclosure, if a broadcasting service is a major service among communication systems, it may be more clearly named a broadcasting system.

The advantages and features of the present disclosure and the methods for achieving them will become clear by referring to the embodiments described below in detail together with the accompanying drawings. However, the present disclosure is not limited to the embodiments disclosed below but may be implemented in various different forms. The embodiments provided are merely to ensure that the disclosure is complete and to fully inform those skilled in the art of the scope of the invention, and the present disclosure is defined only by the scope of the claims. Throughout the specification, the same reference numerals refer to the same components.

Low Density Parity Check (LDPC) codes, first introduced by Gallager in the 1960s, had long been forgotten because of the complexity that made implementation difficult with the technology available at the time. However, as the turbo code proposed by Berrou, Glavieux, and Thitimajshima in 1993 demonstrated performance approaching the channel capacity of Shannon, extensive analysis of the turbo code's performance and characteristics was conducted, leading to significant research on iterative decoding and graph-based channel coding. Consequently, LDPC codes were re-examined in the late 1990s, revealing that applying iterative decoding based on a sum-product algorithm on the Tanner graph corresponding to the LDPC code allows the LDPC code to achieve performance approaching the channel capacity of Shannon.

LDPC codes are generally defined as parity check matrices and can be represented using a bipartite graph commonly referred to as a Tanner graph. Generally, LDPC codes are a type of parity check code, and they are named 'low- density' parity check codes because they have a very low ratio of the number of 1s (i.e., density) in the parity check matrix for very long lengths. Therefore, for convenience, the techniques proposed in this disclosure based on LDPC codes can be easily extended to general parity check matrix codes.

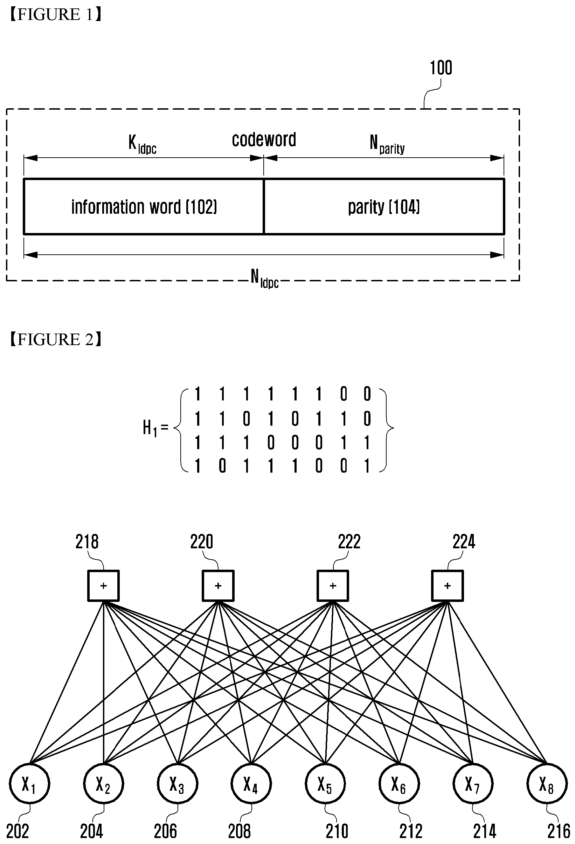

FIG. 1 is a diagram illustrating a structural diagram of a systematic LDPC codeword.

According to FIG. 1, the device where LDPC encoding is performed receives an information word 102 consisting of K_{ldpc} bits or symbols, performs encoding, and generates a codeword 100 consisting of N_{ldpc} bits or symbols. For convenience of explanation below, it is assumed that an information word 102 containing K_{ldpc} bits is received as input and a codeword 100 consisting of N_{ldpc} bits is generated. That is, when an information word ***i*** = (*i*₀, *i*₁, *i*₂, ... , *i*_{*K_{ldpc}*-1}) 102 consisting of K_{ldpc} input bits is encoded, a codeword ***c*** = (*c*₀, *c*₁, *c*₂, ... , *c*_{*N_{ldpc}*-1}) 100 is generated. That is, the information word and the codeword are bit sequences composed of a plurality of bits, and the information word bits and codeword bits refer to the respective bits constituting the information word and the codeword. Typically, when the LDPC encoding bits include information words like ***c*** = (*c*₀, *c*₁, *c*₂, ... , *c_{N_{ldpc}}*-₁) = (***i***, ***w***) = (*i*₀, *i*₁, *i*₂, ... , *i*_{*K_{ldpc}*-1}, *w*₀, *w*₁, *w*₂, ... , *w*_{*N_{ldpc-Kldpc}*-1}), it is called a systematic code. Here, ***w** =* [*w*₀ *w*₁ *w*₂ ... *w*_{*N_{ldpc-}K_{ldpc}*-1}] is a parity bit 104, and the number of parity bits N_{parity} can be represented as N_{parity} *=* N_{ldpc} - K_{ldpc}.

LDPC codes are a type of linear block code and include a process for determining a codeword that satisfies conditions such as Equation 1 below. [Equation 1] $H ⋅ {{c}_{¯}}^{T} = \left[{h}_{0} {h}_{1} {h}_{2} … {h}_{{N}_{ldpc} - 1}\right] ⋅ {{c}_{¯}}^{T} = {\sum }_{i = 0}^{{N}_{ldpc} - 1} {c}_{i} ⋅ {h}_{i} = {0}_{¯}$

Here, ***c** =* [*c*₀ *c*₁ *c*₂ ... *c*_{*N_{ldpc}*-1}]*.*

In Equation 1, H represents the parity check matrix, c represents the codeword, cᵢ represents the i-th bit of the codeword, N_{ldpc} represents the LDPC codeword length, and **h***ᵢ* represents the i-th column of the parity check matrix H.

The parity check matrix H consists of N_{ldpc} columns which are equal to the number of bits in the LDPC codeword. Since Equation 1 means that the sum of the products of the i-th column (**h***ᵢ*) of the parity check matrix and the i-th codeword bit cᵢ is 0, it means that the i-th column (**h***ᵢ*) is related to the i-th codeword bit cᵢ.

FIG. 2 is a diagram illustrating the graph representation method of an LDPC code.

With reference to FIG. 2, the graph representation method of an LDPC code will be explained.

FIG. 2 is a diagram illustrating an example of a parity check matrix H1 of an LDPC code consisting of 4 rows and 8 columns and a Tanner graph of it. With reference to FIG. 2, since the parity check matrix H1 has 8 columns, it generates a codeword of length 8, the code generated through H1 represents an LDPC code, and each column corresponds to 8 encoded bits.

With reference to FIG. 2, the Tanner graph of an LDPC code that is encoded and decoded based on a parity check matrix H1 consists of 8 variable nodes, namely x1 202, x2 204, x3 206, x4 208, x5 210, x6 212, x7 214 , and x8 216, and 4 check nodes 218, 220, 222, and 224. Here, the i-th column and j-th row of the parity check matrix H1 of the LDPC code correspond to the variable node xi and the j-th check node, respectively. Additionally, the value of 1 at the point where the i-th column and j-th row of the parity check matrix H1 of the LDPC code intersect, that is, the non-zero value, means that there exists an edge connecting the variable node xᵢ and the j-th check node on the Tanner graph as shown in FIG. 2.

In the Tanner graph of an LDPC code, the degree of a variable node and a check node represents the number of line segments connected to each node, which is equivalent to the number of non-zero entries in the column or row corresponding to the node in the parity check matrix of the LDPC code. For example, in FIG. 2, the degrees of the variable nodes x1 202, x2 204, x3 206, x4 208, x5 210, x6 212, x7 214, and x8 216 are 4, 3, 3, 3, 2, 2, 2, 2, respectively, and the degrees of the check nodes 218, 220, 222, and 224 are 6, 5, 5, 5, respectively. Additionally, the number of non-zero entries in each column of the parity check matrix H1 of FIG. 2 corresponding to the variable nodes of FIG. 2 corresponds to the degrees of the aforementioned variable nodes, 4, 3, 3, 3, 2, 2, 2, 2 in order, and the number of non-zero elements in each row of the parity check matrix H1 of FIG. 2 corresponding to the check nodes of FIG. 2 corresponds to the degrees of the aforementioned check nodes, 6, 5, 5, 5 in order. For this reason, the degree of each variable node is also called the column degree or column weight, and the degree of the check node is also called the row degree or row weight.

The LDPC encoded codeword bits can be decoded based on an iterative decoding algorithm based on a sum-product algorithm on the bipartite graph listed in FIG. 2. Here, the sum-product algorithm is a type of message passing algorithm, and a message passing algorithm represents an algorithm that exchanges messages through edges on a bipartite graph and updates output messages by calculating them from messages input to variable nodes or check nodes.

Here, the value of the i-th encoded bit can be determined based on the message of the i-th variable node. Both hard decision and soft decision methods are possible for determining the value of the i-th encoded bit. Therefore, the performance of cᵢ that is the i-th bit of an LDPC codeword corresponds to the performance of the i-th variable node of the Tanner graph, which can be determined by the position and number of 1s in the i-th column of the parity check matrix. In other words, the performance of the N_{ldpc} codeword bits can be influenced by the position and number of 1s in the parity check matrix, meaning that the performance of an LDPC code is significantly affected by the parity check matrix. Therefore, to design an LDPC code with excellent performance, a method for designing a good parity check matrix is required.

For ease of implementation, quasi-cyclic LDPC codes (or QC-LDPC codes, hereinafter referred to as QC-LDPC codes) are typically used for parity check matrices in communication and broadcasting systems. Depending on the communication and broadcasting system, there are cases where parity check matrices are used that are not completely quasi-cyclic but have a form similar to a quasi-cyclic structure. Although such LDPC codes may not be strictly classified as QC -LDPC codes algebraically, they are sometimes classified as QC-LDPC codes for convenience.

The conventional QC-LDPC codes are characterized by having a parity check matrix composed of zero matrices or circulant permutation matrices that take the form of small square matrices. Here, a circulant permutation matrix refers to a matrix in which each row or each column contains only one 1 and all other entries are 0. Additionally, a circulant permutation matrix refers to a matrix obtained by circularly shifting each entry of the identity matrix to the right or left. Generally, the identity matrix itself is also included in the circulant permutation matrix, as it is considered to have been circularly shifted zero times. Therefore, while the term circulant permutation matrix fundamentally includes the identity matrix, for the sake of convenience in explanation, the identity matrix and the circulant permutation matrix that is not the identity matrix may be distinguished.

Hereinafter, the QC-LDPC code is explained in detail.

First, as in Equation 2, a circulant permutation matrix *P =* (*P_{i,j}*) of size *Z* × *Z* is defined. Here *P_{i,j}* represents the entry in i-th row and j-th column of the matrix P. (0 ≤ *i, j* < *Z)* [Equation 2-1] ${P}_{i , j} = \left\{\begin{matrix}1 & if i + 1 ≡ j \left(mod Z\right) \\ 0 & otherwise .\end{matrix}\right.$

For a permutation matrix P defined as above, *Pⁱ*(0 ≤ i < Z) is a circulant permutation matrix obtained by circularly shifting each entry of the identity matrix of size *Z* × *Z* to the right by i times. A circulant permutation matrix can also be defined as in [Equation 2-2], in which case *Pⁱ* is a circulant permutation matrix obtained by circularly shifting each entry of the identity matrix of size *Z* × *Z* to the left by i times: [Equation 2-2] ${P}_{i , j} = \left\{\begin{matrix}1 & if i ≡ j + 1 \left(mod Z\right) \\ 0 & otherwise .\end{matrix}\right.$

In this disclosure, various embodiments are described using a circulant permutation matrix defined based on [Equation 2-1] for convenience. However, since the circulant permutation matrices defined in [Equation 2-1] and [Equation 2-2] have identical basic algebraic properties differing only in their notation, the circulant permutation matrix defined based on Equation 2-2 may be used in the embodiments of this disclosure. Alternatively, various types of circulant permutation matrices with identical algebraic properties can be used.

The parity check matrix H of the simplest QC-LDPC code can be expressed in the form of the following Equation 3. [Equation 3] $H = \left[\begin{matrix}{P}^{{V}_{1 , 1}} & {P}^{{V}_{1 , 2}} & ⋯ & {P}^{{V}_{1 , {n}_{b}}} \\ {P}^{{V}_{2 , 1}} & {P}^{{V}_{2 , 2}} & ⋯ & {P}^{{V}_{2 , {n}_{b}}} \\ ⋮ & ⋮ & ⋱ & ⋮ \\ {P}^{{V}_{{m}_{b} , 1}} & {P}^{{V}_{{m}_{b} , 2}} & ⋯ & {P}^{{V}_{{m}_{b} , {n}_{b}}}\end{matrix}\right]$

For convenience, if *P*⁻¹ is defined as a zero matrix of size *Z* × *Z*, each exponent *V_{i,j}* of the circulant permutation matrix or zero matrix in Equation 3 takes one of the values {-1, 0, 1, 2, ..., Z-1}. The identity matrix can be expressed as *P*⁰ or *I* and the zero matrix can be expressed as *P*⁻¹ or *O*. Additionally, since the parity check matrix H of the Equation 3 has *n_{b}* column blocks and *m_{b}* row blocks, the size of the parity check matrix H is *n_{b}Z* × *m_{b}Z.*

If the parity check matrix of Equation 3 has full rank, the length of the information word bits of the QC-LDPC code corresponding to the parity check matrix is (*n_{b}* - *m_{b}*)*Z*. For convenience, *k_{b} =* (*n_{b}* - *m_{b}*) column blocks corresponding to the information word bits can be called information word column blocks and the number of information word bits is *k_{b}Z* and *m_{b}* column blocks corresponding to the remaining parity bits can be called parity column blocks. In this case, the number of parity bits is *m_{b}Z.* For reference, if the parity check matrix of the Equation 3 does not have a maximum rank, the information word bit is larger than (*n_{b}* - *m_{b}*)*Z*, and the number of information word bits has a larger value than *k_{b}Z* and the number of parity bits has a smaller value than *m_{b}Z.*

Generally, the binary matrix of size *m_{b}* × *n_{b}* obtained by replacing each circulant permutation matrix and zero matrix with 1 and 0 respectively in the parity check matrix of Equation 3 is called the mother matrix, base matrix, or base graph of the parity check matrix H and is expressed as M(H) or **H**_{BG}. Additionally, the integer matrix of size *m_{b}* × *n_{b}* obtained as in Equation 4 by selecting the indices of each circulant permutation matrix or zero matrix is called the exponent matrix *V*(**H**) of the parity check matrix H. [Equation 4] $V \left(H\right) = \left[\begin{matrix}{V}_{1 , 1} & {V}_{1 , 2} & ⋯ & {V}_{1 , {n}_{b}} \\ {V}_{2 , 1} & {V}_{2 , 2} & ⋯ & {V}_{2 , {n}_{b}} \\ ⋮ & ⋮ & ⋱ & ⋮ \\ {V}_{{m}_{b} , 1} & {V}_{{m}_{b} , 2} & ⋯ & {V}_{{m}_{b} , {n}_{b}}\end{matrix}\right]$

Of course, the names of these matrices are merely examples, and the exponent matrix *V*(**H**) can be referred to by other names. For instance, since the indices of each circulant permutation matrix correspond to values that circularly shift the identity matrix as in [Equation 2-1] or [Equation 2-2], each exponent may be called shift values (or circular shift values), and *V*(**H**) may also be called the circular shift value matrix or shift value matrix. Generally, if a *Z* value corresponding to the size of the exponent matrix or shift value matrix and the circulant permutation matrix or zero matrix is given, the parity check matrix can be determined or identified. For this reason, according to the mathematical definition, a parity check matrix refers to a binary matrix H that satisfies the conditions of Equation 1, but in some cases, for convenience, an exponent matrix or a shift value matrix may be named as a parity check matrix.

Since a single integer included in the exponent matrix or the shift value matrix corresponds to a circulant permutation matrix in the parity check matrix, the exponent matrix may be expressed as a sequence of integers for convenience. Generally, the parity check matrix can be expressed not only as an exponent matrix but also as various sequences capable of expressing algebraically identical characteristics. In this disclosure, for convenience, the parity check matrix has been expressed as an exponent matrix or a sequence indicating the position of 1 within the parity check matrix; however, since there are various sequence notations capable of distinguishing the position of 1 or 0 included in the parity check matrix, it may be expressed in the form of various sequences or matrices that exhibit algebraically identical effects, not limited to the method expressed in this specification. To distinguish the sequence from other sequences, it may be referred to in various ways, such as an LDPC sequence, an LDPC code sequence, an LDPC sequence, a parity check matrix sequence, or a (circular) shift value sequence.

Additionally, while LDPC encoding and decoding can be performed by directly generating a parity check matrix in the transmitting and receiving device, depending on the implementation characteristics, LDPC encoding and decoding can also be performed based on an exponent matrix, a shift value matrix, or a sequence that produces the same effect algebraically as the parity check matrix. Therefore, although encoding and decoding using a parity check matrix are described in this disclosure for convenience, actual transmitting and receiving devices can implement encoding and decoding through various methods that can obtain the same effect as the parity check matrix.

For reference, the effect of being algebraically identical means that two or more different representations can be described as being perfectly identical to one another logically or mathematically, or that they can be transformed. Particularly in the case of codes that can be defined by matrices, such as LDPC codes, this may mean that algebraic values defined by matrices, such as minimum distance, rank, or cycle characteristics on a Tanner graph, are identical, and it may mean that the basic structure or operation is identical during the encoding/decoding process. For example, if the same matrix is obtained through appropriate column permutations and row permutations, the two matrices can be considered algebraically identical in terms of code. Additionally, various transposes that do not change the actual code characteristics can also provide the algebraically identical effect.

When the following matrix A is given as a specific example, examples of various transformations that provide the same algebraic effect are shown in A1 through A8.$A = \left[\begin{matrix}{P}^{{a}_{1 , 1}} & {P}^{{a}_{1 , 2}} & {P}^{{a}_{1 , 3}} & {P}^{{a}_{1 , 4}} \\ {P}^{{a}_{2 , 1}} & {P}^{{a}_{2 , 2}} & {P}^{{a}_{2 , 3}} & {P}^{{a}_{2 , 4}} \\ {P}^{{a}_{3 , 1}} & {P}^{{a}_{3 , 2}} & {P}^{{a}_{3 , 3}} & {P}^{{a}_{3 , 4}} \\ {P}^{{a}_{4 , 1}} & {P}^{{a}_{4 , 2}} & {P}^{{a}_{4 , 3}} & {P}^{{a}_{4 , 4}}\end{matrix}\right]$ ${A}_{1} = \left[\begin{matrix}{P}^{{a}_{1 , 1}} & {P}^{{a}_{1 , 3}} & {P}^{{a}_{1 , 2}} & {P}^{{a}_{1 , 4}} \\ {P}^{{a}_{2 , 1}} & {P}^{{a}_{2 , 3}} & {P}^{{a}_{2 , 2}} & {P}^{{a}_{2 , 4}} \\ {P}^{{a}_{3 , 1}} & {P}^{{a}_{3 , 3}} & {P}^{{a}_{3 , 2}} & {P}^{{a}_{3 , 4}} \\ {P}^{{a}_{4 , 1}} & {P}^{{a}_{4 , 3}} & {P}^{{a}_{4 , 2}} & {P}^{{a}_{4 , 4}}\end{matrix}\right] ,$${A}_{2} = \left[\begin{matrix}{P}^{{a}_{3 , 1}} & {P}^{{a}_{3 , 3}} & {P}^{{a}_{3 , 2}} & {P}^{{a}_{3 , 4}} \\ {P}^{{a}_{2 , 1}} & {P}^{{a}_{2 , 3}} & {P}^{{a}_{2 , 2}} & {P}^{{a}_{2 , 4}} \\ {P}^{{a}_{1 , 1}} & {P}^{{a}_{1 , 3}} & {P}^{{a}_{1 , 2}} & {P}^{{a}_{1 , 4}} \\ {P}^{{a}_{4 , 1}} & {P}^{{a}_{4 , 3}} & {P}^{{a}_{4 , 2}} & {P}^{{a}_{4 , 4}}\end{matrix}\right] ,$${A}_{3} = \left[\begin{matrix}{P}^{{a}_{1 , 1} + x} & {P}^{{a}_{1 , 2}} & {P}^{{a}_{1 , 3} + y} & {P}^{{a}_{1 , 4}} \\ {P}^{{a}_{2 , 1} + x} & {P}^{{a}_{2 , 2}} & {P}^{{a}_{2 , 3} + y} & {P}^{{a}_{2 , 4}} \\ {P}^{{a}_{3 , 1} + x} & {P}^{{a}_{3 , 2}} & {P}^{{a}_{3 , 3} + y} & {P}^{{a}_{3 , 4}} \\ {P}^{{a}_{4 , 1} + x} & {P}^{{a}_{4 , 2}} & {P}^{{a}_{4 , 3} + y} & {P}^{{a}_{4 , 4}}\end{matrix}\right] ,$${A}_{4} = \left[\begin{matrix}{P}^{{a}_{1 , 1} + x} & {P}^{{a}_{1 , 2}} & {P}^{{a}_{1 , 3} + y} & {P}^{{a}_{1 , 4}} \\ {P}^{{a}_{2 , 1} + x + z} & {P}^{{a}_{2 , 2} + z} & {P}^{{a}_{2 , 3} + y + z} & {P}^{{a}_{2 , 4} + z} \\ {P}^{{a}_{3 , 1} + x} & {P}^{{a}_{3 , 2}} & {P}^{{a}_{3 , 3} + y} & {P}^{{a}_{3 , 4}} \\ {P}^{{a}_{4 , 1} + x + w} & {P}^{{a}_{4 , 2} + w} & {P}^{{a}_{4 , 3} + y + w} & {P}^{{a}_{4 , 4} + w}\end{matrix}\right] ,$${A}_{5} = \left[\begin{matrix}{P}^{- {a}_{1 , 1}} & {P}^{- {a}_{2 , 1}} & {P}^{- {a}_{3 , 1}} & {P}^{- {a}_{4 , 1}} \\ {P}^{- {a}_{2 , 1}} & {P}^{- {a}_{2 , 2}} & {P}^{- {a}_{3 , 2}} & {P}^{- {a}_{4 , 2}} \\ {P}^{- {a}_{1 , 3}} & {P}^{- {a}_{2 , 3}} & {P}^{- {a}_{3 , 3}} & {P}^{- {a}_{4 , 3}} \\ {P}^{- {a}_{1 , 4}} & {P}^{- {a}_{2 , 4}} & {P}^{- {a}_{3 , 4}} & {P}^{- {a}_{4 , 4}}\end{matrix}\right] ,$${A}_{6} = \left[\begin{matrix}{P}^{{a}_{1 , 1}} & {P}^{{a}_{2 , 1}} & {P}^{{a}_{3 , 1}} & {P}^{{a}_{4 , 1}} \\ {P}^{{a}_{1 , 2}} & {P}^{{a}_{2 , 2}} & {P}^{{a}_{3 , 2}} & {P}^{{a}_{4 , 2}} \\ {P}^{{a}_{1 , 3}} & {P}^{{a}_{2 , 3}} & {P}^{{a}_{3 , 3}} & {P}^{{a}_{4 , 3}} \\ {P}^{{a}_{1 , 4}} & {P}^{{a}_{2 , 4}} & {P}^{{a}_{3 , 4}} & {P}^{{a}_{4 , 4}}\end{matrix}\right] ,$${A}_{7} = \left[\begin{matrix}{P}^{- {a}_{1 , 1}} & {P}^{- {a}_{1 , 2}} & {P}^{- {a}_{1 , 3}} & {P}^{- {a}_{1 , 4}} \\ {P}^{- {a}_{2 , 1}} & {P}^{- {a}_{2 , 2}} & {P}^{- {a}_{2 , 3}} & {P}^{- {a}_{2 , 4}} \\ {P}^{- {a}_{3 , 1}} & {P}^{- {a}_{3 , 2}} & {P}^{- {a}_{3 , 3}} & {P}^{- {a}_{3 , 4}} \\ {P}^{- {a}_{4 , 1}} & {P}^{- {a}_{4 , 2}} & {P}^{- {a}_{4 , 3}} & {P}^{- {a}_{4 , 4}}\end{matrix}\right] ,$${A}_{8} = \left[\begin{matrix}{P}^{{ka}_{1 , 1}} & {P}^{{ka}_{1 , 2}} & {P}^{{ka}_{1 , 3}} & {P}^{{ka}_{1 , 4}} \\ {P}^{{ka}_{2 , 1}} & {P}^{{ka}_{2 , 2}} & {P}^{{ka}_{2 , 3}} & {P}^{{ka}_{2 , 4}} \\ {P}^{{ka}_{3 , 1}} & {P}^{{ka}_{3 , 2}} & {P}^{{ka}_{3 , 3}} & {P}^{{ka}_{3 , 4}} \\ {P}^{{ka}_{4 , 1}} & {P}^{{ka}_{4 , 2}} & {P}^{{ka}_{4 , 3}} & {P}^{{ka}_{4 , 4}}\end{matrix}\right] ,$ (where *k* is a coprime integer with Z)

*A*₁ is an example of a block-unit permutation by swapping the second and third column blocks of *A. A*₂ is an example of a block-unit permutation by additionally swapping the first and third row blocks of *A*₁*. A*₃ is an example of applying a circulant permutation only to the first and third column blocks of *A*, respectively. *A*₄ is an example of applying a circulant permutation only to the second and fourth row blocks of *A*₃, respectively. *A*₅ is an example of applying a transpose to *A. A*₆ is an example of applying block-unit transpose to *A. A*₇ is an example where the signs of each exponent (or circular shift value) are reversed for *A* (however, for convenience, when representing zero matrix of size *Z* × *Z* as *P*⁻¹, (*-a_{i,j}*) may also be expressed as a positive value, such as (*Z* - *a_{i,j}*) since the usage of negative exponent (or shift value) can cause confusion). *A*₈ is an example of applying an affine transformation where the constant term is zero to *A* (generally, it can also be applied when the constant term is not zero). For reference, although the examples above, for convenience, described the case where *P^{a_{i,j}}* has no entries of zero matrix of size *Z* × *Z*, when a zero matrix is included, the part corresponding to the zero matrix is always a zero matrix regardless of the transformation. For example, if *P*^{*a*_{2,3}} is a zero matrix in *A*, then *P*^{*a*_{2,3}} is also a zero matrix in *A*₁, *A*₂; *A*₆, and *P*^{*a*_{2,3}+*y*} and *P*^{*a*_{2,3}+*y*+*z*}, respectively, in *A*₃ and *A*₄ are zero matrices; *P*^{*-a*_{2,3}} in *A*₅ and *A*₇ are zero matrices; and *P*^{*ka*_{2,3}} in *A*₈ is a zero matrix.

The transformations above are merely examples, and various other transformations may exist. Furthermore, while each transformation can be applied independently, they can also be applied in combination or overlap as appropriate. Here, the characteristic of each transformation or combination of transformations is that it can be transformed back into the original matrix through an appropriate invertible transformation process.

Since the various transformations or combinations of transformations mentioned above essentially involve a simple change in the arrangement of bits (or variable nodes) or check nodes on the Tanner graph, or these are reversible transformations in which symmetric transformations or specific structures are preserved, in terms of code performance, instantaneous performance may vary depending on the given channel conditions, but on average, identical performance can be provided. As such, in this disclosure, all parity check matrices obtained through transformations that achieve the same effect are considered to be the same parity check matrix.

Up to now, for convenience, although the case where there is only one circulant permutation matrix corresponding to a square block of size *Z* × *Z* has been described, the same invention can be applied to cases where a plurality of circulant permutation matrices are included in a single block. For example, when two circulant permutation matrices ${P}^{{V}_{ij}^{\left(1\right)}}$ and ${P}^{{V}_{ij}^{\left(2\right)}}$ correspond to the positions of a single i-th row block and j-th column block as shown in the following Equation 5, they can be simply expressed in the form of a sum such as ${P}^{{V}_{ij}^{\left(1\right)}} + {P}^{{V}_{ij}^{\left(2\right)}}$, and the exponent matrix (or circular shift value matrix) can be represented as shown in Equation 6. Looking at the above Equation 6, it can be seen that the i-th row and j-th column corresponding to the row block and column block containing the sum of the plurality of circulant permutation matrices are matrices in which two integers correspond. [Equation 5] $H = \left[{P}^{{V}_{i , j}^{\left(1\right)}}+{P}^{{V}_{i , j}^{\left(2\right)}}\right]$ [Equation 6] $V \left(H\right) = \left[\left({V}_{i , j}^{\left(1\right)}, {V}_{i , j}^{\left(2\right)}\right)\right]$

As in the embodiment, generally, in a QC-LDPC code, one or more circulant permutation matrices can correspond to one row block and one column block in the parity check matrix, and for reference, a matrix of a size *Z* × *Z* in which a plurality of circulant permutation matrices are duplicated within a single row block and column block is called a circulant matrix. Generally, circular matrices have entries that are not only binary numbers but also arbitrary numbers; however, since the present disclosure describes binary codes for convenience, the circulant matrix refers to a binary circulant matrix. Of course, the algebraic structures and characteristics proposed in the present disclosure can be extended in a similar manner to non-binary codes, but details are omitted in the present disclosure.

Meanwhile, the base matrix (or mother matrix or base graph) for the parity check matrix and exponent matrix (or circular shift value matrix) of the Equations 5 and 6 refers to a binary matrix obtained by replacing each circulant permutation matrix and zero matrix with 1 and 0, respectively, similar to the definition used in the Equation 3, and the circulant matrix included in one block (i.e., the sum of a plurality of circulant permutation matrices) can also be replaced with 1.

A simple example of the relationship between the parity check matrix, the exponent matrix (or circular shift matrix), and the base matrix is shown in the following [Equation 7]. [Equation 7] $\begin{matrix}{H}_{1} = \left[\begin{matrix}{P}^{159} & O & {P}^{0} & {P}^{0} & O & O \\ {P}^{117} & {P}^{109} & O & {P}^{0} & {P}^{0} & O \\ O & {P}^{225} & {P}^{1} & O & {P}^{0} & {P}^{0} \\ {P}^{84} & {P}^{211} & {P}^{0} & O & O & {P}^{0}\end{matrix}\right] \left(=\left[\begin{matrix}{P}^{159} & O & I & I & O & O \\ {P}^{117} & {P}^{109} & O & I & I & O \\ O & {P}^{225} & {P}^{1} & O & I & I \\ {P}^{84} & {P}^{211} & I & O & O & I\end{matrix}\right]\right) , \\ M \left({H}_{1}\right) = \left[\begin{matrix}1 & 0 & 1 & 1 & 0 & 0 \\ 1 & 1 & 0 & 1 & 1 & 0 \\ 0 & 1 & 1 & 0 & 1 & 1 \\ 1 & 1 & 1 & 0 & 0 & 1\end{matrix}\right] , \\ V \left({H}_{1}\right) = \left[\begin{matrix}159 & - 1 & 0 & 0 & - 1 & - 1 \\ 117 & 109 & - 1 & 0 & 0 & - 1 \\ - 1 & 225 & 1 & - 1 & 0 & 0 \\ 84 & 211 & 0 & - 1 & - 1 & 0\end{matrix}\right] .\end{matrix}$

In [Equation 7], the exponent of the zero matrix of size Z × Z (or the shift value) being denoted as -1 is merely an example and can be expressed in various ways. Furthermore, the matrix representation method of the [Equation 7] can be expressed through various other methods and, as a specific example, the representation method of the parity check matrix of an LDPC code defined in the 3GPP TS 38.212, a 3GPP 5G standard specification, can be used. In 3GPP TS 38.212, the parity check matrices of the LDPC codes corresponding to BG1 (Base Graph 1) and BG2 (Base Graph 2) are represented using tables because their sizes are too large, and applying this representation method to the matrices of the [Equation 7] yields the following [Table 1].

**H_{BG1}** is a matrix of size 4 × 8, and **H₁** is a matrix of size 4*Z* × 8*Z*. The entries of the base matrices (or base graphs) and parity check matrices not expressed in Table 1 below correspond to zero or to zero matrices of size *Z* × *Z.*

**[Table 1]**

| **H_{BG1}** | | ***V_{i,j}*** |
|---|---|---|
| Row index *i* | Column index *j* | |
| 0 | 0 | 159 |
| | 2 | 0 |
| | 3 | 0 |
| 1 | 0 | 117 |
| | 1 | 109 |
| | 3 | 0 |
| | 4 | 0 |
| 2 | 1 | 225 |
| | 2 | 1 |
| | 4 | 0 |
| | 5 | 0 |
| 3 | 0 | 84 |
| | 1 | 211 |
| | 2 | 0 |
| | 5 | 0 |

If the base matrix and exponent matrix in the [Equation 7] are expressed using a sequence, they can be represented in the following way.
*M*(**H₁**):
   023
   0 1 3 4
   1245
   0 125
*V*(**H₁**):
   15900
   117 109 0 0
   225 1 0 0
   84 211 0 0

As shown above, when the exponent matrix *V*(**H₁**) is expressed as a sequence, it can be named in various ways for convenience, such as a shift sequence, shift value sequence, or LDPC sequence. In the sequence representation above, *M*(**H₁**) represents the row-by-row listing of the column positions where the entries are non-zero, and *V*(**H₁**) represents the row-by-row listing of the exponent or shift values of each non-zero circulant permutation matrix. From the above sequences, the exponent matrix (or shift value matrix) can be precisely defined, and if information about the *Z* value is obtained, the parity check matrix can also be precisely defined.

Another simple example of the relationship between a parity check matrix, an exponent matrix (or circular shift value matrix), and base matrices is shown in the following [Equation 8]. The example in [Equation 8] illustrates a case where the parity check matrix contains a circulant matrix in which at least two or more circulant permutation matrices correspond to at least one *Z* × *Z* size block. [Equation 8] $\begin{matrix}{H}_{2} = \left[\begin{matrix}{P}^{117} + {P}^{159} & {P}^{109} & {P}^{0} & {P}^{0} \\ {P}^{84} & {P}^{211} + {P}^{225} & {P}^{1} + {P}^{3} & {P}^{0}\end{matrix}\right] , \\ M \left({H}_{2}\right) = \left[\begin{matrix}1 & 1 & 1 & 1 \\ 1 & 1 & 1 & 1\end{matrix}\right] , \\ V \left({H}_{2}\right) = \left[\begin{matrix}117 , 159 & 109 & 0 & 0 \\ 84 & 211 , 225 & 1 , 3 & 0\end{matrix}\right] , \\ W \left({H}_{2}\right) = \left[\begin{matrix}2 & 1 & 1 & 1 \\ 1 & 2 & 2 & 1\end{matrix}\right] .\end{matrix}$

For reference, in the [Equation 8], *W*(**H₂**) is a weight matrix for a base matrix, an exponent matrix, or a parity check matrix, and is a matrix that represents how many circulant permutation matrices correspond to the i-th row and j-th column of the base matrix or exponent matrix, or the i-th row block and j-th column block of the parity check matrix. For example, *W*(**H₂**) represents a matrix in which the entries of the i-th row and j-th column indicate the number of circulant permutation matrices constituting a circulant matrix of size *Z* × *Z* corresponding to the i-th row block and j- th column block of the parity check matrix. That is, *W*(**H₂**) is a matrix in which zero is represented as an entry when a zero matrix corresponds, and w is represented when w circulant permutation matrices correspond. (For reference, a zero matrix can be viewed as a circulant matrix in a broad sense, but it is not a circular 'permutation' matrix.)

The base matrix, the parity check matrix, or the circular shift value matrix (or exponent matrix) defined in [Equation 8] can be represented as shown in [Table 2] by applying the method of representing LDPC code parity check matrices in 3GPP TS 38.212 as in [Table 1].

**H_{BG2}** is a matrix of size 2 × 4, and **H₂** is a matrix of size 2*Z* × 4*Z*. The entries of the base matrices (or base graphs) and parity check matrices that are not represented in the following Table 2 correspond to zero or zero matrices of size *Z* × *Z.*

**[Table 2]**

| **H_{BG2}** | | ***V_{i,j}*** |
|---|---|---|
| Row index *i* | Column index *j* | |
| 0 | 0 | 117, 159 |
| | 1 | 109 |
| | 2 | 0 |
| | 3 | 0 |
| 1 | 0 | 84 |
| | 1 | 211, 225 |
| | 2 | 1, 3 |
| | 3 | 0 |

If the base matrix and exponent matrix of the [Equation 8] are expressed using a sequence, they can be represented in the following way.
*M*(**H₂**):
   0 1 2 3
   0 1 2 3
*V*(**H₂**):
   (117 , 159) 109 0 0
   84 (211, 225) (1, 3) 0

As another method of representation, it can also be expressed in a form consisting only of a sequence using a weight matrix as follows.
*M*(**H₂**):
   0 1 2 3
   0 1 2 3
*W*(**H₂**):
   2 1 1 1
   122 1
*V*(**H₂**):
   117 159 109 0 0
   84 211 225 1 3 0

In the above representation, *M*(**H₂**) is a method of listing the positions of columns where the entry is not zero for each row, and *W*(**H₂**) is a matrix defined based on the number of circulant permutation matrices that constitute the circular matrices corresponding to the base matrix, exponent matrix, or parity check matrix, and *V*(**H₂**) is a method of listing the exponent or shift values of each non-zero circulant matrix row by row. From the above sequences, the exponent matrix can be precisely defined, and if information about the Z value is obtained, the parity check matrix can also be precisely defined.

Since the performance of an LDPC code is determined by the parity check matrix, it is necessary to design a parity check matrix for an LDPC code with excellent performance. Additionally, an LDPC encoding or decoding method capable of supporting various input lengths and code rates is required.

Lifting may refer not only to a method used for the efficient design of QC-LDPC codes, but also to a method used to generate parity check matrices of various lengths or LDPC codewords using a given base matrix and an exponent matrix. That is, the lifting may refer to a method of efficiently designing a very large parity check matrix by configuring a value Z that determines the size of a circulant permutation matrix or a zero matrix from a given small mother matrix according to a specific rule, or to generate parity check matrices of various lengths or LDPC codewords by applying an appropriate Z value to a given exponent matrix or a corresponding sequence.

The existing lifting method and the characteristics of the QC-LDPC code designed through this lifting are briefly explained with reference to the following reference [Myung2006].

### Reference [Myung2006]

S. Myung, K. Yang, and Y. Kim, "Lifting Methods for Quasi-Cyclic LDPC Codes," IEEE Communications Letters. vol. 10, pp. 489-491, June 2006.

First, given an LDPC code C₀, let the S QC-LDPC codes to be designed through the lifting method be C₁, ..., C_{S}, and let the value corresponding to the size of the row block and column block of the parity check matrix of each QC-LDPC code be Lk. Here, C₀ corresponds to the smallest LDPC code that has the mother matrix of the C₁, ..., C_{S} codes as its parity check matrix and the Z₀ value corresponding to the size of the row and column blocks is 1. Additionally, for convenience, the parity check matrix **H*ₖ*** of each code Cₖ has exponent matrix $V \left({H}_{k}\right) = \left({V}_{ij}^{\left(k\right)}\right)$ of *m* × *n* size, and each exponent ${V}_{i , j}^{\left(k\right)}$ is selected from the values {-1, 0, 1, 2, ..., Zₖ - 1}.

The existing lifting method consists of steps such as C₀ -> C₁ -> ... -> C_{S} and has the characteristic of satisfying conditions such as Zₖ₊₁ = qₖ +₁Zₖ (where q_{k +}1 is a positive integer, k=0,1,..., S-1). Additionally, because of the characteristics of the lifting process, if only the parity check matrix **H*_{S}*** of C_{S} is stored, all of the above QC-LDPC codes C₀, C₁, ..., C_{S} can be represented using the following Equation 9 or Equation 10 depending on the lifting method. [Equation 9] $V \left({H}_{k}\right) ≡ \left⌊\frac{{Z}_{k}}{{Z}_{S}}V\left({H}_{S}\right)\right⌋$
or

[Equation 10] $V \left({H}_{k}\right) ≡ V \left({H}_{S}\right) \left(mod {Z}_{k}\right)$

Thus, the method of designing larger QC-LDPC codes C₁, ..., C_{S}, etc. from C₀, as well as the method of generating smaller codes Cᵢ(i = k-1, k-2, ..., 1, 0) from larger codes Ck using appropriate methods such as Equation 9 or Equation 10, can also be called lifting. For reference, in 3GPP TS 38.212, LDPC codes of various lengths can be generated using the lifting method of [Equation 10].

In the lifting method of the above Equation 9 or 10, as Zₖ which corresponds to the size of the row block or column block in the parity check matrix of each QC-LDPC code Cₖ has a multiple relationship with each other, the exponent matrix is also selected by a specific method. This existing lifting method helps to easily design QC-LDPC codes with improved error floor characteristics by improving the algebraic or graph characteristics of each parity check matrix designed through lifting.

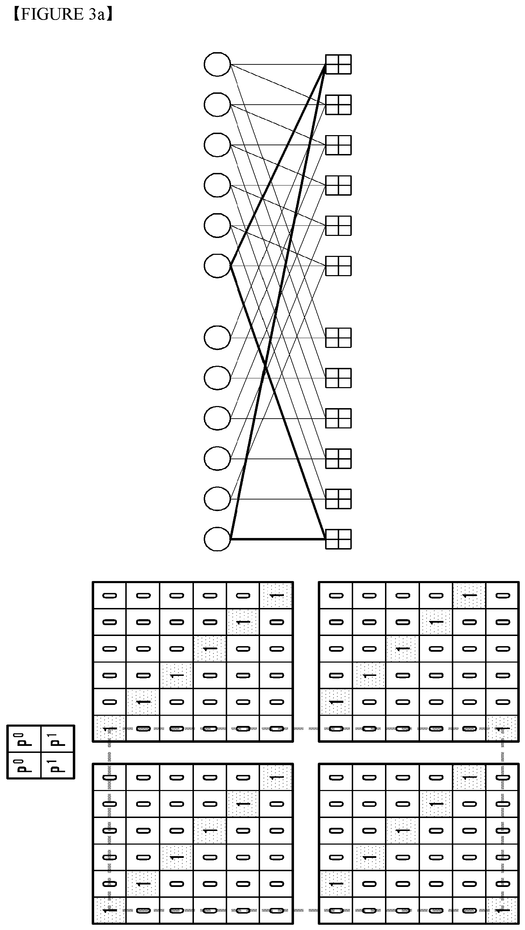

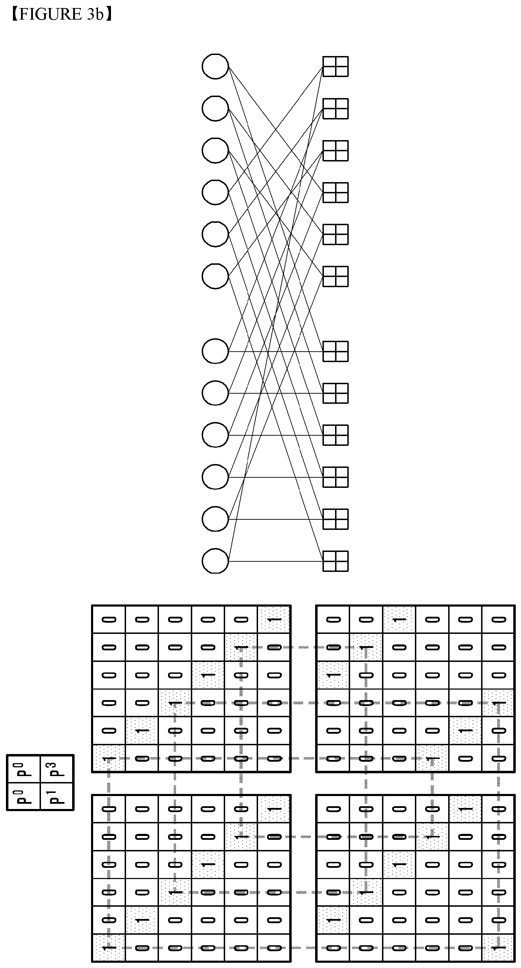

FIGS. 3a and 3b are example diagrams to briefly explain that cycle characteristics can vary significantly depending on the exponent matrix of the QC-LDPC code.

FIG. 3a is a diagram illustrating the cycle characteristics of the QC-LDPC code.

The exponent matrix of FIG. 3a is ${\left[\begin{matrix}{P}^{0} & {P}^{0} \\ {P}^{1} & {P}^{1}\end{matrix}\right]}_{\left(Z=6\right)}$, and in this case, there can be many 4-cycles on the Tanner graph. Codes with many such short cycles can cause serious degradation in decoding performance.

FIG. 3b is a diagram illustrating the cycle characteristics of the QC-LDPC code.

The exponent matrix of FIG. 3b is ${\left[\begin{matrix}{P}^{0} & {P}^{0} \\ {P}^{1} & {P}^{3}\end{matrix}\right]}_{\left(Z=6\right)}$, and in this case, the shortest cycle length on the Tanner graph is 12. As such, since changing just one exponent of the circulant permutation matrix can significantly alter the cycle characteristics on the Tanner graph, the selection of the exponent matrix plays an important role in improving the performance of LDPC codes. The lifting method can also be viewed as one of the design methods that consider these cycle characteristics.

Generally, lifting can be thought of as using the exponent matrix of Equation 4 for LDPC encoding and decoding by changing the values of its entries for various Z values. For example, let the exponent matrix of Equation 4 be denoted by *V*(***H***) = (*V_{i,j}*) and the exponent matrix transformed according to the Z value be denoted by *V*(***H***(*Z*)) = (*V_{i,j}*(*Z*)), generally, the transformation of Equation 11 can be applied. [Equation 11] ${V}_{i , j} \left(Z\right) = \left\{\begin{matrix}{V}_{i , j} & {V}_{i , j} < 0 \\ f \left({V}_{i , j}, Z\right) & {V}_{i , j} \geq 0\end{matrix}\right. or {V}_{i , j} \left(Z\right) = \left\{\begin{matrix}{V}_{i , j} & {V}_{i , j} \leq 0 \\ f \left({V}_{i , j}, Z\right) & {V}_{i , j} > 0\end{matrix}\right.$

In the Equation 11, *f*(*x*, *Z*) can be defined in various forms, for example, the [Equation 9] corresponds to $f \left(x, Z\right) = \left⌊\frac{Z}{{Z}_{max}}x\right⌋ \left({Z}_{max}={Z}_{S}\right)$, and the [Equation 10] can correspond to *f*(*x*, *Z*) = mod(x, Z) (mod(a,b) means the modulo-b operation on a). Additionally, in addition to that, *f*(*x*, *Z*) can be defined in various ways, as in the following Equation 12. [Equation 12] $\begin{matrix}f \left(x, Z\right) = mod \left(x{, 2}^{\left⌊{log}_{2}Z\right⌋}\right) \\ or \\ f \left(x, Z\right) = \left⌊\frac{x}{{2}^{D - \left⌊{log}_{2}Z\right⌋}}\right⌋ \\ or \\ f \left(x, Z\right) = \left⌊\frac{Z}{D}x\right⌋\end{matrix}$

In the Equation 12, D represents a constant that is a positive integer defined in advance.

For reference, in the transformation formula of the Equation 11, the reference value (or, the *V_{i,j}* reference value to distinguish the application of *V_{i,j}* and *f*(*V_{i,j}*, *Z*)) to which the transformation formula (or transformation function) f is applied is represented as 0 for convenience, but it may be set differently depending on the lifting size Z value to be supported or the method of representing the zero matrix of that *Z* × *Z* size. For example, if the zero matrix of *Z* × *Z* size is defined as a predetermined number or symbol other than the negative integer -1, the reference value for applying the transformation formula f may be defined differently. Additionally, in the representation of exponent matrices or LDPC sequences, if the method is based on excluding exponents corresponding to zero matrices from the outset, the rule for values where the exponent is less than zero in Equation 11 may be omitted. As transformation formula f applies to non-zero circulant permutation matrices or circular matrices, generally, various ways to omit transformations for zero matrix sizes *Z* × *Z* can be represented.

As an embodiment of the present disclosure, a case is described in which LDPC encoding and decoding are applied based on a plurality of exponent matrices or LDPC sequences based on a single fixed base matrix. That is, the base matrix is fixed as one, and an exponent matrix of an LDPC code, a (circular) shift value matrix, or an LDPC sequence defined based on the base matrix can be determined, and variable-length LDPC encoding and decoding are performed by applying lifting from the matrix or sequence according to the lifting size included in each lifting size group. This method is characterized in that the entries or numbers constituting the exponent matrix or LDPC sequence of the LDPC code may have different values, but the positions of the corresponding entries or numbers correspond exactly on the base matrix.

LDPC codes defined in TS 38.212, the 3GPP 5G standard, are also codes designed in this manner and two base matrices **H_{BG}** are defined and eight exponent matrices (or circular shift value matrices) for each base matrix $V \left({H}_{{i}_{LS}}\right) = \left({V}_{i , j}^{\left({i}_{LS}\right)}\right) \left({i}_{LS}=0,1,2,…,7\right)$ are defined, which can be used for LDPC encoding. That is, according to the standard specification, parity check matrices for various LDPC codes can be determined based on a total of 2 base matrices, 16 exponent matrices, and appropriate lifting sizes Z. However, in the TS 38.212 specification, the matrix corresponding to *V*(**H***_{i_{LS}}*) is named the parity check matrix, and the matrix corresponding to the standard parity check is named matrix-**H**. *V*(**H***_{i_{LS}}*) is a matrix consisting of integers and a parity check matrix in the strict sense can be constructed only if the lifting size *Z* is given, but as explained earlier, for convenience, *V*(**H***_{i_{LS}}*) can also be called a parity check matrix.

Hereinafter, for the sake of convenience of explanation, the LDPC codes and their representation methods defined in the 3GPP 5G standard TS 38.212 are used as much as possible; however, in some cases, they may be expressed using conventional mathematical expressions or other methods. First, to determine the parity check matrix or matrix-**H** of the LDPC code, the lifting size (Z) to be supported is shown in the following [Table 3]. (Set index for each lifting size set below *i_{LS}* is for illustrative purposes only and can be changed to a different order.

**[Table 3]**

| ***Set index (**i _{LS})* | ***Set of lifting sizes (Z)*** |
|---|---|
| 0 | {2, 4, 8, 16, 32, 64, 128, 256} |
| 1 | {3, 6, 12, 24, 48, 96, 192, 384} |
| 2 | {5, 10, 20, 40, 80, 160, 320} |
| 3 | {7, 14, 28, 56, 112, 224} |
| 4 | {9, 18, 36, 72, 144, 288} |
| 5 | {11, 22, 44, 88, 176, 352} |
| 6 | {13, 26, 52, 104, 208} |
| 7 | {15, 30, 60, 120, 240} |

In this disclosure, lifting sizes or block sizes are basically expressed in the manner of [Table 3], but they can also be expressed in the manner of [Table 4] below, and various other methods of expression are also possible.

**[Table 4]**

| ***Set index (**i _{LS)}* | ***Set of lifting sizes (Z)*** |
|---|---|
| 0 | 2 × 2*^{k}*, *k* = 0,1,2, ...,7 |
| 1 | 3 × 2*^{k}*, *k* = 0, 1, 2, ..., 7 |
| 2 | 5 × 2*^{k}*, *k* = 0, 1, 2, ... , 6 |
| 3 | 7 × 2*^{k}*, *k* = 0, 1, 2, *...* , 5 |
| 4 | 9 × 2*^{k}*, *k* = 0, 1, 2, ..., 5 |
| 5 | 11 × 2*^{k}*, *k* = 0,1,2,...,5 |
| 6 | 13 × 2*^{k}*, *k* = 0, 1, 2, ... , 4 |
| 7 | 15 × 2*^{k}*, *k* = 0, 1, 2, ... , 4 |

In 3GPP 5G, as shown in the [Table 3] or [Table 4], the lifting size or block size Z may be divided into a plurality of sets (or groups). (Hereafter, for convenience, they will be referred to as the lifting size set (or group) or block size set (or group).)

In 3GPP 5G standard, the parity check matrix or matrix-**H** is determined based on the exponent matrix *V* (**H***_{i_{LS}}*(*Z*)) ≡ *V*(**H***_{i_{LS}}*) (mod Z) to be obtained using the lifting method of [Equation 10]. This means ${V}_{i , j}^{\left({i}_{LS}\right)} \left(Z\right) = mod \left({V}_{i , j}^{\left({i}_{LS}\right)}, Z\right)$ for each i and j when $V \left({H}_{{i}_{LS}}\right) = \left({V}_{i , j}^{\left({i}_{LS}\right)}\right)$ and $V \left({H}_{{i}_{LS}}\left(Z\right)\right) = \left({V}_{i , j}^{\left({i}_{LS}\right)}\left(Z\right)\right)$. (For reference, in the 3GPP 5G standard specification TS 38.212, ${V}_{i , j}^{\left({i}_{LS}\right)} \left(Z\right)$ is simply expressed as *P_{i,j}*.)

As described earlier in [Equation 11], it should be noted that in this disclosure, no special transformation is applied to the parts corresponding to zero matrices of size *Z* × *Z* in the base matrix and exponent matrix. That is, even in *V*(**H***_{i_{LS}}*(*Z*)) ≡ *V*(**H***_{i_{LS}}*) (mod *Z*), unless otherwise specified, no special transformation is performed on the parts corresponding to zero matrices, and, depending on the Z value, only the size of the zero matrix may change. As a specific example, in the representation used in the 3GPP 5G standard specifications as shown in [Table 1] and [Table 2], the part corresponding to the zero matrix of size *Z* × *Z* is not indicated from the beginning. Therefore, if a predefined transformation, such as modulo, is appropriately performed only on the parts *V_{i,j}* included in [Table 1] or [Table 2], the part corresponding to the zero matrix is naturally not transformed, which is equivalent to defining a zero matrix with only a different size. The above representation is merely an example for the convenience of explanation, and various other representations may exist.

Since the parity check matrix or matrix-**H** for a given exponent matrix (or circular shift value matrix) can be transformed in various ways according to the lifting sizes defined in [Table 3], the required set of lifting sizes may be defined differently depending on the system. That is, [Table 3] and [Table 4] are merely examples, and all lifting size (Z) values included in the [Table 3] and [Table 4] lifting size (or block size) group (or set) may be used, or a portion of the appropriate lifting sizes may be selected and used depending on the situation required by the system, and more diverse lifting size values may be added as needed.

For example, when the minimum value of the transport block size (TBS) is 24, Z = 2, 3, 4, 5, 6, 9, 13 are practically never used in the system. In this case, it can be defined by excluding some Z values as shown in [Table 5] below.

**[Table 5]**

| ***Set index (**i _{LS)}* | ***Set of lifting sizes (Z)*** |
|---|---|
| 0 | {8, 16, 32, 64, 128, 256} |
| 1 | {12, 24, 48, 96, 192, 384} |
| 2 | {10, 20, 40, 80, 160, 320} |
| 3 | {7, 14, 28, 56, 112, 224} |
| 4 | {18, 36, 72, 144, 288} |
| 5 | {11, 22, 44, 88, 176, 352} |
| 6 | {26, 52, 104, 208} |
| 7 | {15, 30, 60, 120, 240} |

In an LDPC code-based communication system that applies [Table 5] as the lifting size, since the minimum lifting size is 7, each column block constituting the parity check matrix of the LDPC code used for LDPC encoding and decoding can be composed of at least 7 columns.

If the minimum value of TBS is 8 or higher for future scalability and additional values such as 8, 16, etc. are used, the lifting size set (or block size group) may be changed as shown in the following [Table 6].

**[Table 6]**

| ***Set index (**i _{LS)}* | ***Set of lifting sizes (Z)*** |
|---|---|
| 0 | {4, 8, 16, 32, 64, 128, 256} |
| 1 | {6, 12, 24, 48, 96, 192, 384} |
| 2 | {(5,) 10, 20, 40, 80, 160, 320} |
| 3 | {7, 14, 28, 56, 112, 224} |
| 4 | {(9,) 18, 36, 72, 144, 288} |
| 5 | {11, 22, 44, 88, 176, 352} |
| 6 | {(13,) 26, 52, 104, 208} |
| 7 | {15, 30, 60, 120, 240} |

The [Table 6] excludes only the cases where Z = 2 or 3 from the [Table 3] or [Table 4] and it is because the minimum Z value that can be determined when TBS is 8 or higher is 4 or higher.

As another example of configuring a lifting size set, if the lifting size set is classified into A sets *Z*₁, *Z*₂, *Z*₃, ...*Z_{A}*, it can basically be classified in the following way. (*k =* 1, 2, ...) ${Z}_{1} = \left\{A,2A,…{, 2}^{k}A\right\}$ ${Z}_{2} = \left\{\left(A+1\right),2\left(A+1\right),…{, 2}^{k}\left(A+1\right)\right\}$ ... ${Z}_{i} = \left\{\left(A+i-1\right),2\left(A+i-1\right),…{, 2}^{k}\left(A+i-1\right)\right\}$ ... ${Z}_{A} = \left\{2A-1,2\left(2A-1\right),…{, 2}^{k}\left(2A-1\right)\right\}$

For example, the following are examples for the cases where A = 4 and A = 8 can be represented as in the following [Table 7-1] and [Table 7-2]. (k = 0, 1, 2, ...)

**[Table 7-1]**

| ***Set of lifting sizes (Z)*** |
|---|
| 4, 8, 16, 32, ...(= 4 × 2*^{k}*) |
| 5, 10, 20, 40, ...(= 5 × 2*^{k}*) |
| 6, 12, 24, 48, ...(= 6 × 2*^{k}*) |
| 7, 14, 28, 56, ...(= 7 × 2*^{k}*) |

**[Table 7-2]**

| ***Set of lifting sizes (Z)*** |
|---|
| 8, 16, 32, 64, ...(= 8 × 2*^{k}*) |
| 9, 18, 36, 72, ...(= 9 × 2*^{k}*) |
| 10, 20, 40, 80, ...(= 10 × 2*^{k}*) |
| 11, 22, 44, 88, ...(= 11 × 2*^{k}*) |
| 12, 24, 48, 96, ...(= 12 × 2*^{k}*) |
| 13, 26, 52, 108, ...(= 13 × 2*^{k}*) |
| 14, 28, 56, 112, ...(= 14 × 2*^{k}*) |
| 15, 30, 60, 120, ...(= 15 × 2*^{k}*) |

If the lifting size sets are defined in the manner shown in the [Table 7-1] and [Table 7-2] , there is an advantage in that the distribution of Z values can be configured relatively uniformly. The lifting size sets defined in the [Table 7-1] and [Table 7-2] all have the same number of Z values, but appropriate Z values may be added or subtracted for each set as needed. For example, it is possible to define the lifting size sets of the [Table 3] through [Table 6] based on the lifting size set of the [Table 7-2].

Additionally, Z values suitable for the system can also be configured by appropriately configuring the range of *k* value in [Table 7-1] and [Table 7-2]. For example, if the *k* value is configured to *k* = 0, 1, ..., 6, a set of lifting sizes in which the number of distinct Z values in each set is 7 is obtained, and if the *k* value is configured to *k* = 3, 4, ... , 6, a set of lifting sizes in which the number of distinct Z values in each set is 4 is obtained. However, the *k* value is an example, and one example of a *k* value does not limit the scope of the rights of the present disclosure. Additionally, in some cases, it is also possible to add or exclude some suitable Z values in the lifting size sets. For example, if the maximum value of Z set in the system is Zmax, all values greater than Zmax can be removed (e.g. Zmax = 768). Additionally, if all Z values supported in the existing 3GPP 5G standard are included, at least some of the values such as 2, 3, 4, 5, 6, and 7 may also be included. Of course, even if additional values such as TBS = 8, 16 are supported in 5G or 6G systems, values such as Z = 2, 3 are not used, so only values such as 4, 6, 7 or 4, 5, 6, 7 may be further included, and values that are not actually used in 5G may be excluded. Specific examples of the lifting size sets are shown in the following [Table 8]. (In Table 8, the numbers in parentheses represent values that may or may not be used as lifting sizes.)

**[Table 8]**

| ***Set index (**i _{LS)}* | ***Set of lifting sizes (Z)*** |
|---|---|
| 0 | {(2, 4,) 8, 16, 32, 64, 128, 256, 512} |
| 1 | {(3, 6,) 12, 24, 48, 96, 192, 384, 768} |
| 2 | {(5,) 10, 20, 40, 80, 160, 320, 640} |
| 3 | {7, 14, 28, 56, 112, 224, 448(, 896)} |
| 4 | {(9,) 18, 36, 72, 144, 288, 576} |
| 5 | {11, 22, 44, 88, 176, 352, 704} |
| 6 | {(13,) 26, 52, 104, 208, 416(, 832)} |
| 7 | {15, 30, 60, 120, 240, 480(, 960)} |

The lifting size sets may be defined in various ways in addition to [Table 3] through [Table 8], but a common characteristic is that each of the plurality of lifting size sets must not have any overlapping lifting sizes, and the lifting sizes included in each lifting size set must be multiples or divisors of each other. The [Table 3] through [Table 8] are composed of consecutive 2*^{k}* (*k* = 0, 1, 2, ...) multiples for the smallest lifting size in each lifting size set, but, generally, it is possible to be composed of discontinuous multiples as 2*^{k}* (*k* = 0, 1, 3, 5, ...), and multiples of integers other than multiples of 2.

In the new communication systems including 6G systems, to support backward compatibility with existing systems (e.g., 5G systems), the existing set of lifting sizes may be maintained as is (e.g., [Table 3] or [Table 4]), and a new set of lifting sizes may be added (e.g., [Tables 5] through [Table 8]). Alternatively, the set of lifting sizes may be defined as a single unit, but if the range of TBS used is determined differently in advance according to system configurations such as application scenarios or target BLER, the range of Z values used will also vary. For example, if the first minimum TBS and first maximum TBS values are configured for a service applying the first target BLER, and the second minimum TBS and/or second maximum TBS values are defined for a service applying the second target BLER, then the values of the first minimum TBS and the second minimum TBS may differ, or the values of the first maximum TBS and the second maximum TBS may differ (both the minimum and maximum values may differ).

Additionally, applicable service scenarios or target BLERs, etc., may be determined based on higher layer signaling information. For example, channel quality information (CQI ) tables or modulation coding scheme (MCS) tables can typically be determined by considering target service scenarios or BLERs. (e.g., the first target service or BLER is the first CQI table and/or the first MCS table, the second target service or BLER is the second CQI table and/or 2nd MCS table, and the third target service or BLER is the third CQI table and/or third MCS table, ...)

Consequently, this implies that the range of lifting sizes to be used or the set of lifting sizes to be used may be determined from the higher layer signaling information, and the intermediate operation may vary depending on the system. Furthermore, the set of lifting sizes to be used can be indicated through physical layer signaling or higher layer signaling. A parity check matrix can be determined based on the set of lifting sizes specified in this way and the determined lifting size Z value.

For reference, in the present invention, target BLER refers to the minimum BLER to be achieved in the system, and, typically, the average BLER of the terminal or base station is configured so that it does not exceed the target BLER.

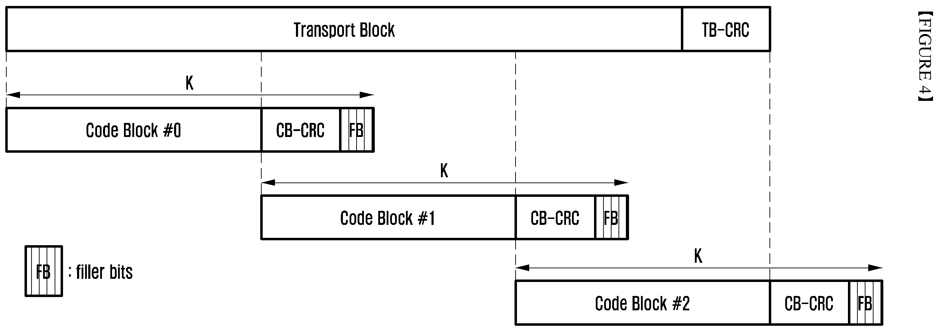

FIG. 4 is a transport block structure diagram according to one embodiment of the present disclosure.

With reference to FIG. 4, a CRC bit (TB-CRC bit) of L bit is added to a transport block composed of A bits, and one transport block can become one code block. Additionally, if the value B = A + L is greater than a specific threshold, it may be divided into a plurality of code blocks through an appropriate segmentation process. In this case, the size K of all code blocks is the same, and to achieve this, a null bit is applied to each code block. Alternatively, specific bits called null bits or filler bits may be added. The null bits or filler bits typically correspond to a value of 0, but they are not necessarily limited to this and can be configured with any specific bits determined in advance. The operation of adding predetermined bits such as null bits or filler bits in this way is commonly called shortening because it reduces the size of the actual pure information word bits, and if the values are 0, it may be called zero-padding.

After the size of the transport block to be transmitted (TBS, transport block size) is determined, one of two different LDPC code base matrices used for LDPC encoding or decoding can be determined based on the TBS size and the code rate indicated in the MCS through a method such as the [Base matrix determination method] below.

### [Base matrix determination method]

The LDPC base matrix for LDPC encoding and decoding of a transport block with TBS = A may be determined based on the TBS size and the code rate indicated by the MCS as follows:

In the case that A ≤ 292 (or 288) or, A ≤ 3824 and R ≤ 0.67 or, R ≤ 0.25, LDPC encoding can be performed using LDPC base matrix 2.

Otherwise, LDPC encoding can be performed using LDPC base matrix 1. For reference, the base matrix 1 *M*(**H_{BG1}**) and the base matrix 2 *M*(**H_{BG2}**) defined in the 3GPP 5G standard are as follows.
*M*(**H_{BG1}**):
   0 1 2 3 5 6 9 10 11 12 13 15 16 18 19 20 21 22 23
   0 2 3 4 5 7 8 9 11 12 14 15 16 17 19 21 22 23 24
   0 1 2 4 5 6 7 8 9 10 13 14 15 17 18 19 20 24 25
   0 1 3 4 6 7 8 10 11 12 13 14 16 17 18 20 21 22 25
   0 1 26
   0 1 3 12 16 21 22 27
   0 6 10 11 13 17 18 20 28
   0 1 4 7 8 14 29
   0 1 3 12 16 19 21 22 24 30
   0 1 10 11 13 17 18 20 31
   12478 1432
   0 1 12 16 21 22 23 33
   0 1 10 11 13 1834
   0 3 7 20 23 35
   0 12 15 16 17 21 36
   0 1 10 13 18 25 37
   1 3 11 20 22 38
   0 14 16 17 21 39
   1 12 13 18 1940
   0 1 7 8 10 41
   0 3 9 11 22 42
   1 5 16 20 21 43
   0 12 13 1744
   12101845
   0 3 4 11 22 46
   1 6 7 14 47
   0 2 4 15 48
   1 6 8 49
   0 4 19 21 50
   1 14 18 25 51
   0 10 13 24 52
   1 7 22 25 53
   0 12 14 24 54
   1 2 11 21 55
   07151756
   16122257
   0 14 15 18 58
   1 13 23 59
   0 9 10 12 60
   1 3 7 19 61
   0 8 17 62
   1 3 9 18 63
   042464
   1 16 18 25 65
   0 7 9 22 66
   1 6 10 67
*M*(**H_{BG2}**):
   0123691011
   0 3 4 5 6 7 8 9 11 12
   0 1 3 4 8 10 12 13
   1 2 4 5 6 7 8 9 10 13
   0 1 11 14
   0 1 5 7 11 15
   0 5 7 9 11 16
   157111317
   0 1 12 18
   18101119
   0 16720
   0 7 9 13 21
   1 3 11 22
   0 1 8 13 23
   1 6 11 13 24
   0 10 11 25
   1 9 11 12 26
   1 5 11 12 27
   06728
   0 1 10 29
   1 4 11 30
   081331
   1232
   0 3 5 33
   12934
   0535
   2 7 12 13 36
   0637
   1 2 5 38
   0439
   2 5 7 9 40
   1 13 41
   0 5 12 42
   2 7 10 43
   0 12 13 44
   1 5 11 45
   0 2 7 46
   10 13 47
   1 5 11 48
   0 7 12 49
   2 10 13 50
   1 5 11 51

The sizes of base matrix 1 *M*(**H_{BG1}**) and base matrix 2 *M*(**H_{BG2}**) are 46×68 and 42×52, respectively, and the sizes of the parity check matrices determined from the base matrices are 46Z × 68Z and 42Z × 52Z.

Additionally, the number of CRC bits (L_{TB}) to be added to the transport block can be determined as follows according to the determined TBS.

### [Method for determining the number of transport block CRC bits]

The CRC bit size L_{TB} value for a transport block with TBS = A can be configured differently depending on the TBS value as follows.${L}_{TB} = 24 for A > 3824 , otherwise {L}_{TB} = 16 .$

According to the TBS size A determined in this way or the total number of bits B = A + L where the CRC is appended to the transport block, an appropriate code block can be determined from the transport block, and LDPC encoding and decoding can be performed for each code block. The process of determining the code block size (CBS) at this point can be explained in more detail as follows:

### [CBS determination method]

Input bit sequence for code block segmentation can be expressed as b₀, b₁, ... , b_{B-1}. (B > 0). If B is larger than the maximum code block size K_{cb}, segmentation of the input bit sequence is performed, and L = 24-bit CRC is additionally appended to each code block. For the LDPC base matrix 1, the maximum code block size is K_{cb} = 8448, and for the LDPC base matrix 2, the maximum code block size is K_{cb} = 3840.

The specific steps are explained as follows.

Step 1: The number of code blocks C can be determined.

If *B* ≤ *K_{cb}, L =* 0, *C* = 1, and *B'* = *B.*

Otherwise, *L* = 24, $C = \left⌈B/\left({K}_{cb}-L\right)\right⌉$, and *B'* = *B* + *C* × *L.*

Step 2: Let the bit outputs from code block segmentation be cᵣ₀, cᵣ₁, ... , cr_{(Kr - 1)}, where r represents the code block number (0 ≤ r < C), Kr (= K) can mean the number of bits of a code block for code block number r. Here, K, the number of bits included in each code block, can be calculated as follows:
$K ′ = B ′ / C ;$

In the case of LDPC base matrix 1, *K_{b}* = 22.

In the case of the LDPC base matrix 2,
If *B* > 640, *K_{b}* = 10;
If 560 < *B* ≤ 640, *K_{b}* = 9;
If 192 < *B* ≤ 560, *K_{b}* = 8;
If *B* ≤ 192, *K_{b}* = 6.

Step 3: Among the Z values in Table 3, the minimum value *Z_{c}* that satisfies *K_{b}* · *Z_{c}* ≥ *K'* can be determined. *K* = 22*Z_{c}* is configured for LDPC base matrix 1, and *K* = 10*Z_{c}* is configured for LDPC base matrix 2.

The *K_{b}* value in step 2 of the [CBS determination method] can correspond to the maximum value of the LDPC information word bit (= *K_{b}Z_{c}*) without shortening or zero padding as a value corresponding to the column or column block corresponding to the LDPC information word bit in the base matrix (or base graph) or the parity check matrix of the LDPC code. For example, even if the number of columns (or column blocks) corresponding to information word bits in the LDPC base matrix 2 or the parity check matrix corresponding to base matrix 2 is 10, if *K_{b}* = 6 is configured, it means that substantially LDPC encoding/decoding for the information word bits of maximum 6*Z_{c}* bits is performed, and the information word bits corresponding to at least (10 - *K_{b}*)*Z_{c} =* 4*Z_{c}* columns in the parity check matrix are shortened or zero-padded. Here, shortening or zero padding may mean that the transmitter and receiver assign agreed-upon bit values, such as 0, and it may mean not using that part in the parity check matrix.

The lifting size Z value for LDPC encoding and decoding can be determined based on the lifting size sets shown in [Table 3] through [Table 8] or specific lifting size values added and removed from the lifting size sets. Each Z value is included in a specific set determined in advance according to index i_{LS}, and when a Z value is determined in Step 3 of the [CBS determination method], the set or the index i_{LS} value of the set corresponding to that Z value is determined, and the parity check matrix of the LDPC code corresponding to each index or the corresponding sequence can also be determined. By applying a modulo operation based on the lifting size Z to the LDPC code parity check matrix or the corresponding sequence determined in this way, the parity check matrix or sequence is transformed to support the encoding and decoding of LDPC codes of various lengths. In the 3GPP 5G standard as well, each number included in the parity check matrix or sequence of the LDPC code means a value corresponding to the circulant permutation matrix.

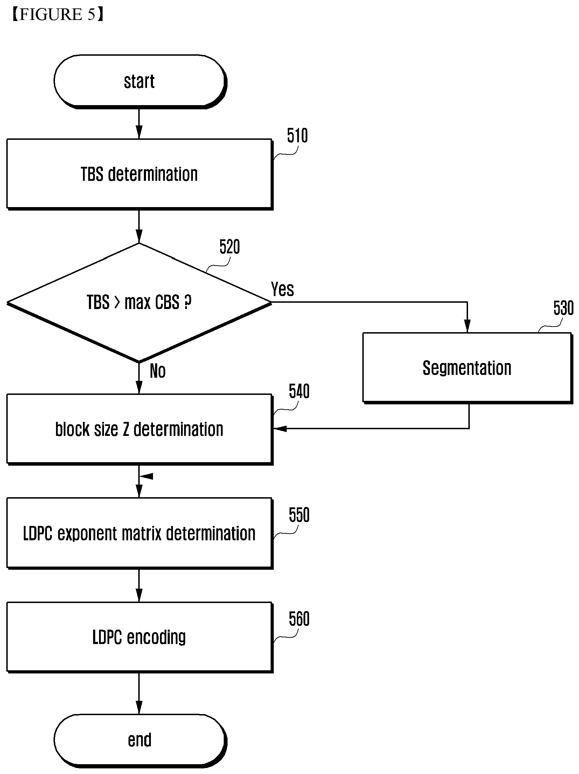

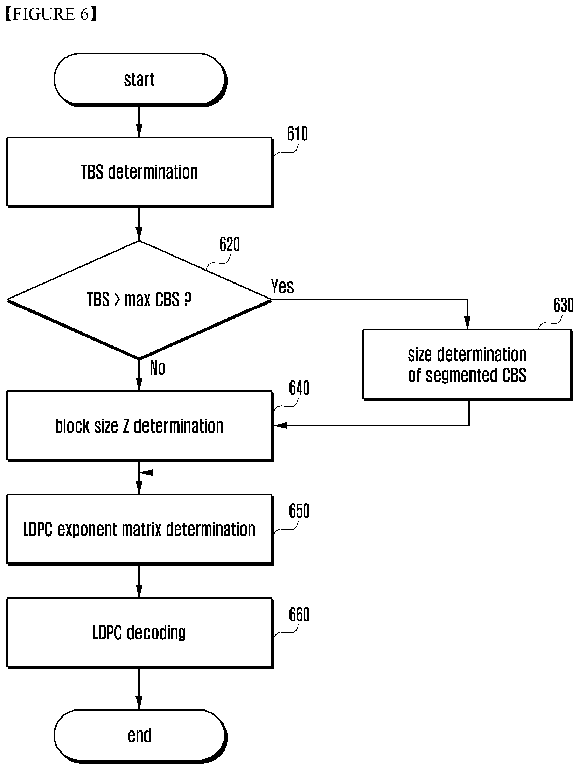

Flowcharts for an example of an LDPC encoding and decoding process based on a designed base matrix or exponent matrix are shown in FIGS. 5 and 6.

FIG. 5 is a diagram illustrating an example of an LDPC encoding process.

First, the transmitter determines the transport block size TBS to be transmitted as in step 510 of FIG. 5. In step 520, the transmitter determines whether the TBS is greater than, less than, or equal to the max CBS.

If TBS is greater than max CBS, the transmitter can determine CBS by segmenting the transport block in step 530. If TBS is less than or equal to max CBS, the transmitter skips the segmentation operation and determines the TBS as CBS.

In step 540, the transmitter determines the lifting size (Z) value to be applied to the LDPC encoding based on the CBS.

And the transmitter determines a parity check matrix or sequence based on the TBS or CBS or lifting size (Z) value in step 550. Additionally, the transmitter may also determine an LDPC exponent matrix or sequence that has an algebraically identical effect to the parity check matrix.

And the transmitter performs LDPC encoding based on a parity check matrix or sequence in step 560. Additionally, the transmitter can perform LDPC encoding based on an exponent matrix or sequence in step 560. Additionally, the transmitter can perform LDPC encoding based on the lifting size and the exponent matrix or sequence in step 560.

For reference, the step 550 may, in some cases, include a process of transforming the determined LDPC exponent matrix or sequence based on the determined lifting size. It is evident that the LDPC exponent matrix or sequence or parity check matrix for LDPC encoding can be determined in various ways based on TBS or CBS depending on the system. For example, it is possible for the transmitter to first determine the base matrix through TBS and then determine the LDPC exponent matrix or sequence parity check matrix based on the determined base matrix and CBS, and various other methods may also be applied. For reference, additional operations may be included between step 520 and step 540 or between step 530 and step 540 depending on the system, and, for example, in the case of a 3GPP 5G system, when using base matrix 2 (*M*(**H_{BG2}**)), the process of determining the *K_{b}* value, referring to the number of columns actually used in the base matrix or the number of column blocks used in the parity check matrix according to the TBS size, may also be included. (For reference, shortening is applied to (10 - *K_{b}*) column blocks of the parity check matrix corresponding to columns of the base matrix.)

The LDPC decoding process can also be represented similarly as shown in FIG. 6.

FIG. 6 is a diagram illustrating an example of an LDPC decoding process.

If TBS is determined in step 610, then in step 620, the receiver determines whether TBS is greater than or less than or equal to max CBS.

If TBS is greater than max CBS, the receiver determines the size of the segmented CBS in step 630. If TBS is determined to be less than or equal to max CBS, TBS is determined to be equal to CBS.

In step 640, the receiver determines the lifting size (Z) value to be applied to the LDPC decoding.

And, in step 650, the receiver determines a parity check matrix or sequence based on the TBS or CBS or lifting size (Z) value. Additionally, the transmitter can determine an exponent matrix or sequence that has an algebraically identical effect to the parity check matrix.

And in step 660, the receiver can perform LDPC decoding based on a parity check matrix or sequence. Additionally, the receiver can perform LDPC decoding using an exponent matrix or sequence in step 660. For reference, step 650 may, in some cases, include a process of transforming the determined LDPC exponent matrix or sequence based on the determined lifting size. It is obvious that the LDPC exponent matrix or sequence or parity check matrix for LDPC decoding can be determined in various ways based on TBS or CBS depending on the system. For example, it is possible for the receiver to first determine a base matrix through TBS and then determine the LDPC exponent matrix or sequence parity check matrix based on the determined base matrix and CBS, and various other methods may also be applied.

According to the above embodiment, the process of determining the exponent matrix or sequence of LDPC codes in steps 550 and 650 of FIGS. 5 and 6 has been described for the case where the exponent matrix or sequence is determined by one of TBS, CBS, or lifting size (Z), but various other methods may exist. Additionally, depending on the system, additional operations may be included between steps 620 and 640 or between steps 630 and 640 of FIG. 6, and, for example, in the case of a 3GPP 5G system, when using the base matrix 2 (*M*(**H_{BG2}**)), the process of determining the *K_{b}* value, referring to the number of columns actually used in the base matrix or the number of column blocks used in the parity check matrix according to the TBS size, may also be included. For reference, since the receiver can see that the bits corresponding to the column blocks of the parity check matrix corresponding to the columns of the (10 - *K_{b}*) base matrix have been shortened at the transmitter, the receiver may perform additional appropriate operations on the shortened bits before performing LDPC decoding.

In an embodiment of an LDPC encoding and decoding process based on the base matrix and exponent matrix (or LDPC sequence) of the LDPC codes of FIGS. 5 and 6, various code rates and various lengths of LDPC encoding and decoding can be supported by appropriately shortening or puncturing a portion of the information word bits and puncturing and repeating a part of the codeword bits for the LDPC codes. For example, as with the 3GPP 5G standard technology, in the LDPC encoding process of FIG. 5, by applying shortening to some of the information word bits, puncturing the information word bits corresponding to the first two columns of the base matrix, that is, the first 2*Z_{c}* column of the parity check matrix, and puncturing some of the parity or repeating some of the LDPC codeword, various information word lengths (or code block lengths) and various code rates can be supported.

When the given input bits or code block bits are denoted as *i*₀, *i*₁, *i*₂, ... , *i*_{*K*-1} and the encoded bits are denoted as *d*₀, *d*₁, *d*₂, ... , *d*_{*N*-1} (where in the case of the base matrix 1, *N =* 66*Z_{c}* and, in the case of the base matrix 2, *N* = 50*Z_{c}*), part of the encoding process can be defined as shown in [Table 9] below.

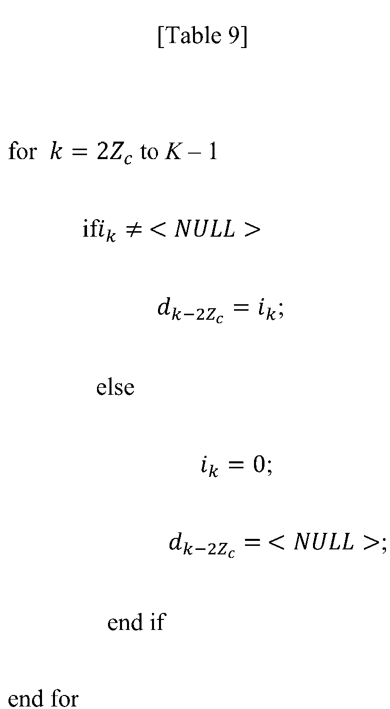

According to the above encoding process, the first 2*Z_{c}* bits of the input bits or code block bits, *i*₀, *i*₁, *i*₂, ... , i_{2*Zc*}-1, are not included in the encoding bits. That is, this means that the 2*Z_{c}* bits are punctured at the transmitter and are not transmitted to the receiver. For reference, if part of the information word bits is punctured, it means that the transmitter does not transmit part of the information word 102 of FIG. 1, and therefore the receiver can perform decoding by treating the untransmitted information word bits as erasure. In other words, since the punctured bit is treated as if it were erased and has an equal probability of being 0 or 1, the receiver may perform decoding by inserting a corresponding value.

In the encoding process, the punctured information word bits may not always be transmitted even in the case of retransmission. When a circular buffer is used for rate matching, if rate matching and retransmission are performed without storing the punctured information word bits in the circular buffer, the punctured information word bits may not always be transmitted.

On the other hand, in the case of initial transmission, a part of the information word bits is punctured, and in the case of retransmission, all or part of the punctured information word bits may be transmitted. All information word bits are stored in a circular buffer, but in the case of initial transmission, a redundancy value (RV) can be appropriately configured so that a part of the information word bits is punctured (e.g., RV0 value is configured by excluding the information word bits to be punctured). Even if a part of the information word bits is punctured in the initial transmission, since those bit values are stored in the circular buffer, in the case of retransmission, a part or all of the punctured information word bits may be transmitted depending on the circular buffer rate matching operation and the selection of an appropriate RV value.

In [Table 9], for convenience, *d*₀, *d*₁, *d*₂, ... , *d*_{*N*-1} is referred to as the encoding bit, but the definition of the encoding bit may change depending on the convenience of explanation. For example, as *d*₀, *d*₁, *d*₂, ... , *d*_{*N*-1} in [Table 9], the bit sequence after puncturing a part of the information word bits could be defined as the encoding bit; however, since input bits or code block bits *i*₀, *i*₁, *i*₂, ... , *i*_{*K*-1} are actually used to generate the parity bit vector ***w*** during the encoding process, based on the state before the puncturing of the information word bits, $\left({i}_{¯}, {w}_{¯}\right) = \left({i}_{0},{i}_{1},{i}_{2},…,{i}_{{K}_{ldpc} - 1},{w}_{0},{w}_{1},{w}_{2},…,{w}_{{N}_{ldpc} - {K}_{ldpc} - 1}\right)$ may also be defined as a encoded bit. Additionally, a bit sequence *e*₀, *e*₁, *e*₂, *..., e*_{*E*-1} with rate matching applied based on the allocated resource amount may also be defined by the encoded bit, and a bit sequence *f*₀, *f*₁, *f*₂, ... , *f*_{*E*-1} to which interleaving is applied for a rate-matched bit sequence may also be defined as the encoding bit. Additionally, the encoding bit sequence may be defined in various ways for convenience of explanation, but typically, the bit sequence related to actual transmission in the system is *d*₀, *d*₁, *d*₂, ... , *d*_{*N*-1}*,* or (***i***, ***w***) related to the encoding process can be defined as the encoding bit.

In the LDPC decoding process of FIG. 6, decoding can be performed by adding appropriate operations to the shortened information word bits, punctured bits, or repeated bits in response to the transmitter operation. Typically, since the shortened information word bit is 0, the receiver may perform decoding by excluding the column corresponding to the shortened bit from the parity check matrix, or by configuring a value pre-configured by the system for the shortened bit. (Since it is certain that it is 0, the highest value corresponding to 0 configured by the system is typically configured.) Since the punctured parity bit is considered as erasure and has an equal probability of being 0 or 1, the receiver may perform decoding by inserting a value corresponding to it, or depending on the structure of the parity check matrix, decoding may be performed without using at least some of the rows corresponding to the punctured parity bit. Generally, when parity bits corresponding to columns with a degree of 1 are punctured, there is an advantage in that decoding complexity is reduced because the LDPC decoder can perform decoding without using part or all of the corresponding parts of the parity check matrix.

Furthermore, when supporting variable information word lengths or variable code rates by utilizing LDPC code shortening or zero padding, code performance can be improved depending on the shortening order or method. If a shortening order is configured, coding performance can be improved by appropriately rearranging the order of part or all of the given base matrix. Additionally, performance can be improved by appropriately determining the lifting size or the number of column blocks to which shortening is applied for a specific information word length (or code block length CBS). Similarly, there are methods to improve LDPC code performance by adjusting the parity bit puncturing order or the transmission order of the generated LDPC codewords. For example, superior performance can be achieved by appropriately puncturing a part of the information word bits and parity bits, rather than simply puncturing parity bits to support variable code rates. Moreover, LDPC coding performance can be improved by appropriately determining the order in advance when repeating a part of the LDPC codeword to support lower code rates.

Typically, in the LDPC encoding process, the transmitter first determines the size of the input bit (or code block) to which LDPC encoding is to be applied, then determines the lifting size (Z) to which the LDPC encoding is to be applied based on that size, determines an appropriate LDPC exponent matrix or sequence based on the lifting size, and then performs LDPC encoding based on the lifting size (Z) and the determined exponent matrix or LDPC sequence. At this time, the LDPC exponent matrix or sequence may be applied to the LDPC encoding without transformation, and in some cases, LDPC encoding can be performed by appropriately transforming the LDPC exponent matrix or sequence according to the lifting size (Z).

Similarly, in the LDPC decoding process, the receiver determines the size of the input bit (or code block) for the transmitted LDPC codeword, then determines the lifting size (Z) to apply LDPC decoding according to the size, determines an appropriate LDPC exponent matrix or sequence according to the lifting size, and then performs LDPC decoding based on the lifting size (Z) and the determined exponent matrix or LDPC sequence. At this time, the LDPC exponent matrix or sequence may be applied to LDPC decoding without transformation, or in some cases, the LDPC exponent matrix or sequence may be appropriately transformed according to the lifting size (Z) to perform LDPC decoding.

In a parity check matrix, the submatrix corresponding to the parity bit often has a special structure for efficient encoding. In this case, the encoding method or complexity may change because of lifting. Therefore, to maintain the same encoding method or complexity, lifting may not be applied to a part of the exponent matrix corresponding to the parity submatrix in the parity check matrix, or a different lifting method may be applied compared to the lifting method applied to the exponent matrix corresponding to the information word bit. In other words, the lifting method applied to the sequence corresponding to the information word bit within the exponent matrix and the lifting method applied to the sequence corresponding to the parity bit may be configured differently, and in some cases, lifting may not be applied to a part or the whole of the sequence corresponding to the parity bit, so a fixed value may be used without sequence transformation.

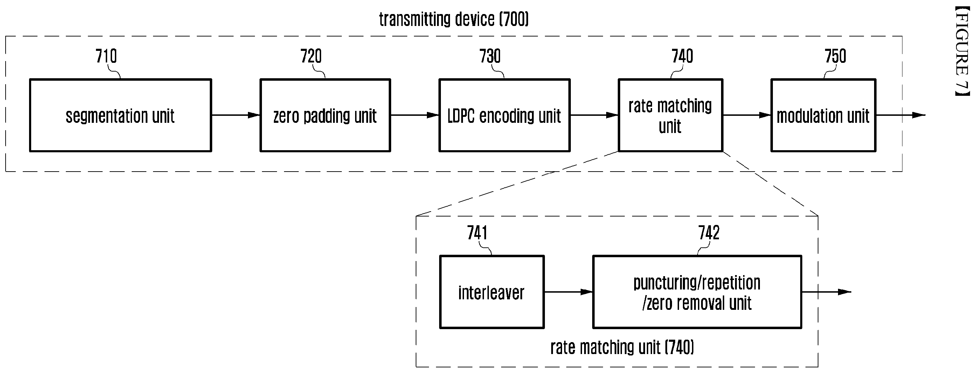

FIG. 7 is a block diagram of a transmitting device according to one embodiment of the present disclosure.

Specifically, as shown in FIG. 7, the transmitting device 700 for processing variable-length input bits may include a segmentation unit 710, a zero padding unit 720, an LDPC encoding unit 730, and a rate matching unit 740, a modulation unit 750, etc. The rate matching unit 740 may include an interleaver 741 and a puncturing/repetition /zero removal unit 742, etc.

Here, the component shown in FIG. 7 is a component that performs encoding and modulation for variable-length input bits, and this is just one example, and in some cases, some of the components shown in FIG. 7 may be omitted or changed, and other components may be added.

Meanwhile, the transmitting device 700 can determine necessary parameters (e.g., at least one of input bit length, ModCod (modulation and code rate), parameters for zero padding (or shortening), the code rate/codeword length of an LDPC code, parameters for interleaving, parameters for repetition and puncturing, etc., and a modulation method), encode input bits based on the determined parameters, and transmit them to the receiving device 800.

Since the number of input bits is variable, if the number of input bits is greater than a preconfigured value, the input bits can be segmented to have a length less than or equal to the preconfigured value. Additionally, each segmented block can correspond to one LDPC-coded block. However, if the number of input bits is less than or equal to a preconfigured value, the input bits are not segmented, and the input bits can correspond to one LDPC-coded block.

Meanwhile, the transmitting device 700 may store various parameters used for encoding, interleaving, and modulation. Here, the parameters used for encoding may include at least one of the code rate, codeword length, and information regarding the parity check matrix of the LDPC code. And the parameters used for interleaving may include information regarding interleaving rules, and parameters used for modulation may include information regarding the modulation method. Additionally, information regarding puncturing may include the puncturing length. Additionally, information regarding repetition may include the repetition length. Information regarding the parity check matrix may include the exponent value of the circulant matrix or values that are algebraically identical thereto when using the parity matrix presented in this disclosure.

In this case, each component constituting the transmitting device 700 can perform an operation using these parameters.

Meanwhile, the transmitting device 700 may further include a control unit (not illustrated) for controlling the operation of the transmitting device 700 depending on the case.

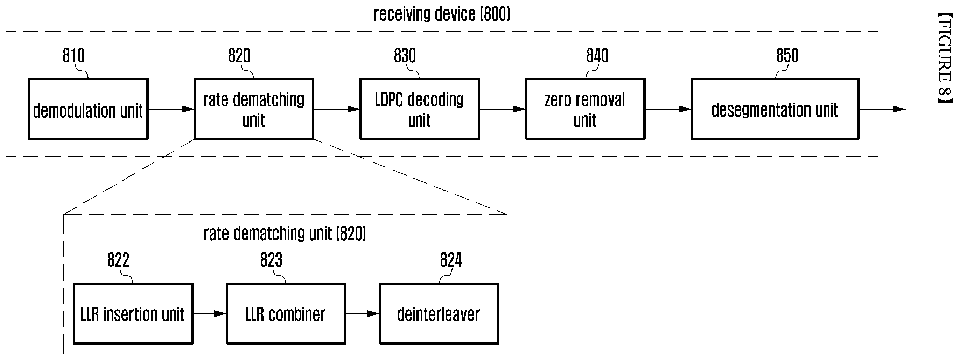

FIG. 8 is a block diagram of a receiving device according to one embodiment of the present disclosure.

Specifically, as shown in FIG. 8, the receiving device 800 may include a demodulation unit 810, a rate dematching unit 820, an LDPC decoding unit 830, a zero removal unit 840, and a desegmentation unit 850, etc. to process variable-length information. The rate dematching unit 820 may include an LLR (log likelihood ratio) insertion unit 822, an LLR combiner 823, a deinterleaver 824, etc.

Here, the component shown in FIG. 8 is a component that performs a function corresponding to the component shown in FIG. 8, and this is merely an example, and in some cases, some may be omitted or changed, and other components may be added.

The parity check matrix of the present disclosure may be read using memory, provided in advance at a transmitting or receiving device, or generated directly at a transmitting or receiving device. Additionally, the transmitting device may store or generate a sequence or exponent matrix corresponding to the parity check matrix, or a value that is algebraically identical thereto, and apply it to encoding. Similarly, the receiving device may store or generate a sequence or exponent matrix corresponding to the parity check matrix, or a value that is algebraically identical thereto, and apply it to decoding.

Hereunder, a detailed explanation of the receiver operation will be provided based on FIG. 8.

The demodulation unit 810 demodulates the signal received from the transmitting device 700.

Specifically, the demodulation unit 810 is a component corresponding to the modulation unit 750 of the transmitting device 700, and can demodulate a signal received from the transmitting device 700 to generate values corresponding to the bits transmitted from the transmitting device 700.

To this end, the receiving device 800 determines the parameters (e.g., input bit length, ModCod (modulation and code rate), parameters for zero padding (or shortening), the code rate/codeword length of the LDPC code, parameters for interleaving, parameters for repetition and puncturing, etc., and at least one of the modulation method) necessary for demodulation and decoding, and based on the determined parameters, the demodulation unit 810 can perform a decoding process to generate values corresponding to LDPC codeword bits by demodulating a signal received from the transmitting device 700 according to the mode.

Meanwhile, the value corresponding to the bits transmitted by the transmitting device 700 may be an LR (likelihood ratio) value or an LLR (log likelihood ratio) value.

Specifically, the LR value represents the ratio of the probability that the bit transmitted by the transmitting device 700 is 0 to the probability that it is 1, and the LLR value can be represented as the value obtained by taking the log value of the ratio of the probabilities that the bit transmitted by the transmitting device 700 is 0 to the probability that it is 1. Alternatively, the LR or LLR value may be hard-decided according to the probability, a ratio of the probabilities, or a log value of the ratio of the probabilities, and represented as the bit value itself, or it may be represented as a predefined representative value according to an interval to which the probability, the ratio of the probabilities, or the log value of the ratio of the probabilities belongs. An example of a method for determining a predefined representative value according to the interval to which the probability, a ratio of the probabilities, or a log value of the ratio of the probabilities belongs is a method that considers quantization. Additionally, various other values corresponding to the probability, a ratio of the probabilities, or a log value of the ratio of the probabilities may also be used.

In this disclosure, for convenience, operations based on LLR values are shown to explain the operation of the receiving method and device, but are not limited thereto.

The demodulation unit 810 includes a function to perform multiplexing (not shown) on LLR values. Specifically, the multiplexer (not shown) is a component corresponding to the bit demultiplexer (not shown) of the transmitting device 700 and can perform an operation corresponding to the bit demultiplexer (not shown).

To this end, the receiving device 800 may store information about parameters that the transmitting device 700 used for demultiplexing and block interleaving. Accordingly, the multiplexer (not shown) can perform the demultiplexing and block interleaving operations performed in the bit demultiplexer (not shown) on the LLR value corresponding to the cell word (information representing the received symbol for the LDPC codeword as a vector value) in reverse, thereby multiplexing the LLR value corresponding to the cell word in bit units.

The rate dematching unit 820 can additionally insert LLR values into the LLR values output from the demodulation unit 810. In this case, the rate dematching unit 820 can insert pre-agreed LLR values between the LLR values output from the demodulation unit 810.

Specifically, the rate dematching unit 820 may perform operations corresponding to the interleaver 741, zero remover, and puncturing/repetition/zero removal unit 742 as a component corresponding to the rate matching 740 of the transmitting device 700.

First, the rate dematching unit 820 performs deinterleaving to correspond to the interleaver 741 of the transmitter. The LLR insertion unit 822 can insert an LLR value corresponding to the zero bits at the positions where the zero bits in the LDPC codeword were padded in the output values of the deinterleaver 824. In this case, the LLR value corresponding to the padded zero bits, i.e., the shortened zero bits, can be ∞ or -∞. However, ∞ or -∞ is a theoretical value and can be the maximum or minimum value of the LLR value used in the receiving device 800.

To this end, the receiving device 800 may store information about the parameters that the transmitting device 700 used to pad the zero bits. Accordingly, the rate dematching unit 820 can determine the position where zero bits were padded in the LDPC codeword and insert an LLR value corresponding to the shortened zero bits at that position.

Additionally, the LLR insertion unit 822 of the rate dematching unit 820 may insert an LLR value corresponding to the punctured bits at the positions of the punctured bits in the LDPC codeword. In this case, the LLR value corresponding to the punctured bits can be 0 or another predetermined value. Generally, in the case where parity bits with a degree of 1 are punctured, since they have no effect on performance improvement in an LDPC decoding process, they may not be used in the LDPC decoding process without LLR insertion into part or all of corresponding puncturing positions. However, to increase the efficiency of the LDPC decoding process based on parallel processing, the LLR insertion unit 822 can insert a predetermined LLR value at a position corresponding to some or all of the puncturing bits with a degree of 1, regardless of the improvement in decoding performance.

To this end, the receiving device 800 may store information about the parameters used for puncturing in the transmitting device 700. Accordingly, the LLR insertion unit 822 may insert a corresponding LLR value (e.g., LLR = 0) at the position where LDPC information word bits or parity bits have been punctured. However, this process may be omitted at some of the punctured parity bit positions.

The LLR combiner 823 can combine, that is, sum the LLR values output from the LLR insertion unit 822 and the demodulation unit 810. Specifically, the LLR combiner 823 is a component corresponding to the puncturing/repetition/zero removal unit 742 of the transmitting device 700 and can perform an operation corresponding to the repetition unit 742. First, the LLR combiner 823 can combine the LLR values corresponding to the repeated bits with other LLR values. Here, the other LLR values may be LLR values for the bits that formed the basis for generating the repeated bits in the transmitting device 700, that is, LDPC information word bits or parity bits that were selected as the repetition target.

That is, as described above, the transmitting device 700 selects LDPC encoded bits and repeats them between LDPC information word bits and LDPC parity bits and transmits them to the receiving device 800. Accordingly, the LLR values for the LDPC encoded bits may consist of LLR values for the repeated LDPC encoded bits and LLR values for the non-repeated LDPC encoded bits. The LLR combiner 823 can combine LLR values for the same LDPC encoded bits.

To this end, the receiving device 800 may store information about the parameters used for repetition in the transmitting device 700. Accordingly, the LLR combiner 823 may determine the LLR value for the repeated LDPC encoded bits and combine it with the LLR value for the LDPC encoded bits that formed the basis of the repetition.

Additionally, the LLR combiner 823 can combine an LLR value corresponding to the retransmitted or increment redundancy (IR) bits with another LLR value. Here, the other LLR value may be an LLR value for some or all of the LDPC codeword bits that formed the basis for generating the retransmitted or IR bits at the transmitting device 700.

As described above, when a NACK occurs for HARQ, the transmitting device 700 may transmit some or all of the bits to the receiving device 800.

Accordingly, the LLR combiner 823 can combine the LLR values for bits received through retransmission or IR with the LLR values for LDPC codeword bits received through the previous frame.

To this end, the receiving device 800 may store information about the parameters used by the transmitting device 700 for retransmission or IR bit generation. Accordingly, the LLR combiner 823 may determine the LLR value for the number of retransmission or IR bits and combine it with the LLR value for the LDPC encoded bits that formed the basis for the generation of the retransmission bits.

The deinterleaver 824 can deinterleave the LLR values output from the LLR combiner 823.

Specifically, the deinterleaver unit 824 is a component corresponding to the interleaver 741 of the transmitting device 700 and can perform an operation corresponding to the interleaver 741.

To this end, the receiving device 800 may store information about the parameters that the transmitting device 700 used for interleaving. Accordingly, the deinterleaver 824 can deinterleave the LLR values corresponding to the transmitted LDPC encoded bits by performing the interleaving operation performed in the interleaver 741 in reverse on the LLR values corresponding to the transmitted LDPC encoded bits.

The LDPC decoding unit 830 may perform LDPC decoding based on the LLR value output from the rate dematching unit 820.

Specifically, the LDPC decoding unit 830 is a component corresponding to the LDPC encoding unit 730 of the transmitting device 700 and can perform an operation corresponding to the LDPC encoding unit 730.

To this end, the receiving device 800 may store prior information regarding parameters used by the transmitting device 700 to perform LDPC encoding according to the mode. Accordingly, the LDPC decoding unit 830 may perform LDPC decoding based on the LLR value output from the rate dematching unit 820 according to the mode.

For example, the LDPC decoding unit 830 may perform LDPC decoding based on the LLR value output from the rate dematching unit 820 according to an iterative decoding method based on a sum-product algorithm, and may output error-corrected bits according to the LDPC decoding. The LDPC decoding unit 830 performs LDPC decoding for the LDPC codeword based on a parity check matrix or a corresponding exponent matrix or sequence. Additionally, LDPC decoding can be performed using parity check matrices defined differently according to the code rate (i.e., the code rate of the LDPC code). The LDPC decoding unit 830 can generate information word bits by performing LDPC decoding through an iterative decoding algorithm by passing LLR values corresponding to the LDPC codeword bits. Here, the LLR value is a channel value corresponding to the LDPC codeword bits and can be expressed in various ways.

The zero removal unit 840 can remove zero bits from the bits output from the LDPC decoding unit 830.

Specifically, the zero removal unit 840 is a component corresponding to the zero padding unit 720 of the transmitting device 700 and can perform an operation corresponding to the zero padding unit 720.

To this end, the receiving unit 800 may already store information about the parameters used to pad zero bits in the transmitting device 700. Accordingly, the zero removal unit 840 can remove the zero bits padded in the zero padding unit 720 from the bits output from the LDPC decoding unit 830.

The desegmentation unit 850 is a component corresponding to the segmentation unit 710 of the transmitting device 700 and can perform an operation corresponding to the segmentation unit 710.

To this end, the receiving device 800 may already store information about the parameters that the transmitting device 700 used for segmentation. Accordingly, the desegmentation unit 850 can restore the bits prior to segmentation by combining the bits output from the zero removal unit 840, i.e., the segments for variable-length input bits.

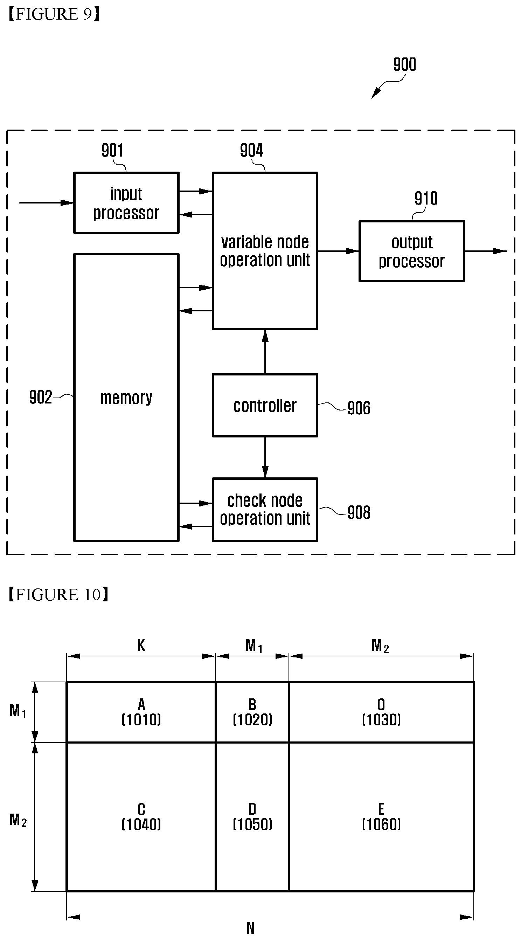

FIG. 9 shows a structural diagram of an LDPC decoding unit according to one embodiment of the present disclosure.

Meanwhile, as described above, the LDPC decoding unit 830 can perform LDPC decoding using an iterative decoding algorithm, and in this case, the LDPC decoding unit 830 can be configured with a structure as shown in FIG. 9. However, the detailed configuration illustrated in FIG. 9 is also just an example.

According to FIG. 9, the decoding device 900 includes an input processor 901, a memory 902, and a variable node operation unit 904, a controller 906, a check node operation unit 908 and an output processor 910, etc.

The input processor 901 stores the input value. Specifically, the input processor 901 can store the LLR value of the received signal received through the channel.

The controller 906 determines the number of values input to the variable node operation unit 904 and the address value in memory 902, the number of values input to the check node operation unit 908 and the address value in memory 902, etc., based on the size of the block of the received signal received through the channel (i.e., the length of the codeword) and the parity check matrix corresponding to the code rate.

The memory 902 stores the input and output data of the variable node operation unit 904 and the check node operation unit 908.

The variable node operation unit 904 receives data from memory 902 and performs variable node operation based on the address information and number information of the input data received from the controller 906. Subsequently, the variable node operation unit 904 stores the variable node operation results in memory 902 based on the address information and number information of the output data received from the controller 906. Additionally, the variable node operation unit 904 inputs the variable node operation results to the output processor 910 based on the data received from the input processor 901 and memory 902. Here, the variable node operation has been described above based on FIG. 6.

The check node operation unit 908 receives data from memory 902 based on the address information and number information of the input data received from the controller 906 and performs check node operation. Afterwards, the check node operation unit 908 stores the check node operation results in memory 902 based on the address information and number information of the output data received from the controller 906. Here, the check node operation has been described in detail based on FIG. 6.

The output processor 910 determines whether the information word bits of the codeword of the transmitting side were 0 or 1 based on the data received from the variable node operation unit 904, and then outputs the result of the determination, and the output value of the output processor 910 becomes the final decoded value. In this case, the determination can be made based on the sum of all message values input to a single variable node in FIG. 6 (initial message value and all message values input from the check node).

Meanwhile, the memory 902 of the decoding device 900 can store information regarding the code rate, codeword length, and parity check matrix of the LDPC code, and the LDPC decoding unit 830 can perform LDPC decoding using this information. However, this is only an example, and the information may be provided from the transmitting side.

For reference, in this disclosure, although the explanation is limited to LDPC codes as a FEC (forward error correction) technique of a communication system, the FEC encoding and decoding in a communication system can generally be subdivided into concatenated codes such as outer codes and inner codes. Depending on the definitions of outer codes and inner codes, the transmitter performs inner encoding after outer encoding, and the receiver performs outer decoding after inner decoding.

For external codes, algebraic codes capable of relatively simple error detection or correction, such as cyclic redundancy check (CRC) codes, bose-chaudhuri-hocquenghem (BCH) codes, and reed-solomon (RS) codes, are widely used, but they are not necessarily limited to these and a plurality of codes can be applied in combination.

For internal codes, encoding schemes that are relatively complex but have excellent error correction capabilities, such as LDPC, Turbo, and Polar codes, are widely utilized; however, they are not necessarily limited thereto. (For example, tail-biting convolutional codes or other algebraic codes may be used, and the overlapping application of a plurality of codes is also possible.) For reference, in the 3GPP 5G system, CRC codes are used for external codes, LDPC codes are used for internal codes for data channels, and Polar codes are used for internal codes for control channels.

Various broadcasting and communication systems use LDPC codes optimized for each system, and this disclosure basically explains the systems using LDPC codes defined based on a parity check matrix having the same structure as the LDPC codes used in the 3GPP 5G system, but is not necessarily limited to this. Additionally, the communication systems including 5G or 6G systems may apply rate matching at the transmitter and rate dematching at the receiver to support various code rates and various code lengths, but in the systems that perform encoding/decoding based on fixed LDPC codes, such as some broadcasting systems, not only rate matching or rate dematching, but also all or part of other operations may be omitted.

FIG. 10 illustrates the general structure of a parity check matrix of an LDPC code, which is an internal code applied to the FEC encoding unit (not shown) and FEC decoding unit (not shown) to be described in the present disclosure.

The number of columns of the parity check matrix illustrated in FIG. 10 is N, and the number of rows is (M1 + M2). (However, M ₁, M ₂ ≥ 0, M1 + M2 _{>} 0). Generally, when a parity check matrix has full rank, the number of columns corresponding to information word bits in the parity check matrix is equal to the total number of columns minus the total number of rows. That is, if the parity check matrix of FIG. 10 has full rank (M1 ₊ M2), it means that the number of information word bits K becomes N - (M1 ₊ M2). For convenience, the present disclosure describes only the case where the parity check matrix of FIG. 10 has the maximum rank, but it is not necessarily limited thereto.

First, the parity check matrix of FIG. 10 can be divided into the first part of the parity check matrix composed of submatrices A 1010 and B 1020, and the second part of the parity check matrix composed of submatrices C 1040, D 1050, and E 1060 (if one of M₁ or M₂ is 0, it may not be distinguished as a first part and a second part). The submatrix 01030 means a zero matrix of size M₁ × M₂. Since the submatrix 01030 is a zero matrix of size M₁ × M₂, even if it is included in the first part of the parity check matrix, it does not affect matrix operations. For this reason, for convenience, in this disclosure, the first part of the parity check matrix is defined as a matrix composed of submatrices A 1010 and B 1020, excluding the zero matrix of size M₁ × M₂, but the first part of the parity check matrix, as needed, may include a zero matrix of size M₁ × M₂.

If the parity check matrix of FIG. 10 is defined as a QC LDPC code with a lifting size or block size of Z, then the parity check matrix of FIG. 10 may correspond to a base matrix or weight matrix having a size of *m_{b}* × *n_{b}* for *k_{b} = K*/*Z, n_{b} = N*/*Z*, and *m_{b} =* (*M*₁ *+ M*₂) / *Z = m*_{*b*1} + *m*_{*b*2} (*m*_{*b*1} = *M*₁/*Z, m*_{*b*2} = *M*₂/*Z*). Likewise, the first part of the parity check matrix composed of submatrices A 1010 and B 1020 corresponds to a submatrix of a base matrix or weight matrix of size $\left(\frac{{M}_{1}}{Z}\right) \times \left(\frac{K + {M}_{1}}{Z}\right)$ or *m*_{*b*1} × (*k_{b}* + *m*_{*b*1}) and the second part of the parity check matrix composed of submatrices C 1040, D 1050 and E 1060 corresponds to a submatrix of a base matrix or weight matrix of size $\left(\frac{{M}_{2}}{Z}\right) \times \left(\frac{K + {M}_{1} + {M}_{2}}{Z}\right)$ or *m*_{*b*2} × (*k_{b}* + *m*_{*b*1} + *m*_{*b*2}) = *m*_{*b*2} × *n_{b}*.

For convenience, let H be the parity check matrix of FIG. 10, let the information word bits (or information word bit vectors) corresponding to submatrix A 1010 or C 1040 be denoted as ***i** =* (*i*₀, *i*₁, *i*₂, *..., i*_{*K*-1}), let the first parity bits (or first parity bit vectors) corresponding to submatrix B 1020 or D 1050 be denoted as ***w*₁** = (*w*_{1,0}, *w*_{1,1}, *w*_{1,2}, ... , *w*_{1,*M*₁-1}), and let the second parity bits (or second parity bit vectors) corresponding to submatrix E 1060 be denoted as ***w*₂** = (*w*_{2,0}, *w*_{2,1}, *w*_{2,2}, *... , w*_{2,*M*₂-1})*,* and then a relational expression as in the following Equation 13 can be obtained from Equation 1. [Equation 13] $\begin{matrix}H ⋅ {c}^{T} = H ⋅ \left[\begin{matrix}{{i}_{¯}}^{T} \\ {{w}_{¯}}_{1}^{T} \\ {{w}_{¯}}_{2}^{T}\end{matrix}\right] = \left[\begin{matrix}A & B & O \\ C & D & E\end{matrix}\right] ⋅ \left[\begin{matrix}{{i}_{¯}}^{T} \\ {{w}_{¯}}_{1}^{T} \\ {{w}_{¯}}_{2}^{T}\end{matrix}\right] \\ = \left\{\begin{matrix}A ⋅ {{i}_{¯}}^{T} + B ⋅ {{w}_{¯}}_{1}^{T} = 0 \\ C ⋅ {{i}_{¯}}^{T} + D ⋅ {{w}_{¯}}_{1}^{T} + E ⋅ {{w}_{¯}}_{2}^{T} = 0\end{matrix}\right.\end{matrix}$

With reference to the Equation 13, the first parity vector ***w*₁** can be obtained (or calculated or determined) based on the information word bit vector i and the first part of the parity check matrix. Additionally, after obtaining the parity vector ***w*₁**, the parity vector ***w*₂** can be obtained (or calculated or determined) based on the information word bit vector ***i***, the parity vector ***w*₁** and the second part of the parity check matrix.

In the present disclosure, the first part of the parity check matrix composed of A 1010 and B 1020, which is necessary to generate a first parity vector ***w*₁** based on an information word bit vector ***i***, for convenience, may be referred to as a core part or core matrix, a kernel part or kernel matrix, or a precoding part or matrix. Additionally, the second part of the parity check matrix composed of C 1040, D 1050, and E 1060, which is necessary to generate a second parity vector ***w*₂** based on an information word bit vector ***i*** and/or the first parity vector ***w*₁**, may be referred to as an extension part or a single parity-check extension part.

As a specific example, the core matrix parts of the base matrix 1 *M*(**H_{BG1}**) and the core matrix parts of the base matrix 2 *M*(**H_{BG2}**) defined in the previously explained 3GPP 5G standard are represented as follows.
*M*(**H_{BG1}**)Core matrix of:
   0 1 2 3 5 6 9 10 11 12 13 15 16 18 19 20 21 22 23
   0 2 3 4 5 7 8 9 11 12 14 15 16 17 19 21 22 23 24
   0 1 2 4 5 6 7 8 9 10 13 14 15 17 18 19 20 24 25
   0 1 3 4 6 7 8 10 11 12 13 14 16 17 18 20 21 22 25
*M*(**H_{BG2}**)Core matrix of:
   0 1 2 3 6 9 10 11
   0 3 4 5 6 7 8 9 11 12
   0 1 3 4 8 10 12 13
   1 2 4 5 6 7 8 9 10 13

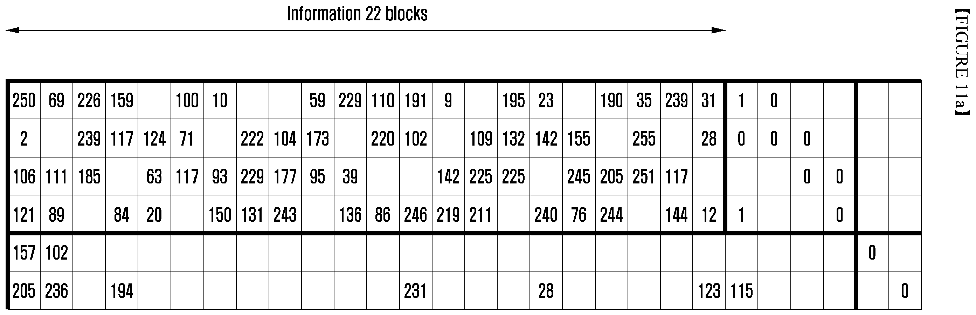

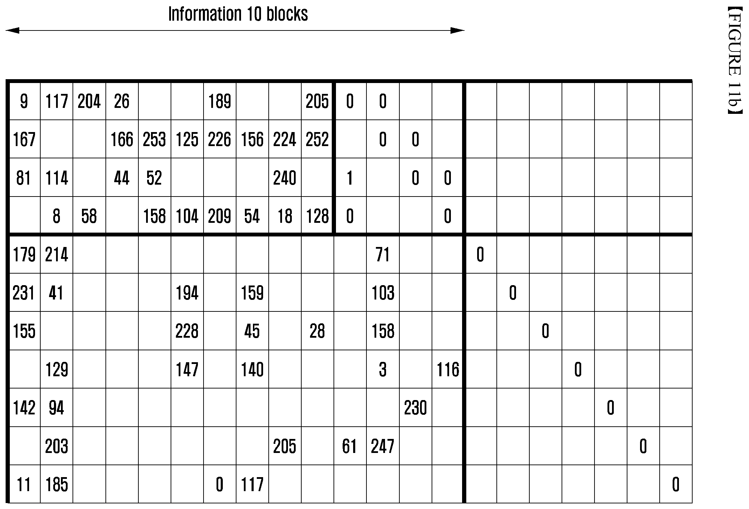

The size of the core matrix of *M*(**H_{BG1}**) is 4×26, and the size of the core matrix of *M*(**H_{BG2}**) is 4×14. Additionally, based on the parity check matrix, the core matrix sizes are 4Z×26Z and 4Z×14Z, respectively. As a specific example, in the 3GPP 5G standard TS 38.212, a part of the exponent matrix of the LDPC code defined for the case where the lifting size set index ***i_{LS}** =* 0 is shown in FIG. 11a and FIG. 11b. The part corresponding to the core matrix of the base matrix or parity check matrix in FIG. 11a and FIG. 11b is as follows.
*V*(**H₁**), core matrix of *i_{LS}* = 0:
   250 69 226 159 100 10 59 229 110 191 9 195 23 190 35 239 31 1 0
   2 239 117 124 71 222 104 173 220 102 109 132 142 155 255 28 0 0 0
   106 111 185 63 117 93 229 177 95 39 142 225 225 245 205 251 11700
   121 89 84 20 150 131 243 136 86 246 219 211 240 76 244 144 12 1 0
*V*(**H₂**), core matrix of *i_{LS}* = 0:
   9 117 204 26 189 205 0 0
   167 166 253 125 226 156 224 252 0 0
   81 114 44 52 240 1 0 0
   8 58 158 10420954 18 12800

Meanwhile, in the present disclosure, a parity check matrix based on the following conditions may be considered for the parity check matrix corresponding to FIG. 10.

Hereinafter, submatrix A 1010 and submatrix B 1020 can be called the first submatrix and the second submatrix respectively. Additionally, the circulant permutation matrix in the following can mean a circulant permutation matrix having a size Z × Z determined based on the lifting size Z, and, for example, can be constructed as Equation 5 or Equation 6. Additionally, in the present disclosure, a circulant matrix may mean a matrix in which circulant permutation matrices are overlapped.

**Condition 1(a):** In the parity check matrix for the QC-LDPC code of FIG. 10, if the submatrix B 1020 does not contain a circulant matrix in which circulant permutation matrices of size *Z* × Z are overlapped, then all column blocks of the submatrix B 1020 have a weight of 2 or more, and at least one odd column block with a weight of 3 or more may be included in the submatrix B 1020. Additionally, all columns of the base matrix *M*(**B**) corresponding to the submatrix B 1020 have a weight of 2 or more, and at least one column with an odd weight of 3 or more may be included in the base matrix *M***(B).**

**Condition 1(b):** In the parity check matrix for the QC-LDPC code of FIG. 10, if the submatrix B 1020 includes at least one circulant matrix in which circulant permutation matrices of size *Z* × *Z* are overlapped, all column blocks of the submatrix B 1020 have a weight of 2 or more, and at least one odd column block with a weight of 3 or more is included in the submatrix B 1020. Additionally, in the weight matrix *W*(**B**) corresponding to the submatrix B 1020, the sum of the entries of all columns is 2 or more, and at least one column is included in the weight matrix *W*(**B**) where the sum of the entries is an odd number, 3 or more. (The weight of the column block containing the circulant matrix in which the circulant permutation matrices of the size Z × Z are overlapped may be 2 or 3 or more.)

**Condition 2**: All column weights and row weights of the submatrix E1060 of FIG. 10 are 1. Additionally, the column weights and row weights of the submatrix of the base matrix and weight matrix corresponding to the submatrix E1060 are both 1. Therefore, E1060 and the submatrix of the base matrix and weight matrix corresponding to E1060 are either an identity matrix, or a matrix that transforms into an identity matrix by applying appropriate column permutations or row permutations, etc. (i.e., E1060 means that it is an identity matrix or a matrix having equivalent algebraic properties.) If the parity check matrix of FIG. 10 is defined as a quasi-cyclic parity check matrix, the submatrix E can be distinguished by identity matrices of a plurality of *Z* × *Z* sizes.

FIG. 11a and FIG. 11b are examples of parity check matrices satisfying at least one of condition 1(a), condition 1(b), or condition 2. As briefly explained above, FIG. 11a is an example of the case where K = 22*Z, M1 = 4*Z, and M2 = 2*Z in FIG. 10, and FIG. 11b is an example of the case where K = 10*Z, M1 = 4*Z, and M2 = 7*Z in FIG. 10. Note that since the code rate of the LDPC code corresponding to the parity check matrices of FIG. 10, FIG. 11a, and FIG. 11b is K/N, a codeword with a lower code rate can be generated as M2 decreases. In other words, according to the present disclosure, LDPC encoding and decoding can be performed based on a parity check matrix that can support a lower code rate by further extending columns with a degree of 1 while including FIG. 11a and FIG. 11b.

If a set of lifting sizes is used for LDPC encoding or decoding with respect to the parity check matrix of a quasi-cyclic LDPC code, the number of columns constituting one column block of the parity check matrix is greater than or equal to the minimum value of the lifting size. For example, when the values in Table 6 are used as the lifting size, the number of columns constituting one column block of the parity check matrix may be at least 4. Therefore, in a communication system where the lifting size of Table 6 is substantially applied to a parity check matrix of an LDPC code having a structure such as that shown in FIG. 10, FIG. 11 a, and FIG. 11 b satisfying at least one of the condition 1(a), condition 1(b), or condition 2, it means that the number of columns with a degree of 3 in the submatrix B 1020 is at least 4.

For reference, in a parity check matrix, base matrix, or weight matrix, the core matrix may also be defined in a form that satisfies at least one of the condition 1(a), condition 1(b), or condition 2 by adding one or two additional rows as follows.
Core matrix of *M*(**H_{BG1}**):
   0 1 2 3 5 6 9 10 11 12 13 15 16 18 19 20 21 22 23
   0 2 3 4 5 7 8 9 11 12 14 15 16 17 19 21 22 23 24
   0 1 2 4 5 6 7 8 9 10 13 14 15 17 18 19 20 24 25
   0 1 3 4 6 7 8 10 11 12 13 14 16 17 18 20 21 22 25
   0 1 26
Core matrix of *M*(**H_{BG2}**):
   0 1 2 3 6 9 10 11
   0 3 4 5 6 7 8 9 11 12
   0 1 3 4 8 10 12 13
   1 2 4 5 6 7 8 9 10 13
   0 1 11 14

However, for convenience in this disclosure, a parity check matrix [A1010 B1020] containing a submatrix B satisfying only condition 1(a) or condition 1(b) is considered as a core matrix (or kernel matrix or precoding matrix). That is, in the present invention, the first part of the base matrix, the first part of the parity check matrix, the core matrix/part, or the kernel matrix/part, etc., means a submatrix in which columns corresponding to parity bits with a degree of 1 and rows directly related to the parity bits with the degree of 1 are excluded.

As an embodiment of the present disclosure, a method for improving the performance of an LDPC code and a method for improving the decoding convergence speed according to a weight matrix are described.

First, the core matrix of the base matrix 2 *M*(**H_{BG2}**) defined in **[Base matrix determination methods]** consists of 4 rows, and this can also be expressed as a weight matrix like Equation 14. Since LDPC code defined by the base matrix 1 *M*(**H_{BG1}**) or the base matrix 2 *M*(**H_{BG2}**) is defined such that one circulant permutation matrix corresponds to one Z × Z size block, the base matrix and the weight matrix are basically the same. [Equation 4] $W \left({H}_{BG 2}\right) = \left[\begin{matrix}1 & 1 & 1 & 1 & 0 & 0 & 1 & 0 & 0 & 1 & 1 & 1 & 0 & 0 \\ 1 & 0 & 0 & 1 & 1 & 1 & 1 & 1 & 1 & 1 & 0 & 1 & 1 & 0 \\ 1 & 1 & 0 & 1 & 1 & 0 & 0 & 0 & 1 & 0 & 1 & 0 & 1 & 1 \\ 0 & 1 & 1 & 0 & 1 & 1 & 1 & 1 & 1 & 1 & 1 & 0 & 0 & 1\end{matrix}\right]$

As such, LDPC codes designed so that at most one circulant permutation matrix corresponds to one Z × Z size block are structured suitable for performing layered decoding in units of single row blocks during decoding. That is, this means that the structure of the LDPC code is suitable for performing decoding through Z-unit parallel processing processors. Layered decoding means the operation of performing decoding sequentially layer by layer. Therefore, decoding may be performed sequentially in units of a single row block, or decoding can be performed layer by layer by configuring a plurality of row blocks into a single layer. Meanwhile, in the present disclosure, layered decoding was defined as an operation of performing decoding sequentially layer by layer, but performing decoding sequentially simply means performing decoding layer by layer, but it does not mean that decoding must be performed in the order of the layer's index. Additionally, in the present disclosure, the meaning of performing decoding sequentially may mean performing decoding sequentially according to layered decoding order or pattern (or sequence). Additionally, depending on the structure of a parity check matrix, some layers may consist of a single row block, while others may consist of a plurality of row blocks.

Since these layered decoding methods typically perform parallel processing using layers composed of a single row block or a plurality of row blocks as the basic unit, it can be determined that one iteration of decoding is completed once decoding is performed for the total number of row blocks. This means that if there are sufficient parallel processors, the decoding throughput through layered decoding is inversely proportional to the number of row blocks. However, if the same code length is supported using a parity check matrix with a small number of row blocks, it means that the lifting size Z value increases, and thus the amount of parallel processors required to perform decoding simultaneously for a single row block increases.

For example, the weight matrix *W*(**H_{BG2}**) consists of 4 rows and 14 columns, with weights of 3, 3, 2, 3, 3, 2, 3, 2, 3, 3, 3, 2, 2, 2, and the weight matrix $W \left({H}_{BG 2}^{′}\right)$ consisting of 3 rows and 13 columns and having a similar weight distribution to *W*(**H_{BG2}**) and the weight matrix $W \left({H}_{BG 2}^{"}\right)$ consisting of 2 rows and 12 columns and having a similar weight distribution to (**H_{BG2}**) can be configured as follows.$W \left({H}_{BG 2}^{′}\right) = \left[\begin{matrix}1 & 1 & 1 & 1 & 1 & 1 & 1 & 0 & 1 & 1 & 1 & 1 & 0 \\ 1 & 1 & 0 & 1 & 1 & 1 & 1 & 1 & 1 & 1 & 1 & 1 & 1 \\ 1 & 1 & 1 & 1 & 1 & 0 & 1 & 1 & 1 & 1 & 1 & 0 & 1\end{matrix}\right] ,$$W \left({H}_{BG 2}^{"}\right) = \left[\begin{matrix}2 & 1 & 1 & 2 & 1 & 1 & 2 & 1 & 1 & 2 & 1 & 1 \\ 1 & 2 & 1 & 1 & 2 & 1 & 1 & 1 & 2 & 1 & 2 & 1\end{matrix}\right] .$

If LDPC codes with the same code length can be generated using respective weight matrices *W*(**H_{BG2}**), $W \left({H}_{BG 2}^{′}\right)$, and $W \left({H}_{BG 2}^{"}\right)$ and the lifting size corresponding to each parity check matrix is *Z*₁, *Z*₂, *Z*₃, there is a relationship of ${Z}_{3} = \frac{14}{12} {Z}_{1} , {Z}_{2} = \frac{13}{12} {Z}_{1}$. Additionally, if each parallel processing processor *Zᵢ* is allowed in the LDPC decoder, the approximate decoding throughput of $W \left({H}_{BG 2}^{′}\right)$ can be 1.5 times that of *W*(**H_{BG2}**) and that of $W \left({H}_{BG 2}^{"}\right)$ can be 2 times that of *W*(**H_{BG2}**).

As such, when sufficient parallel processing processors are available, reducing the number of row blocks can increase the decoding throughput inversely. Therefore, for systems requiring very high decoding throughput, if more parallel processing processors can be applied, it is advantageous to keep the number of rows in the base matrix or weight matrix, that is, the number of row blocks in the parity check matrix, small.

While keeping the number of rows in the base matrix or weight matrix, that is, the number of row blocks of the parity check matrix, small may be beneficial in terms of decoding information throughput, configuring the number of row blocks too small can lead to serious constraints on algebraic characteristics such as the cycle characteristics or minimum distance characteristics of the LDPC code, resulting in performance degradation. Therefore, the base matrix or weight matrix must be determined by considering the system's target information throughput and target error correction capability simultaneously.

As an embodiment of the present disclosure, a method for improving code performance while increasing decoding information throughput is proposed. In particular, the present disclosure proposes algebraic characteristics that must be satisfied by the core matrix part of the base matrix or weight matrix, which is closely related to the system's maximum decoding throughput or peak data rate. Of course, if the parity check matrix does not include the second part of the parity check matrix composed of the submatrix C 1040, D 1050, and E 1060 of FIG. 10, the core matrix may be identical to the base matrix or weight matrix.

One of the conditions that the core matrix of the parity check matrix must satisfy is that when selecting two columns from the weight matrix corresponding to the core matrix that have only one non- zero element, non-zero entries must not be included in only one row, such as $\left[\begin{matrix}0 & 0 \\ ⋮ & ⋮ \\ {w}_{1} & {w}_{2} \\ ⋮ & ⋮ \\ 0 & 0\end{matrix}\right]$ (*w*₁, *w*₂ ≥ 1 ). Simple examples include $\left[\begin{matrix}{w}_{1} & {w}_{2} \\ 0 & 0\end{matrix}\right] , \left[\begin{matrix}0 & 0 \\ {w}_{1} & {w}_{2}\end{matrix}\right] , \left[\begin{matrix}{w}_{1} & {w}_{2} \\ 0 & 0 \\ 0 & 0\end{matrix}\right]$, $\left[\begin{matrix}0 & 0 \\ {w}_{1} & {w}_{2} \\ 0 & 0\end{matrix}\right]$, ... etc. Since the minimum distance of the parity check matrix corresponding to the weight matrix or its core matrix containing such a structure becomes less than *w*₁ + *w*₂, error floor phenomenon is highly likely to occur easily. Therefore, the non- zero entries must be located in different rows in any two columns where there is only one non- zero element, such as $\left[\begin{matrix}{w}_{1} & 0 \\ 0 & {w}_{2}\end{matrix}\right]$, $\left[\begin{matrix}{w}_{1} & 0 \\ 0 & {w}_{2} \\ 0 & 0\end{matrix}\right] , \left[\begin{matrix}{w}_{1} & 0 \\ 0 & 0 \\ 0 & {w}_{2}\end{matrix}\right]$, ... ,. This means that for base matrices, all non-zero entries located in columns with a weight of 1 are located in different rows. The content can be defined as conditions 3(a) and 3(b) below.

**Condition 3(a):** All columns of the base matrix or weight matrix corresponding to the core matrix have a weight of 2 or more, or the number of columns with a weight of 1 is at most 1.

**Condition 3(b):** If there are two or more columns with a weight of 1 among the columns of the base matrix or weight matrix corresponding to the core matrix, the non-zero entries contained in the columns with a weight of 1 are located in different rows.

The conditions 3(a) and 3 (b) mean that if the number of column blocks consisting only of a single circulant permutation matrix or a circulant matrix included in the core matrix is at most 1, or if the core matrices include 2 or more column blocks consisting only of a single circulant permutation matrix or a circulant matrix, the circulant permutation matrices or circular matrices with the size Z × Z must be included in different row blocks. Additionally, conditions 3(a) and (3b) are structures designed to prevent a severe error floor phenomenon, but if a superior error floor characteristic is to be obtained, the following condition 4 may be added. As described above, the circulant permutation matrix and the circulant matrix may have a size Z × *Z.*

**Condition 4:** In the parity check matrix corresponding to the core matrix, the weight of the column corresponding to the information word bit (or input bit or code block) is 3 or more.

The condition 4 can be applied to improve the error floor characteristic, even though the coding gain may decrease because no column corresponding to an information bit has weight 2, such as in the parity check matrix corresponding to the base matrix 2 *M*(**H_{BG2}**) of Equation 14.

The condition 4 means that if, in the parity check matrix for the QC-LDPC code, submatrix A 1010 does not contain a circulant matrix in which circulant permutation matrices of *Z* × *Z* size are overlapped, the weight of every column block of the submatrix A 1010 is 3 or more, and the weight of every column of the base matrix *M*(**A**) corresponding to the submatrix A 1010 is 3 or more. Additionally, it means that if, in the parity check matrix for the QC-LDPC code, the submatrix A 1010 includes at least one circulant matrix in which circulant permutation matrices of *Z* × *Z* size are overlapped, the weight of every column block of the submatrix A 1010 is 3 or more, and the sum of every column entry of the weight matrix *W*(**A**) corresponding to the submatrix A 1010 is 3 or more.

As another condition that the core matrix of the parity check matrix must satisfy, the condition that the weight matrix corresponding to the core matrix does not contain entries greater than or equal to 3 may be considered. Generally, if the core matrix of the weight matrix contains integer entries greater than or equal to 3, it means that three or more circulant permutation matrices correspond to that position, and if three or more circulant permutation matrices constituting a circulant matrix of size *Z* × *Z* are overlapped, the maximum cycle length is limited to 6, regardless of the *Z* value. Since the performance improvement effect of iterative decoding is reduced in the case of short cycle length, a parity check matrix corresponding to a weight matrix or core matrix containing entries with values of 3 or more is suitable for use when the code length is short or the code rate is relatively high. In this disclosure, since the design method of LDPC codes supporting various code rates and various code lengths is discussed, entries with values of 3 or more are not included in the core matrix of the weight matrix. (Of course, they may be included in the part corresponding to the single parity check extension part.) The above content can be defined as condition 5 below.

**Condition 5:** The weight matrix corresponding to the core matrix consists only of 0s and 1s, or only of 0s, 1s, and 2s.

As another condition that the core matrix must satisfy, the submatrix B 1020 of FIG. 10 corresponding to the first parity vector **w₁** must have a maximum rank to enable efficient encoding, and a restrictive structure as follows is desirable to prevent severe degradation of cycle characteristics.

**Condition 6(a):** If the weight matrix corresponding to the core matrix consists of 4 rows, the submatrix corresponding to B 1020 in the weight matrix and the base matrix is one of the following:
$\left[\begin{matrix}1 & 1 & 0 & 0 \\ 1 & 1 & 1 & 0 \\ 0 & 0 & 1 & 1 \\ 1 & 0 & 0 & 1\end{matrix}\right] , \left[\begin{matrix}1 & 1 & 0 & 0 \\ 0 & 1 & 1 & 0 \\ 1 & 0 & 1 & 1 \\ 1 & 0 & 0 & 1\end{matrix}\right] , \left[\begin{matrix}1 & 1 & 0 & 0 \\ 1 & 1 & 1 & 0 \\ 0 & 0 & 1 & 1 \\ 1 & 0 & 1 & 1\end{matrix}\right] , \left[\begin{matrix}1 & 1 & 0 & 0 \\ 0 & 1 & 1 & 0 \\ 1 & 1 & 1 & 1 \\ 1 & 0 & 1 & 1\end{matrix}\right] ,$
$\left[\begin{matrix}1 & 1 & 0 & 0 \\ 0 & 1 & 1 & 0 \\ 1 & 1 & 1 & 1 \\ 1 & 0 & 1 & 1\end{matrix}\right] , \left[\begin{matrix}1 & 1 & 0 & 0 \\ 0 & 1 & 1 & 0 \\ 1 & 0 & 1 & 1 \\ 1 & 1 & 1 & 1\end{matrix}\right]$

**Condition 6(b):** If the weight matrix corresponding to the core matrix consists of 3 rows, the submatrix of the base matrix corresponding to submatrix B 1020 is $\left[\begin{matrix}1 & 1 & 0 \\ 1 & 1 & 1 \\ 1 & 0 & 1\end{matrix}\right]$, and the weight matrix is one of the following:
$\left[\begin{matrix}1 & 1 & 0 \\ 1 & 1 & 1 \\ 1 & 0 & 1\end{matrix}\right] , \left[\begin{matrix}1 & 1 & 0 \\ 0 & 1 & 1 \\ 2 & 0 & 1\end{matrix}\right] , \left[\begin{matrix}2 & 1 & 0 \\ 0 & 1 & 1 \\ 1 & 0 & 1\end{matrix}\right] , \left[\begin{matrix}1 & 2 & 0 \\ 0 & 1 & 1 \\ 2 & 0 & 1\end{matrix}\right] , \left[\begin{matrix}1 & 2 & 0 \\ 0 & 1 & 2 \\ 2 & 0 & 1\end{matrix}\right] .$

**Condition 6(c):** If the weight matrix corresponding to the core matrix consists of 2 rows, the submatrix of the base matrix corresponding to submatrix B 1020 is $\left[\begin{matrix}1 & 1 \\ 1 & 1\end{matrix}\right]$, and the weight matrix is one of the following: $\left[\begin{matrix}1 & 1 \\ 2 & 1\end{matrix}\right] , \left[\begin{matrix}1 & 2 \\ 2 & 1\end{matrix}\right]$.

For reference, the condition 6(a) describes the case where the weight matrix and the base matrix are identical, and condition 6(b) has the same form as the base matrix only when the weight matrix is $\left[\begin{matrix}1 & 1 & 0 \\ 1 & 1 & 1 \\ 1 & 0 & 1\end{matrix}\right]$. In the base matrices or weight matrices shown in conditions 6(a), 6(b), and 6(c), 0 represents a zero matrix of *Z* × *Z* size, and 1 represents an identity matrix *I* = (*P*⁰) of size *Z* × *Z* or a circulant permutation matrix *P^{v}*(v > 0). Additionally, 2 represents a circulant matrix (*P*^{*v*₁} + *P*^{*v*₂}) of size *Z* × *Z* (*v*₁, *v*₂ ≥ 0, *v*₁ ≠ *v*₂)*.*

Generally, the upper bound for the cycle length can be predicted from the base matrix or weight matrix, but the cycle characteristics of the parity check matrix corresponding to the base matrix or weight matrix cannot be known. For example, if the submatrix B 1020 is $\left[\begin{matrix}I & I \\ {P}^{{v}_{1}} + {P}^{{v}_{2}} & I\end{matrix}\right]$ or $\left[\begin{matrix}I & I & 0 \\ {P}^{{v}_{1}} & I & I \\ {P}^{{v}_{2}} & 0 & I\end{matrix}\right]$*,* in each case, regardless of the v1, v2 value, the base matrix or weight matrix is the same as $\left[\begin{matrix}1 & 1 \\ 2 & 1\end{matrix}\right]$ or $\left[\begin{matrix}1 & 1 & 0 \\ 1 & 1 & 1 \\ 1 & 0 & 1\end{matrix}\right]$, but the cycle characteristics differ significantly. In the case $\left[\begin{matrix}I & I \\ {P}^{{v}_{1}} + {P}^{{v}_{2}} & I\end{matrix}\right]$, if at least one of v1 or v2 is 0, or ${v}_{1} ≡ {v}_{2} \left(mod\frac{Z}{2}\right)$ (or ${v}_{1} - {v}_{2} ≡ \frac{Z}{2} \left(mod Z\right)$), a large number of 4-cycles are generated, so basically v1 and v2 are configured to be an integer satisfying *v*₁, *v*₂(mod *Z*) > 0, ${v}_{1} ≢ {v}_{2} \left(mod\frac{Z}{2}\right)$ (or ${v}_{1} - {v}_{2} ≢ \frac{Z}{2} \left(mod Z\right)$ ). Similarly, in the case $\left[\begin{matrix}I & I & 0 \\ {P}^{{v}_{1}} & I & I \\ {P}^{{v}_{2}} & 0 & I\end{matrix}\right]$, if v1 = 0, a large number of 4-cycles are generated, so basically v1 is configured to be an integer satisfying *v*₁(mod *Z*) ≥ 1 and v2 is configured to be an integer satisfying *v*₂(mod *Z*) ≥ 0. The above is merely a method to eliminate 4-cycles, and the values of v1 and v2 can be restricted in various ways to obtain longer cycles.

If the communication system applies the information word bit puncturing described in [Table 9], additional conditions that the core matrix must satisfy may be added as follows.

**Condition 7:** In an LDPC encoding system where information word bits are punctured, a submatrix of a core matrix consisting only of columns corresponding to the punctured information word bits has at least one row with a row weight of 1.

Since bits punctured at the receiver are treated as bits erased during the reception process, it is determined that the probability of the punctured bit being 0 is equal to the probability of it being 1. This typically means 1 when decoding is performed using the LR value and 0 when using the LLR value, but it may be determined in a different form based on the values used during the decoding process. If LDPC decoding is performed based on a parity check matrix that does not satisfy condition 7, the punctured information word bits may not be decoded unless maximum likelihood (ML) decoding or pseudo ML decoding techniques are used. Since ML or pseudo ML decoding methods are not typically used because of their complexity, the parity check matrix can be decided to satisfy condition 7 in order to guarantee decoding success.

If the LDPC code is a QC-LDPC code, the parity check matrix can be expressed as in the following condition 8 because it can be expressed based on the lifting size Z value and the base matrix and/or weight matrix and/or exponent matrix, etc.

**Condition 8:** In a QC-LDPC encoding system in which puncturing of information word bits is applied in lifting size Z or multiples thereof, the submatrix of the base matrix consisting of only a number of columns corresponding to the submatrix of the core matrix consisting of only a*Z columns corresponding to the punctured a*Z (a: an integer greater than or equal to 1) information word bits has at least one row with a weight of 1. Additionally, the submatrix of the weight matrix consisting of a number of columns corresponding to the submatrix of the core matrix consisting of a*Z columns has at least one row with a weight of 1 and an entry of 1.

For example, in a QC-LDPC encoding system where 2Z bit puncturing is always applied to the information word bits, condition 8 means that a = 2.

Meanwhile, in the present disclosure, at least one of the conditions may be used to construct a parity check matrix. That is, the parity check matrix may be determined to satisfy one of the conditions or to satisfy a combination of at least two of the conditions.

As an embodiment of the present disclosure, a method for improving the error floor performance of an LDPC code is proposed. Generally, the error floor phenomenon of an LDPC code is greatly influenced by the cycle characteristics of the Tanner graph. However, since the cycle characteristics on the Tanner graph of a QC LDPC code are determined by the relationship between the base matrix and the exponent or cycle shift value of the circulant permutation matrix, not only the position of the circulant permutation matrix constituting the parity check matrix but also the cycle shift value must be appropriately selected.

In the present disclosure, algebraic properties are proposed for which the submatrix B 1020 corresponding to the first parity bits (or first parity bit vector) ***w*₁** = (*w*_{1,0}, *w*_{1,1}, *w*_{1,2}, ... , *w*_{1,*M*₁-1}) in the first part of the parity check matrix composed of submatrix A 1010 and B 1020 in FIG. 10 must be satisfied.

The submatrix B 1020 is *M*₁ × *M*₁ (or *m*_{*b*1}Z × *m*_{*b*1}*Z*) and the submatrix B1020 corresponds to a base matrix or weight matrix of size $\left(\frac{{M}_{1}}{Z}\right) \times \left(\frac{{M}_{1}}{Z}\right)$ (or *m*_{*b*1} × *m*_{*b*1}). Additionally, the first column block of submatrix B 1020 consists of three circulant permutation matrices. In this case, the circulant permutation matrix may include the identity matrix. That is, In the present disclosure, the circulant permutation matrix is defined as a matrix in the form of a circularly shifted matrix shifting each entry of the identity matrix by i, and if the i value is 0, the circulant permutation matrix can be the identity matrix. This may apply throughout the detailed description of the present disclosure. Additionally, the remaining column blocks of the submatrix B 1020 consist of two circulant permutation matrices or identity matrices. For convenience, the remaining column blocks are represented only when the identity matrix is composed of a double diagonal structure, but generally, there is no need to be limited thereto.

The specific example of the submatrix B 1020 is shown in Equation 15. The submatrix B 1020 can be determined based on at least one of the matrices included in Equation 15 below. However, the embodiments of the present disclosure are not limited thereto, and various matrices satisfying the characteristics (the first column block is composed of three circulant permutation matrices, the remaining column blocks are composed of two circulant permutation matrices or identity matrices) can be considered. [Equation 15] $\begin{matrix}{B}_{1} = \left[\begin{matrix}{P}^{a} & I & O \\ {P}^{b} & I & I \\ {P}^{c} & O & I\end{matrix}\right] , {B}_{2 , 1} = \left[\begin{matrix}{P}^{a} & I & O & O \\ {P}^{b} & I & I & O \\ O & O & I & I \\ {P}^{c} & O & O & I\end{matrix}\right] , \\ {B}_{2 , 2} = \left[\begin{matrix}{P}^{a} & I & O & O \\ O & I & I & O \\ {P}^{b} & O & I & I \\ {P}^{c} & O & O & I\end{matrix}\right] , {B}_{3} = \left[\begin{matrix}{P}^{a} & I & O & O & O \\ O & I & I & O & O \\ {P}^{b} & O & I & I & O \\ O & O & O & I & I \\ {P}^{c} & O & O & O & I\end{matrix}\right] \\ M \left({B}_{1}\right) = \left[\begin{matrix}1 & 1 & 0 \\ 1 & 1 & 1 \\ 1 & 0 & 1\end{matrix}\right] , M \left({B}_{2 , 1}\right) = \left[\begin{matrix}1 & 1 & 0 & 0 \\ 1 & 1 & 1 & 0 \\ 0 & 0 & 1 & 1 \\ 1 & 0 & 0 & 1\end{matrix}\right] , \\ M \left({B}_{2 , 2}\right) = \left[\begin{matrix}1 & 1 & 0 & 0 \\ 0 & 1 & 1 & 0 \\ 1 & 0 & 0 & 1 \\ 1 & 0 & 0 & 1\end{matrix}\right] , M \left({B}_{3}\right) = \left[\begin{matrix}1 & 1 & 0 & 0 & 0 \\ 0 & 1 & 1 & 0 & 0 \\ 1 & 0 & 1 & 1 & 0 \\ 0 & 0 & 0 & 1 & 1 \\ 1 & 0 & 0 & 0 & 1\end{matrix}\right] , \\ M \left({B}_{4 , 1}\right) = \left[\begin{matrix}1 & 1 & 0 & 0 & 0 & 0 \\ 0 & 1 & 1 & 0 & 0 & 0 \\ 1 & 0 & 1 & 1 & 0 & 0 \\ 0 & 0 & 0 & 1 & 1 & 0 \\ 0 & 0 & 0 & 0 & 1 & 1 \\ 1 & 0 & 0 & 0 & 0 & 1\end{matrix}\right] , M \left({B}_{4 , 2}\right) = \left[\begin{matrix}1 & 1 & 0 & 0 & 0 & 0 \\ 0 & 1 & 1 & 0 & 0 & 0 \\ 0 & 0 & 1 & 1 & 0 & 0 \\ 1 & 0 & 0 & 1 & 1 & 0 \\ 0 & 0 & 0 & 0 & 1 & 1 \\ 1 & 0 & 0 & 0 & 0 & 1\end{matrix}\right] \\ V \left({B}_{2 , 1}\right) = \left[\begin{matrix}a & 0 & - 1 & - 1 \\ b & 0 & 0 & - 1 \\ - 1 & - 1 & 0 & 0 \\ c & - 1 & - 1 & 0\end{matrix}\right] , V \left({B}_{3}\right) = \left[\begin{matrix}a & 0 & - 1 & - 1 & - 1 \\ - 1 & 0 & 0 & - 1 & - 1 \\ b & - 1 & 0 & 0 & - 1 \\ - 1 & - 1 & - 1 & 0 & 0 \\ c & - 1 & - 1 & - 1 & 0\end{matrix}\right]\end{matrix}$

In the Equation 15, the first column block of *B*₁, *B*_{2,1}, *B*_{2,2}, and *B*₃ consists of three distinct circulant permutation matrices *P^{a}, P^{b},* and *P^{c}.* Additionally, in Equation 15, for convenience, although only the cases where the *m*_{*b*1} values are 3, 4, 5, and 6 are shown, a submatrix B 1020 can be similarly defined for integers greater than that. Additionally, matrices that can be transformed into a submatrix B 1020 of the form above through an appropriate invertible transform process can be considered as algebraically identical matrices.

In the present disclosure, a method to improve the cycle characteristics for not only *B*₁, the *B*_{2,1}, *B*_{2,2}, and *B*₃ of the Equation 15, but also a larger submatrix B 1020 of a similar form is proposed. For convenience, detailed information regarding the method for analyzing the cycle characteristics of QC LDPC codes and some algebraic characteristics is omitted in this disclosure, but reference is made to [Myung2005].

### [Myung2005]

S. Myung, K. Yang, and J. Kim, "Quasi-Cyclic LDPC Codes for Fast Encoding," IEEE Transactions on Information Theory, vol. 51, No. 8, pp. 2894-2901, Aug. 2005.

If, as in Equation 15, the submatrix B 1020 has a dual diagonal structure of size where the remaining column blocks, excluding the first column block, consist of identity matrices, then for the convenience of encoding, at least two values among the indices (or circular shift values) *a, b, c* of the circulant permutation matrix of the first column block are configured to be the same. In this case, the matrix *ϕ* of the *Z* × *Z* size used in the encoding process becomes the identity matrix *I* or a simple permutation matrix *P^{x}* and the inverse matrix *ϕ*⁻¹ of *ϕ* is simplified to the identity matrix *I or P^{-x},* making the encoding process concise. (For details on the encoding process of QC LDPC codes, refer to [Myung2005].) As a specific example, if *a* = *c* is configured, since *ϕ* becomes *P^{b}* and *ϕ*⁻¹ becomes *P^{-b}*, efficient encoding can be performed. Similarly, if *a = b* is configured, since *ϕ* becomes *P^{c}* and *ϕ*⁻¹ becomes *P^{-c},* efficient encoding can be performed.

However, in the case where *a = c ≠ b,* according to the structure shown in the following Equation 16, there always exist *Z* cycles of length 2*m*_{*b*1} on the Tanner graph. In other words, if the value of *m*_{*b*1} is fixed, regardless of the lifting size *Z* and the exponent *a*(= *c*) value, a cycle of length 2*m*_{*b*1} always exists. (For details on the cycle characteristics of QC LDPC codes, refer to [Myung2005]) [Equation 16] $\left[\begin{matrix}{P}^{a} & I & ∗ & ∗ & ∗ \\ ∗ & I & I & ∗ & ∗ \\ ∗ & ∗ & ⋱ & ⋱ & ∗ \\ ∗ & ∗ & ∗ & I & I \\ {P}^{a} & ∗ & ∗ & ∗ & I\end{matrix}\right]$

Furthermore, in the case of *a* = *b*, because of the structure as shown in the following Equation 17, regardless of the lifting size *Z* and exponent *a*(= *b*) value, there is always a cycle shorter than 2*m*_{*b*1}. [Equation 17] $\left[\begin{matrix}{P}^{a} & I & ∗ \\ {P}^{b} & I & ∗ \\ ∗ & ∗ & ∗\end{matrix}\right] , \left[\begin{matrix}{P}^{a} & I & ∗ & ∗ \\ ∗ & I & I & ∗ \\ {P}^{b} & ∗ & I & ∗ \\ ∗ & ∗ & ∗ & ∗\end{matrix}\right]$

If *m*_{*b*1} value is appropriately large, the cycle characteristics of the Tanner graph corresponding to the structure of Equations 16 and 17 may not have a significant effect on the performance of the LDPC code. However, if *m*_{*b*1} value is relatively small, there is a possibility that BLER will increase because of the error floor phenomenon, and this means that the lower the system's target BLER is, the more significant the problem becomes.

In order to solve this problem, in the present invention, a method to improve cycle characteristics is proposed by limiting such that the indices (or circular shift values) *a, b, c* of the circulant permutation matrices constituting the first column block of a submatrix B 1020 having a structure like Equation 15 satisfies specific algebraic conditions. Additionally, the method explains that it has the characteristic of improving cycle characteristics while increasing the computational complexity related to the *ϕ*⁻¹ matrix required in the LDPC encoding process to a reasonable level.

If, for a parity check matrix of a QC LDPC code, the lifting size *Z* is *Z* = *p* · *2^{L},* (where *p* is an odd number and *L* is an integer greater than or equal to 0), then the indices (or circular shift values) *a, b, c* of the circulant permutation matrices constituting the first column block of the submatrix B 1020 are distinct integers and satisfy at least some or all of the following conditions:

**Exponent condition 1a**: At least one of the differences between two exponents (circular shift value) has a greatest common divisor with the lifting size *Z* that is either 1 or the smallest divisor of *Z* greater than 1. (In other words, it is coprime to *Z* or has the least divisor of *Z* that is greater than 1 as its greatest common divisor.)

**Exponent condition 1b:** Two of the differences between two exponents have a common divisor with the lifting size *Z*, the common divisor being either 1 or the smallest divisor of Z greater than 1.

**Exponent condition 2a:** At least one of the differences between the two exponents is $\frac{Z}{{2}^{i}}$ (0 ≤ *i* ≤ *L*)*.*

**Exponent condition 2b:** At least one of the differences between the two exponents is $\frac{Z}{{2}^{i}}$ (1 ≤ *i* ≤ *L)* if *p* is 1 and *L >* 1, and is $\frac{Z}{{2}^{i}}$ (1 ≤ *i < L*) if *p* is an odd number greater than or equal to 3 and *L* > 0.

For reference, the difference between the indices used in the exponent conditions means |*a - b*|, |*b* - *c*|, |*c - a*|, etc.

According to the exponent condition 1a, if the difference between the two exponents is coprime to *Z*, the length of the cycle determined by the circulant permutation matrix related to the two exponents is maximized. For example, if the value of |*a - b*| is coprime to *Z*, the length of a cycle on a Tanner graph determined by $\left[\begin{matrix}{P}^{a} & I & ∗ \\ {P}^{b} & I & ∗ \\ ∗ & ∗ & ∗\end{matrix}\right]$ of the Equation 17 is 4Z. If the greatest common divisor of |*a - b*| and *Z* is *D,* the cycle length becomes 4*Z*/*D*. Consequently, as the *Z* value increases, the cycle length also increases.

As another example, when the value of |*a - c*| is coprime to *Z*, the cycle length determined by the structure of Equation 16 is 2*m*_{*b*1}*Z*16. If the greatest common divisor of |*a - c*| and *Z* is *D*, the cycle length becomes 2*m*_{*b*1}*Z*/*D.* Consequently, it can be seen that the cycle length is not fixed regardless of the Z value, but rather increases as the value of Z increases. Considering only the cycle characteristics, it is desirable for the difference between the exponents to be coprime to *Z* each other; however, depending on the situation and other conditions, the exponent can be selected such that the greatest common divisor D is small (for example, to become the least divisor of Z to be greater than 1). For example, if the difference between the exponents cannot satisfy the characteristic of being coprime to Z each other, it is desirable to select an exponent that has a smaller greatest common divisor.

The exponent condition 1b is a condition designed to further improve cycle characteristics by more restricting the exponent condition than exponent condition 1a. For example, when the value of |a *- b*| and |*b* - *c*| are coprime to *Z* each other, not only cycle characteristics related to exponents a and b are improved, as in $\left[\begin{matrix}{P}^{a} & I & ∗ \\ {P}^{b} & I & ∗ \\ ∗ & ∗ & ∗\end{matrix}\right]$, but also cycle characteristics related to exponents b and c are also improved similarly, as in $\left[\begin{matrix}∗ & ∗ & ∗ \\ {P}^{b} & ∗ & I \\ {P}^{c} & ∗ & I\end{matrix}\right]$. (The same holds for Equation 15 and other forms of submatrix B extended based on Equation 15.)

For Equation 15 and another form of submatrix B extended based on Equation 15, the matrix *ϕ* required in the encoding process is defined as *ϕ = P^{a} + P^{b} + P^{c}* when *a, b, c* are all different. For such a matrix *ϕ*, it is not easy to calculate *ϕ*⁻¹, and the density of weights of the matrix *ϕ*⁻¹ also generally tends to be high-density rather than low-density. That is, there is a characteristic where a matrix *ϕ* with low-density properties cannot guarantee the low-density properties of the matrix *ϕ*⁻¹. Since this high-density property of the matrix *ϕ*⁻¹ causes an increase in encoding complexity, it is desirable for the density of the matrix *ϕ*⁻¹ to be as low as possible, and it is desirable for matrix *ϕ*⁻¹ to have a simple structure.

The exponent conditions 2a and 2b are conditions for simplifying the matrix *ϕ*⁻¹ as much as possible for efficient LDPC coding. For example, in the case of $\left|a-c\right| = \frac{Z}{{2}^{i}}$ in the exponent condition 2a, with *ϕ*^{2*ⁱ*} = *P*²*^{ⁱa} + P*²*^{ⁱb} + P*^{2*ⁱc*} = *P*^{2*ⁱa*} (*I + P*^{2*ⁱ*(*c-a*)}) *+ P*^{2*ⁱb*} = *P*^{2*ⁱ·b*}, it becomes *ϕ*⁻¹ = *P*^{-2*ⁱb*} . ϕ^{2*ⁱ*-1}. Here, as *ϕ*^{2*ⁱ*-1} is *ϕ*^{2*ⁱ*-1} = *ϕ*^{2*ⁱ*-1} · *ϕ*^{2*ⁱ*-2} ..... *ϕ*² · *ϕ* = (*P*^{2^{(*i*-1)}}*^{a} + P*^{2^{(*i-*1)}}*^{b} + P*^{2^{(*i*-1)}*c*})(*P*^{2^{(*i*-2)}}*^{a} + P*^{2^{*(i-*2)}}*^{b} + P*^{2^{*(i-*2)}*c*}) · ··· · (*P*²*^{a} + P*²*^{b} + P*^{2*c*}) · (*P*^{a} *+ P^{b} + P^{c}*), *ϕ*⁻¹ can be determined relatively simply, but it can be seen that the computational complexity of *ϕ*⁻¹ increases as the value *i* increases. Therefore, depending on the complexity acceptable in the system, it can be used by appropriately limiting the value *i*. Typically, it is preferable to use value *i* within the range of 0 ≤ *i* ≤ 4, but larger values may be used depending on the system's allowable range.

For reference, the operation *P^{x} · v^{T}* of multiplying an arbitrary bit string of length *Z* by a circulant permutation matrix *P^{x}* of size *Z* × *Z* is not an actual matrix multiplication operation, but it is equivalent to performing a circular shift by *x* bits against a bit string *v^{T}.* In other words, since it can actually be implemented as a bit shift operation rather than a matrix multiplication, the operation signifies a very low-complexity operation or action. Furthermore, in the process of performing the operation of *ϕ*^{2*ⁱ*-1} · *v^{T},* computational complexity can be minimized through stepwise calculations, such as *v^{T}* = *ϕ*^{2*ⁱ*-1}(···*(ϕ*²(*ϕ* · *v^{T}*)), rather than expanding each term of *ϕ*^{2*ⁱ*-1}. As a simple example, the operation can be performed in the following way:
$\left({P}^{2 a}+{P}^{2 b}+{P}^{2 c}\right) ⋅ \left({P}^{a}+{P}^{b}+{P}^{c}\right) ⋅ {{v}_{¯}}^{T} = {P}^{3 a} \left(I+{P}^{2 \left(b-a\right)}+{P}^{2 \left(c-a\right)}\right) ⋅ \left(\begin{matrix}I + \\ {P}^{b - a} + {P}^{c - a}\end{matrix}\right) ⋅ {{v}_{¯}}^{T} = {P}^{3 a} \left(I+{P}^{2 \left(b-a\right)}+{P}^{2 \left(c-a\right)}\right) ⋅ \left({{v}_{¯}}^{T}+{P}^{b - a}⋅{{v}_{¯}}^{T}+{P}^{c - a}⋅{{v}_{¯}}^{T}\right) = {P}^{3 a} \left(\begin{matrix}I + \\ {P}^{2 \left(b-a\right)} + {P}^{2 \left(c-a\right)}\end{matrix}\right) ⋅ {{v}_{¯}}_{1}^{T} = {P}^{3 a} \left({{v}_{¯}}_{1}^{T}+{P}^{2 \left(b-a\right)}⋅{{v}_{¯}}_{1}^{T}+{P}^{2 \left(c-a\right)}⋅{{v}_{¯}}_{1}^{T}\right) = {P}^{3 a} ⋅ {{v}_{¯}}_{2}^{T} .$

In the exponent condition 2a, even in case of $\left|a-b\right| = \frac{Z}{{2}^{i}}$ or $\left|b-c\right| = \frac{Z}{{2}^{i}}$, encoding can be performed by determining *ϕ*⁻¹ in the same way. However, if the differences between all two exponents are of the $\frac{Z}{{2}^{i}}$ form, the cycle characteristics are likely to deteriorate. Therefore, for efficient encoding and good cycle characteristics, a method can be considered such that at least one of the differences between the two exponents satisfies the characteristic of $\frac{Z}{{2}^{i}}$ (0 ≤ *i* ≤ *L*) and the remaining exponent differences satisfy exponent condition 1a or exponent condition 1b. Additionally, if the difference between the two exponents is $\frac{Z}{{2}^{i}}$ and there is a case where at least one of exponent condition 1a or exponent condition 1b is satisfied, the exponents can be selected.

The exponent condition 2b is a condition that limits the exponent condition more than exponent condition 2a to enable efficient encoding while further improving cycle characteristics. If exponent condition 2b is satisfied, the encoding complexity increases slightly compared to existing 5G LDPC codes, but there is the advantage of improved cycle characteristics. Of course, if exponent condition 2b is not satisfied, the exponents can be determined by considering exponent condition 2a. For reference, excluding the case where $\frac{Z}{{2}^{i}} = 1$ is satisfied in exponent condition 2a, it can be seen that the difference between the two exponents is never coprime with *Z*. That is, the difference between *Z* and the two exponents has a common divisor greater than 1. The existence of *i* satisfying $\frac{Z}{{2}^{i}} = 1$ means *Z* = *2^{L}* wherein the exponent condition 2b must be satisfied, and therefore the difference between *Z* and the two exponents is not coprime and has 2^{*L*-*i*} as a common divisor according to the condition 1 ≤ *i* < *L.*

As an embodiment of the present disclosure, a more specific example of constituting the submatrix B 1020 of FIG. 10 using the exponent conditions is described.

First, a communication or broadcasting system is considered in which a set of lifting sizes is defined as shown in Tables 3 through 8, such as 5G, and only the lifting sizes included in the set of lifting sizes can be applied. Additionally, a separate parity check matrix or exponent matrix may be defined for each set of lifting sizes. That is, in the case of Tables 3 through 8, a parity check matrix or exponent matrix, etc., may be defined for a total of 8 set indices.

Let *a, b, c* be determined as follows in a submatrix B of Equation 15 and another form extended based on Equation 15. Generally, since the values of the indices, *a, b, c* for the submatrix B of the parity check matrix corresponding to *i_{LS} = k (k* = 0, 1, 2, ...) may all be different, for convenience, they are expressed as *aₖ, bₖ, cₖ.*

**Exponent selection example 1** (*i_{LS} = k*)
- *aₖ* is an arbitrary integer.
- *bₖ* is *bₖ = aₖ + sₖ,* where sₖ is an integer satisfying gcd(*sₖ, Zₖ*) = 1, that is, among the indices corresponding to the submatrix B, *aₖ* and *bₖ* are integers satisfying gcd(|*aₖ* - *bₖ*|, *Zₖ*) *=* 1 . Here gcd(x, y) represents the greatest common divisor of *x , y* and *Zₖ* represents any lifting size belonging to the set of lifting sizes corresponding to *i_{LS} = k.*
- *cₖ* is *cₖ = aₖ + tₖ,* where *tₖ* is one of the lifting sizes smaller than the largest lifting size values *Z*_{*k*,max} among the lifting size values belonging to the lifting size set corresponding to *i_{LS} = k.*

If calculating the difference between each exponent for the submatrix B determined through the exponent selection example 1, since |*aₖ - bₖ*| = |*sₖ*| for an arbitrary lifting size *Zₖ,* the exponent condition 1a is satisfied, and, since *tₖ* is one of the *Zₖ* values and each Z*ₖ* value is a multiple of the others (2*ⁱ* multiple relationship) in |*bₖ - cₖ*| = |*sₖ - tₖ*|, according to the definition of *sₖ,* 1 = gcd(*sₖ*, *Zₖ*) = gcd(*sₖ - Zₖ, Zₖ*) = gcd(*sₖ - tₖ*, *Zₖ*) and exponent condition 1b is also satisfied. However, since $\left|{c}_{k}-{a}_{k}\right| = {t}_{k} = \frac{{Z}_{max}}{{2}^{i}} = p ⋅ {2}^{\left(L-i\right)}$, exponent condition 2a and exponent condition 2b depends on the lifting size *Zₖ*. For example, in the case of *Zₖ > tₖ,* exponent conditions 2a and 2b are always satisfied, but in the case of *Zₖ* ≤ *tₖ* where *cₖ* ≡ *aₖ + tₖ* ≡ *aₖ* (mod *Zₖ*) holds, since the circulant permutation matrices of size *Zₖ* × *Zₖ, P^{aₖ}* and *P^{cₖ}* become virtually identical, exponent conditions 2a and 2b may not be satisfied. In other words, in the case of *Zₖ* ≤ *tₖ,* the structure becomes as shown in Equation 16, meaning that the cycle characteristics are not improved. In conclusion, to improve cycle characteristics for lifting sizes of various lengths, it is desirable that the *tₖ* value be determined to be as small as possible.

However, it is highly likely that encoding complexity will increase significantly because of matrix *ϕ*⁻¹ related operations in the case that the lifting size *Zₖ* value for LDPC encoding is relatively large compared to the *tₖ* value (i.e., when the *i* value is large in $\frac{{Z}_{k}}{{t}_{k}} = {2}^{i}$). Therefore, the *tₖ* value can be selected considering cycle characteristics and encoding complexity. If only the improvement of cycle characteristics is considered, the smallest lifting size among the lifting size values belonging to the set of lifting sizes corresponding to *i_{LS} = k* can be selected as *tₖ.* Additionally, when considering a limited increase in encoding complexity, a lifting size greater than the smallest lifting size and smaller than the largest lifting size among the lifting size values belonging to the lifting size set corresponding to *i_{LS} = k* may be selected as *tₖ.* Typically, when the lifting sizes included in the lifting size set are *Z*₁ = *p ·* 2^{*j*₁}, *Z*₂ = *p ·* 2^{*j*₂}, ... , *Z*ₘₐₓ = *p ·* 2^{*j*ₘₐₓ} (*j*₁ < *j*₂ < ··· < *j*ₘₐₓ), the value of *tₖ* can be configured to *tₖ* = *p* · 2ⁱ(*j*₁ *< i* ≤ *j*ₘₐₓ). Generally, if the values of *j*₁, *j*₂, ..., *j*ₘₐₓ are not consecutive integer values, the value *i* may be selected as an integer other than *j*₂, *j*₃, .... In addition to the above embodiments, for other embodiments *tₖ* may also be selected based on various conditions as described above, but for convenience of explanation, a detailed description may be omitted.

For convenience, when *a* = 1, that is *P^{a} = P*¹, is configured as a specific example of the exponent selection method, an example of exponent selection is shown below.

**Exponent selection example 2** (*i_{LS} = k*)
- ${a}_{k} = 1 \left(\to {P}^{a}=P\right)$
- *bₖ* = 0 (If configured to *sₖ* = -1, gcd(|*aₖ - bₖ*|, *Zₖ*) *= 1, P^{b}* = *I*)
- *cₖ* is *cₖ* = 1 *+ tₖ* (or *cₖ =* 1 - *tₖ),* where *tₖ* is one of the lifting sizes smaller than the largest lifting size *Z*_{k,max} among the lifting size values belonging to the lifting size set corresponding to *i_{LS}* = *k.*

If calculating the difference between each exponent for the submatrix B determined through the exponent selection example 2, since it always holds that gcd(|*aₖ - bₖ*|, *Zₖ*) *=* 1 for any lifting size *Zₖ* as |*aₖ - bₖ*| = 1 and it holds that 1 = gcd(1, *Zₖ*) = gcd(1 + *Zₖ, Zₖ*) = gcd(1 + *tₖ, Zₖ)* as |*bₖ - cₖ*| = 1 *+ tₖ*, exponent condition 1a and exponent condition 1b can be satisfied. In the case of *bₖ =* 0 as in the exponent selection example 2, exponent conditions 1a and 1b can be satisfied for any *aₖ* satisfying not only *aₖ* = 1, but also generally gcd(*aₖ, Zₖ*) = 1. That is, the submatrix B configured as *aₖ = a, bₖ = 0, cₖ = a + tₖ* can satisfy exponent condition 1a and exponent condition 1b for an integer *a* where gcd(*a*, *Zₖ*) = 1. Additionally, since $\left|{c}_{k}-{a}_{k}\right| = {t}_{k} = \frac{{Z}_{max}}{{2}^{i}} = p ⋅ {2}^{\left(L-i\right)}$, the exponent condition 2a and exponent condition 2b is satisfied depending on the lifting size *Zₖ*. *tₖ* (or *cₖ*) can be selected based on various conditions, considering cycle characteristic improvement and encoding complexity as previously explained.

Specific examples related to exponent selection example 2 are described below.

Given a set of lifting sizes as in Table 8, a specific example of submatrix B is shown in the following Equation 18. Equation 18 represents an example of submatrix B in the parity check matrix for *i_{LS}* = 0 in Table 8. (This is an example of configuring (*P^{a}, P^{b}, P^{c}*) of the matrices in Equation 15.) Submatrix B can be determined based on at least one of the matrices included in Equation 18 below. However, the embodiments of the present disclosure are not limited thereto. That is, the following example describes the case where 32 of the lifting sizes is selected, but any one of the lifting sizes included in Table 8 above may be selected. Therefore, various matrices can be considered based on c determined according to the lifting size. [Equation 18] $\begin{matrix}- a = 1 , b = 0 , c = 1 + 32 = 33 \left(Select 32 from lifting sizes\right) \\ {B}_{1} = \left[\begin{matrix}{P}^{1} & I & O \\ I & I & I \\ {P}^{33} & O & I\end{matrix}\right] , {B}_{2 , 1} = \left[\begin{matrix}{P}^{1} & I & O & O \\ I & I & I & O \\ O & O & I & I \\ {P}^{33} & O & O & I\end{matrix}\right] , {B}_{2 , 2} = \left[\begin{matrix}{P}^{1} & I & O & O \\ O & I & I & O \\ I & O & I & I \\ {P}^{33} & O & O & I\end{matrix}\right] , {B}_{3} = \\ \left[\begin{matrix}{P}^{1} & I & O & O & O \\ O & I & I & O & O \\ I & O & I & I & O \\ O & O & O & I & I \\ {P}^{33} & O & O & O & I\end{matrix}\right] , {B}_{4 , 1} = \left[\begin{matrix}{P}^{1} & I & O & O & O & O \\ O & I & I & O & O & O \\ O & O & I & I & O & O \\ I & O & O & I & I & O \\ O & O & O & O & I & I \\ {P}^{33} & O & O & O & O & I\end{matrix}\right] , \\ {B}_{4 , 2} = \left[\begin{matrix}{P}^{1} & I & O & O & O & O \\ O & I & I & O & O & O \\ I & O & I & I & O & O \\ O & O & O & I & I & O \\ O & O & O & O & I & I \\ {P}^{33} & O & O & O & O & I\end{matrix}\right] .\end{matrix}$

In the case of Equation 18, if the lifting size *Z* value in the 0th lifting size set is selected as 32 or less, such as 8, 16, or 32, then *P*³³ = P¹ because from 33 ≡ 1 (mod Z), since effectively the matrix *ϕ* becomes the identity matrix I and *ϕ*⁻¹ also becomes the identity matrix *I*, the encoding process becomes concise, whereas there is a disadvantage that cycle characteristics are not improved. If a limited increase in encoding complexity is considered while improving cycle characteristics, the exponent pairs (*a, b, c*) corresponding to (*P^{a}, P^{b}, P^{c}*) in the submatrix having the structure of Equation 18 may have the following combinations.

**[Table 10]**

| ***Set index** (i _{LS)}* | (***a, b***) | ***c*** |
|---|---|---|
| 0 | | 17 or 3 3 or 6 5 (or 129) |
| 1 | | 25 or 49 or 97 (or 193) |
| 2 | | 2 1 or 4 1 or 8 1 (or 161) |
| 3 | (*a, b*) = (1,0) | 1 5 or 2 9 or 5 7 (or 113) |
| 4 | | 1 9 or 3 7 or 7 3 (or 145) |
| 5 | | 2 3 or 4 5 or 8 9 (or 177) |
| 6 | | 2 7 or 5 3 (or 105) |
| 7 | | 3 1 or 6 1 (or 121) |

The Table 10 is merely an example, and generally, *c = t +* 1 can be determined by selecting *t* which is one of the lifting size values smaller than Zmax.

As one embodiment of the present disclosure, the c value may also be determined based on the largest lifting size among lifting sizes smaller than a specific reference value. To explain in detail, if the reference value is configured to 96 , the numbers 96 or less in each lifting size set in a system using lifting size sets such as those shown in [Table 3] through [Table 8], are 64 , 96, 80, 56, 72, 88, 52, and 60. Therefore, if the c value corresponding to the parity check matrix defined according to each lifting size set index based on the given reference value in each lifting size set is determined, the c value can be defined as 65, 97, 81, 57, 73, 89, 53, and 61 in order according to each lifting size set index. If the reference value is configured to 48, the c value can be defined in the same way as 33, 49, 41, 29, 37, 45, 27, and 31 in order according to each lifting size set index. For reference, when using a set of lifting sizes excluding the numbers inside ( ) in [Table 3] or [Table 8], if the i-th largest lifting size among the lifting sizes included in the set of lifting sizes where *i_{LS}= 1* is determined as the reference value, the c value corresponding parity check matrix defined according to each lifting size set index is characterized by being determined as an integer obtained by adding 1 to the i-th largest lifting size in each set.

Additionally, for uniformity of the encoding method, the i-th largest lifting size in each set of lifting sizes may be selected (i = 2, 3, 4, ...). For example, in a system using a set of lifting sizes as in [Table 3], the 5th largest numbers in each set of lifting sizes are 16, 24, 20, 14, 18, 22, 13, and 15. Therefore, if the c value corresponding to the parity check matrix defined according to each lifting size set index based on the 5th largest number in each lifting size set is determined (i = 5), the *c* value can be defined as 17, 25, 21, 15, 19, 23, 14, and 16 in order according to each lifting size set index. In the same way, if the *c* value corresponding to the parity check matrix defined according to the lifting size set index based on the 4th largest number in each lifting size set is determined (i = 4), the *c* value can be defined as 33, 49, 41, 29, 37, 45, 27, and 31 in order according to the lifting size set index. In the same way, if the c value corresponding to the parity check matrix defined according to the lifting size set index based on the 3rd largest number in each lifting size set is determined (i = 3), the *c* value can be defined as 65, 97, 81, 57, 73, 89, 53, and 61 in order according to the lifting size set index. In the same way, the *c* value corresponding to the parity check matrix defined according to the lifting size set index based on the 2nd largest number in each lifting size set is determined (i = 2), the value *c* can be defined as 129, 193, 161, 113, 145, 177, 105, and 121 in order according to the lifting size set index.

In a system using the lifting size sets of values excluding values inside ( ) in [Table 8], the 5th largest number in each lifting size set is 32, 48, 40, 28, 36, 44, 26, 30. Therefore, if the c value corresponding to the parity check matrix defined according to each lifting size set index based on the 5th largest number in each lifting size set is determined (i = 5), the *c* value can be defined as 33, 49, 41, 29, 37, 45, 27, and 31 in order according to the lifting size set index. In the same way, if the *c* value corresponding to the parity check matrix defined according to the lifting size set index based on the 4th largest number in each lifting size set is determined (i = 4), the *c* value can be defined as 65, 97, 81, 57, 73, 89, 53, and 61 in order according to the lifting size set index. In the same way if the *c* value corresponding to the parity check matrix defined according to the lifting size set index based on the 3rd largest number in each lifting size set is determined (i = 3), the *c* value can be defined as 129, 193, 161, 113, 145, 177, 105, and 121 in order according to the lifting size set index. In the same way, the *c* value corresponding to the parity check matrix defined according to the lifting size set index based on the 2nd largest number in each lifting size is determined (i = 2), the *c* value can be defined as 257, 385, 321, 225, 289, 353, 209, and 241 in order according to the lifting size set index.

According to the (*P^{a}, P^{b}, P^{c}*) = (*P, I, P^{c}*) pairs shown in the Equation 18, Table 10, and corresponding embodiment, the *ϕ* matrix becomes *ϕ* = *P + I + P^{c},* and according to the exponent selection example 2, if the lifting size Z*ₖ* value is less than or equal to (c - 1), c ≡ 1 (mod *Zₖ*) holds true, and ultimately cycle characteristics are not improved as *P^{a}* = *P* = *P^{c},* but efficient LDPC encoding is possible by utilizing the fact that *ϕ = I + P + P^{c} = I* = *ϕ*⁻¹ holds true. In the case that the lifting size *Zₖ* value is greater than (*c* - 1), there exists *i* satisfying (*P*)^{2*ⁱ*} = (*P^{c}*)^{2*ⁱ*} and this becomes (*i* ≥ 1 a) *ϕ*²*^{ⁱ} = I,* and therefore, although the encoding complexity increases by utilizing the *ϕ*⁻¹ = *ϕ*^{2*ⁱ*-1} = *ϕ*^{2*ⁱ*-1} *· ϕ*^{2*ⁱ*-2} · ··· · *ϕ*² *· ϕ*_{property}, efficient LDPC encoding is possible. Here, the cycle length determined by *P^{a}* and *P^{c}* increases from the existing 2*m*_{*b*1} to 2m_{*b*1} · *Z*/*D* = 2*m*_{*b*1} · 2*ⁱ* = 2^{*i*+1} · *m*_{*b*1}. The cycle length determined by *P^{a}* and *P^{b}* or *P^{b}* and *P^{c}* increases significantly in proportion to the *Z* value because it satisfies exponent condition 1a and exponent condition 1b.

For convenience, when *a* = 0, that is, *P^{a} = I* is configured as a specific example of the exponent selection method, an example of exponent selection is shown below.

**Exponent selection example 3** (*i_{LS} = k)*
- ${a}_{k} = 0 \left(\to {P}^{a}=I\right)$
- *bₖ =* 1 (if *sₖ =* 1 configured, gcd(|*aₖ - bₖ*|, *Zₖ*) *= 1, P^{b}* = *P*)
- *cₖ* is *cₖ = tₖ* (or *cₖ = -tₖ*), where *tₖ* is one of the smaller lifting sizes than the largest lifting *Z*_{*k*,max} among the lifting size values belonging to the lifting size set corresponding to *i_{LS} = k.*

If calculating the difference between each exponent for the submatrix B determined through the exponent selection example 3, since it always hold that gcd(|*aₖ - bₖ*|, *Zₖ*) *=* 1 for any lifting size *Zₖ* as |*aₖ - bₖ*| = 1 and it holds that 1 = gcd(1, *Zₖ*) = *gcd*(*Zₖ* - 1, *Zₖ*) = gcd(*tₖ* - 1, *Zₖ*) as |*bₖ - cₖ*| *= tₖ* - 1, exponent condition 1a and exponent condition 1b can be satisfied. In the case of *aₖ =* 0 as in the exponent selection example 3, exponent conditions 1a and 1b can be satisfied for any *bₖ* satisfying not only *bₖ* = 1, but also generally gcd(*bₖ*, *Zₖ*) = 1. That is, the submatrix B configured as *aₖ =* 0, *bₖ = b, cₖ = tₖ* can satisfy exponent condition 1a and exponent condition 1b for an integer *a* where *gcd*(*b, Zₖ*) *=* 1. Additionally, since $\left|{c}_{k}-{a}_{k}\right| = {t}_{k} = \frac{{Z}_{max}}{{2}^{i}} = p ⋅ {2}^{\left(L-i\right)}$, the exponent condition 2a and exponent condition 2b is satisfied depending on the lifting size *Zₖ*. *tₖ* (or *cₖ*) can be selected based on various conditions, considering cycle characteristic improvement and encoding complexity as previously explained.

Specific examples related to exponent selection example 3 are described below.

Given a set of lifting sizes as in Table 8, a specific example of submatrix B is shown in the following Equation 19. Equation 19 represents an example of submatrix B in the parity check matrix for *i_{LS} =* 0 in Table 8. (This is an example of configuring (*P^{a}, P^{b}, P^{c}*) of the matrices in Equation 15.) Submatrix B can be determined based on at least one of the matrices included in Equation 19 below. However, the embodiments of the present disclosure are not limited thereto. That is, the following example describes the case where 32 of the lifting sizes is selected, but any one of the lifting sizes included in Table 8 above may be selected. Therefore, various matrices can be considered based on c determined according to the lifting size. $\begin{matrix}- a = 0 , b = 1 , c = 32 \left(Select 32 from lifting sizes\right) \\ {B}_{1} = \left[\begin{matrix}I & I & O \\ P & I & I \\ {P}^{32} & O & I\end{matrix}\right] , {B}_{2 , 1} = \left[\begin{matrix}I & I & O & O \\ P & I & I & O \\ O & O & I & I \\ {P}^{32} & O & O & I\end{matrix}\right] , {B}_{2 , 2} = \left[\begin{matrix}I & I & O & O \\ O & I & I & O \\ P & O & I & I \\ {P}^{32} & O & O & I\end{matrix}\right] , {B}_{3} = \\ \left[\begin{matrix}I & I & O & O & O \\ O & I & I & O & O \\ P & O & I & I & O \\ O & O & O & I & I \\ {P}^{32} & O & O & O & I\end{matrix}\right] , {B}_{4 , 1} = \left[\begin{matrix}I & I & O & O & O & O \\ O & I & I & O & O & O \\ O & O & I & I & O & O \\ P & O & O & I & I & O \\ O & O & O & O & I & I \\ {P}^{32} & O & O & O & O & I\end{matrix}\right] , \\ {B}_{4 , 2} = \left[\begin{matrix}I & I & O & O & O & O \\ O & I & I & O & O & O \\ P & O & I & I & O & O \\ O & O & O & I & I & O \\ O & O & O & O & I & I \\ {P}^{32} & O & O & O & O & I\end{matrix}\right] .\end{matrix}$ 19]

In the case of Equation 19, if the lifting size *Z* value in the 0th lifting size set is selected as 32 or less, such as 8, 16, or 32, then *P³²* = *P*⁰ *= I* because from 32 ≡ 0 (mod *Z*), since effectively the matrix *ϕ* becomes a circulant permutation matrix *P* and *ϕ*⁻¹ also becomes a circulant permutation matrix *P*⁻¹, the encoding process becomes concise, whereas there is a disadvantage that cycle characteristics are not improved. If a limited increase in encoding complexity is considered while improving cycle characteristics, the exponent pairs (*a, b, c*) corresponding to (*P^{a}, P^{b}, P^{c}*) in the submatrix having the structure of Equation 19 may have the following combinations.

**[Table 11]**

| ***Set index** (i _{LS)}* | **(*a*, *b*)** | ***c*** |
|---|---|---|
| 0 | | 16 or 3 2 or 6 4 (or 128) |
| 1 | | 2 4 or 4 8 or 9 6 (or 192) |
| 2 | | 2 0 or 4 0 or 8 0 (or 160) |
| 3 | (*a, b*) = (0,1) | 1 4 or 28 or 5 6 (or 112) |
| 4 | | 1 8 or 3 6 or 7 2 (or 144) |
| 5 | | 22 or 44 or 88 (or 176) |
| 6 | | 2 6 or 5 2 (or 104) |
| 7 | | 30 or 60 (or 120) |

The Table 11 is merely an example, and generally, *c = t* can be determined by selecting *t* which is one of the lifting size values smaller than Zmax.

As one embodiment of the present disclosure, the *c* value may also be determined based on the largest lifting size among lifting sizes smaller than a specific reference value. To explain in detail, if the reference value is configured to 96 , the numbers 96 or less in each lifting size set in a system using lifting size sets such as those shown in [Table 3] through [Table 8], are 64 , 96, 80, 56, 72, 88, 52, and 60. Therefore, if the *c* value corresponding to the parity check matrix defined according to each lifting size set index based on the given reference value in each lifting size set is determined, the *c* value can be defined as 64, 96, 80, 56, 72, 88, 52, and 60 in order according to each lifting size set index. If the reference value is configured to 48, the c value can be defined in the same way as 32, 48, 40, 28, 36, 44, 26, and 30 in order according to each lifting size set index. For reference, when using a set of lifting sizes excluding the numbers inside ( ) in [Table 3] or [Table 8], if the i-th largest lifting size among the lifting sizes included in the set of lifting sizes where *i_{LS} =* 1 is determined as the reference value, the *c* value corresponding parity check matrix defined according to each lifting size set index is characterized by being determined as the i-th largest lifting size in each set.

Additionally, for uniformity of the encoding method, the i-th largest lifting size in each set of lifting sizes may be selected (i = 2, 3, 4, 5, 6, ...). For example, in a system using a set of lifting sizes as in [Table 3], the 5th largest numbers in each set of lifting sizes are 16, 24, 20, 14, 18, 22, 13, and 15. Therefore, if the *c* value corresponding to the parity check matrix defined according to each lifting size set index based on the 5th largest number in lifting size set is determined (i = 5), the c value can be defined as 16, 24, 20, 14, 18, 22, 13, and 15 in order according to each lifting size set index. In the same way, if the *c* value corresponding to the parity check matrix defined according to the lifting size set index based on the 4th largest number in each lifting size set is determined (i = 4), the *c* value can be defined as 32, 48, 40, 28, 36, 44, 26, and 30 in order according to the lifting size set index. In the same way, if the *c* value corresponding to the parity check matrix defined according to the lifting size set index based on the 3rd largest number in each lifting size set is determined (i = 3), the *c* value can be defined as 64, 96, 80, 56, 72, 88, 52, and 60 in order according to the lifting size set index. In the same way, the *c* value corresponding to the parity check matrix defined according to the lifting size set index based on the 2nd largest number in each lifting size set is determined (i = 2), the value *c* can be defined as 128, 192, 160, 112, 144, 176, 104, and 120 in order according to the lifting size set index.

In a system using the lifting size sets of values excluding values inside ( ) in [Table 8], the 5th largest number in each lifting size set is 32, 48, 40, 28, 36, 44, 26, 30. Therefore, if the *c* value corresponding to the parity check matrix defined according to each lifting size set index based on the 5th largest number in each lifting size set is determined (i = 5), the *c* value can be defined as 32, 48, 40, 28, 36, 44, 26, and 30 in order according to the lifting size set index. In the same way, if the *c* value corresponding to the parity check matrix defined according to the lifting size set index based on the 4th largest number in each lifting size set is determined (i = 4), the *c* value can be defined as 64, 96, 80, 56, 72, 88, 52, and 60 in order according to the lifting size set index. In the same way if the *c* value corresponding to the parity check matrix defined according to the lifting size set index based on the 3rd largest number in each lifting size set is determined (i = 3), the *c* value can be defined as 128, 192, 160, 112, 144, 176, 104, and 120 in order according to the lifting size set index. In the same way, the *c* value corresponding to the parity check matrix defined according to the lifting size set index based on the 2nd largest number in each lifting size is determined (i = 2), the *c* value can be defined as 256, 384, 320, 224, 288, 353, 208, and 240 in order according to the lifting size set index.

According to the (*P^{a}, P^{b}, P^{c}*) = (*I, P, P^{c}*) pairs shown in the Equation 19, Table 11, and corresponding embodiment, the *ϕ* matrix becomes *ϕ = I + P + P^{c},* and according to the exponent selection example 3, if the lifting size Z*ₖ* value is less than or equal to *c*, *c* ≡ 0 (mod *Zₖ*) holds true, and ultimately cycle characteristics are not improved as *P^{a} = I = P^{c},* but efficient LDPC encoding is possible by utilizing the fact that *ϕ* = *P, ϕ*⁻¹ = *P*⁻¹ holds true. In the case that the lifting size *Zₖ* value is greater than c, there exists *i* satisfying (*P^{c}*)²*^{ⁱ} = I* and this becomes (*i* ≥ 1a) *ϕ*²*^{ⁱ} = I,* and therefore, although the encoding complexity increases by utilizing the *ϕ*⁻¹ = *ϕ*^{2*ⁱ*-1} = *ϕ*^{2*ⁱ*-1} · *ϕ*^{2*ⁱ*-2} ..... *ϕ*² · *ϕ* property, efficient LDPC encoding is possible. Here, the cycle length determined by *P^{a}* and *P^{c}* increases from the existing 2*m*_{*b*1} to 2*m*_{*b*1} · *Z*/*D* = 2*m*_{*b*1} · 2*ⁱ* = 2^{*i*+1} · *m*_{*b*1}. The cycle length determined by *P^{a}* and *P^{b}* or *P^{b}* and *P^{c}* increases significantly in proportion to the *Z* value because it satisfies exponent condition 1a and exponent condition 1b.

The exponent selection examples 1, 2, and 3 are methods for selecting exponents of some circulant permutation matrices that constitute submatrix B 1020 in the parity check matrix of FIG. 10, which simultaneously consider cycle characteristic improvement and coding complexity. The exponent selection examples propose a method in which cycle characteristics are not improved when the code length is short and the lifting size is small, but the coding complexity is very low, and as the lifting size increases, the coding complexity increases slightly while the cycle characteristics are improved. Generally, since LDPC codes can be more sensitive to error floor phenomena caused by cycle characteristics as their length increases, the methods, in which cycle characteristics are further improved as the code length increases along with the lifting size, can be said to be methods that can improve error floor phenomena in accordance with the length of the LDPC code.

Of course, when the lift size is small and the code length is short, the cycle characteristics do not significantly affect the error floor phenomenon; however, even in cases where the lift size is small, methods to improve the cycle characteristics can be applied.

As an embodiment of the present disclosure, a method for improving cycle characteristics when the code length is short is described.

**Exponent selection example 4** (*i_{LS} = k*)
- *aₖ* is an arbitrary integer.
- *bₖ* is *bₖ = aₖ + sₖ,* where *sₖ* is an integer satisfying *gcd*(*sₖ, Zₖ*) *=* 1, in other words, *aₖ* and *bₖ* among the exponents corresponding to the submatrix B are integers satisfying gcd(|*aₖ - bₖ*|, *Zₖ*) *=* 1. Here gcd(*x,y*) represents the greatest common divisor of *x, y,* and *Zₖ* represents any lifting size belonging to the set of lifting size corresponding to *i_{LS} = k.* (*Zₖ = pₖ · 2^{Lₖ}, pₖ* is odd, *Lₖ* ≥ 0)
- *cₖ* is ${c}_{k} = {a}_{k} + \frac{{Z}_{k}}{{2}^{min \left(J, {L}_{k}\right)}} = {a}_{k} + {p}_{k} ⋅ {2}^{{L}_{k} - {2}^{min \left(J, {L}_{k}\right)}}$
or ${c}_{k} = \left\{\begin{matrix}{a}_{k} + {p}_{k} , & {L}_{k} < J \\ {a}_{k} + \frac{{Z}_{k}}{{2}^{J}} , & {L}_{k} \geq J\end{matrix}\left(=\left\{\begin{matrix}{a}_{k} + {p}_{k} , & {L}_{k} < J \\ {a}_{k} + {p}_{k} ⋅ {2}^{{L}_{k} - J} , & {L}_{k} \geq J\end{matrix}\right.\right)\right.$.

If the size of *Zₖ* supported by the system is always equal to or greater than *pₖ* · 2*^{J}*, it can be simply expressed as ${c}_{k} = {a}_{k} + \frac{{Z}_{k}}{{2}^{J}} \left(={a}_{k}+{p}_{k}⋅{2}^{{L}_{k} - J}\right)$*.*

The exponent selection example 4 describes a method in which each exponent of the circulant permutation matrix (*P^{a}, P^{b}, P^{c}*) is not a fixed value but is determined variably based on at least one lifting size Z. Therefore, the method proposed in this disclosure can be applied not only to the sets of lifting sizes in [Table 3] through [Table 8] but also to various other sets of lifting sizes.

If *Lₖ < J* in *Zₖ* = *pₖ · 2^{Lₖ},* it can be configured to be *cₖ = aₖ + pₖ* in the example because $\frac{{Z}_{k}}{{2}^{J}}$ is not an integer. That is, the *cₖ* value can be determined variably depending on the *Zₖ* values supported by the system and the given J value. If the *Zₖ* value supported by the system is greater than or equal to *pₖ* · 2*^{J}*, since $\frac{{Z}_{k}}{{2}^{J}}$ is always an integer, *cₖ* =it can be determined in one way as in ${a}_{k} = \frac{{Z}_{k}}{{2}^{J}}$.

The method of the exponent selection example 4 satisfies exponent condition 1a and exponent condition 1b, and whether exponent condition 2a and exponent 2b is satisfied varies depending on the lifting size *Zₖ.* For example, if the range of supported *Zₖ* values is greater than or equal to *pₖ* · 2*^{J}*, the exponent condition 2a and exponent condition 2b are satisfied, and if it is smaller than *pₖ* · 2*^{J}*, they are not satisfied.

According to the embodiment of the above exponent selection example 4, in the case of *Zₖ* ≥ *pₖ ·* 2*^{J}* (or *Lₖ* ≥ *J*)*,* the cycle length determined by *P^{a}* and *P^{c}* increases from the existing 2*m*_{*b*1} to 2^{*J*+1} · *m*_{*b*1}, and in the case of *Zₖ < pₖ* · 2*^{J}* (or *Lₖ < J*)*,* it increases to 2^{*Lₖ*+1}. *m*_{*p*1}. (In the case of *Lₖ* = 0, it does not increase.) The cycle length determined by *P^{a}* and *P^{b}* or *P^{b}* and *P^{c}* increases significantly in proportion to the *Z* value because it satisfies exponent condition 1a and exponent condition 1b.

Additionally, in the case of *Zₖ* ≥ *pₖ* · 2*^{J}* (or *Lₖ* ≥ *J*)*,* since the *ϕ* matrix is $ϕ = {P}^{{a}_{k}} + {P}^{{a}_{k} + {s}_{k}} + {P}^{{a}_{k} + \frac{Z}{{2}^{J}}} = {P}^{{a}_{k}} \left(I+{P}^{{s}_{k}}+{P}^{\frac{Z}{{2}^{J}}}\right)$*,* LDPC encoding is possible using ${ϕ}^{{2}^{J}} = {P}^{{a}_{k} ⋅ {2}^{J}} ⋅ \left(I+{P}^{{s}_{k} ⋅ {2}^{J}}+{P}^{Z}\right) = {P}^{\left({a}_{k}+{s}_{k}\right) ⋅ {2}^{J}}$
*ϕ*⁻¹ = *P*^{*-*(*aₖ+sₖ*)·2}*^{j} . ϕ*^{2*J*-1} = *P*^{*-*(*aₖ+sₖ*·2}*^{^{J}} . ϕ*^{2*^{J}*-1} . *ϕ*^{2*^{J}*-2} ..... *ϕ*² · *ϕ*. In the case of *Zₖ < pₖ* · 2*^{J}* (or *Lₖ* < *J*)*,* since the *ϕ* matrix is
*ϕ* = *P^{aₖ} + P^{aₖ+sₖ}* + *P^{aₖ+pₖ}* = *P^{aₖ}*(*I + P^{sₖ} + P^{pₖ}*), an integer *j* (*j < J*) satisfying
*ϕ*^{2*j*} = *p*^{*a_{k·}*2*j*} (*I + P*^{*s_{k·}*2}*^{j} + P^{z}*) = *P*^{(*aₖ+sₖ*)·2*^{j}*} exists, and so LDPC encoding is possible in a similar way.

The method of the exponent selection example 4 has the disadvantage that the maximum cycle length that can be improved according to the J value is fixed regardless of the lifting size Z, while there is an advantage that the cycle characteristics are improved even if the lifting size Z is small. In other words, the cycle characteristics for various lifting sizes can be improved by ensuring that at least one of the exponents of the circulant permutation matrices is determined variably based on the lifting size Z, rather than all of the indices of the circulant permutation matrices (*P^{a}, P^{b}, P^{c}*) being fixed integer values.

For convenience, as a specific example for the exponent selection example 4, *a* = 1, in other words, when configured to *P^{a}* = *P*¹, an example of exponent selection is shown below.

**Exponent selection example 5** (*i_{LS}* = *k*)
- ${a}_{k} = 1 \left({P}^{a}=P\right)$
- ${b}_{k} = 0 \left({P}^{b}=I\right)$
- *cₖ* is ${c}_{k} = 1 + \frac{{Z}_{k}}{{2}^{min \left(J, {L}_{k}\right)}} = 1 + {p}_{k} ⋅ {2}^{{L}_{k} - {2}^{min \left(J, {L}_{k}\right)}}$
or ${c}_{k} = \left\{\begin{matrix}1 + {p}_{k} , & {L}_{k} < J \\ 1 + \frac{{Z}_{k}}{{2}^{J}} , & {L}_{k} \geq J\end{matrix}\left(=\left\{\begin{matrix}1 + {p}_{k} , & {L}_{k} < J \\ 1 + {p}_{k} {2}^{{L}_{k} - J} , & {L}_{k} \geq J\end{matrix}\right.\right)\right.$.

If the *Zₖ* size supported by the system is always equal to or greater than *pₖ ·* 2*^{J}*, it can be simply expressed as ${c}_{k} = 1 + \frac{{Z}_{k}}{{2}^{J}} \left(=1+{p}_{k}⋅{2}^{{L}_{k} - J}\right)$.

In the case of *bₖ =* 0 like exponent selection example 5, exponent condition 1a and exponent condition 1b are satisfied for any *aₖ* satisfying not only *aₖ =* 1, but also gcd(*aₖ*, *Zₖ*) = 1. That is, for an integer *a* where gcd(*a*, *Zₖ*) *=* 1, a submatrix B configured such as *aₖ* = *a, bₖ = 0, cₖ =* 1 *+ pₖ* · 2^{max(*L*ₖ-*J*,0)} (or ${c}_{k} = \left\{\begin{matrix}a + {p}_{k} , & {L}_{k} < J \\ a + \frac{{Z}_{k}}{{2}^{J}} , & {L}_{k} \geq J\end{matrix}\right.$) satisfies exponent condition 1a and exponent condition 1b.

According to the method of exponent selection example 5, it becomes
*ϕ*^{2*^{J}*} = *P*^{*a·*2*^{J}*} + *I + P*^{*a·*2*^{J}*+*z*} = *I,* and efficient encoding is possible by using *ϕ*⁻¹ = *ϕ*^{2*^{J}*-1} ·
*ϕ*^{2*^{J}*-2} · ··· · *ϕ*² · *ϕ*.

For convenience, as a specific example for the exponent selection example 4, *a* = 1, in other words, when configured to *P^{a} = I,* an example of exponent selection is shown below.

**Exponent selection example 6** (*i_{LS} = k*)
- ${a}_{k} = 0 \left({P}^{a}=I\right)$
- ${b}_{k} = 1 \left({P}^{b}=P\right)$
- *cₖ* is ${c}_{k} = \frac{{Z}_{k}}{{2}^{min \left(J, {L}_{k}\right)}} = {p}_{k} ⋅ {2}^{{L}_{k} - {2}^{min \left(J, {L}_{k}\right)}}$
or ${c}_{k} = \left\{\begin{matrix}{p}_{k} , & {L}_{k} < J \\ \frac{{Z}_{k}}{{2}^{J}} , & {L}_{k} \geq J\end{matrix}=\left\{\left.\begin{matrix}{p}_{k} , & {L}_{k} < J \\ {p}_{k} ⋅ {2}^{{L}_{k} - J} , & {L}_{k} \geq J\end{matrix}\right)\right.\right.$

If the *Zₖ* size supported by the system is always equal to or greater than *pₖ ·* 2*^{J}*, it can be simply expressed as ${c}_{k} = \frac{{Z}_{k}}{{2}^{J}} \left(={p}_{k}⋅{2}^{{L}_{k} - J}\right)$.

In the case of *aₖ =* 0 like exponent selection example 6, exponent condition 1a and exponent condition 1b are satisfied for any *bₖ* satisfying not only *bₖ =* 1, but also *gcd*(*bₖ, Zₖ*) *=* 1. That is, for an integer *b* where *gcd*(*b, Zₖ*) = 1, a submatrix B configured such as *aₖ =* 0*, bₖ* = *b*, *cₖ* = *pₖ* · 2^{max(*Lₖ*-*J*,0)} (or ${c}_{k} = \left\{\begin{matrix}{p}_{k} , & {L}_{k} < J \\ \frac{{Z}_{k}}{{2}^{J}} , & {L}_{k} \geq J\end{matrix}\right.$) satisfies exponent condition 1a and exponent condition 1b.

According to the method of exponent selection example 6, it becomes ${ϕ}^{{2}^{J}} = I + {P}^{b ⋅ {2}^{J}} + {P}^{Z} = {P}^{b ⋅ {2}^{J}}$ and efficient encoding is possible by using ${ϕ}^{- 1} = {P}^{- b ⋅ {2}^{J}} ⋅ {ϕ}^{{2}^{J} - 1} = {P}^{- b ⋅ {2}^{J}} ⋅ {ϕ}^{{2}^{J - 1}} ⋅ {ϕ}^{{2}^{J - 2}} ⋅ ⋯ ⋅ {ϕ}^{2} ⋅ ϕ .$

The exponent selection method of the exponent selection example 4, the exponent selection example 5, and the exponent selection example 6 enable the cycle length to be improved to the maximum 2^{*J*+1} · *m*_{*b*1} when considering efficient encoding. If the *m*_{*b*1} value is relatively large, cycle characteristics can be sufficiently improved even if the J value is not large. Typically, the J value can be determined by considering a parameter *m*_{*b*1} value that indicates the number of rows in the core matrix part of a given parity check matrix in the system and target BLER values. For example, if the target BLER is relatively high or the *m*_{*b*1} value of core matrix is large, J = 1 or 2 may be sufficient, but if the target BLER is relatively low or the *m*_{*b*1} value of core matrix is small, it is advisable to configure J = 2, 3, 4, ... etc.

Generally, because the degree to which the performance of a code is affected by cycle characteristics varies depending on the length of the code, it is also possible to configure the J value differently depending on the lifting size. That is, at least one of the indices is determined according to the lifting size, but the *J*₁ value can be configured to be small when the lifting size is relatively small, and *J*₂ value can be configured to be large when the lifting size is relatively large (*J*₁ < *J*₂). When the J value is configured differently depending on the lifting size, the reference lifting size and appropriate *J*₁,*J*₂ value must be determined.

Various possible exponent selection methods, including the exponent selection examples 1 to 6 above, may be applied variably depending on the target BLER and/or lifting size of the system. For example, if the target BLER of the system is high, the cycle characteristics do not significantly affect the decoding performance of the code, so coding may be performed using the existing method with the highest coding efficiency even if the cycle characteristics are not improved; however, if the target BLER is low, the exponent selection methods proposed in this disclosure may be applied. Here, the highness or lowness of the target BLER can be determined relatively when there are a plurality of target BLERs applicable to the system. For example, when the first target BLER is 10⁻¹ and the second target BLER is 10⁻⁵, the first target BLER can be said to be higher than the second target BLER. If the first target BLER is 10⁻¹, the second target BLER is 10⁻⁵, and the third target BLER 10⁻⁶ (or 10⁻⁷), the first target BLER can be determined to be higher than the second target BLER and the third target BLER, and the first target BLER and the second target BLER can be determined to be higher than the third target BLER. In this way, when there are multiple target BLERs applicable to the system, the highness or lowness of the BLER is determined based on a specific BLER value, and then the exponent selection method proposed in the present disclosure can be applied variably based on this.

However, this is an embodiment of the present invention, and the exponent selection method proposed in this disclosure may be applied when the target BLER is high or regardless of the target BLER, and may be applied variably based on other factors. Additionally, since the exponent selection method described throughout this disclosure means the method of selecting the exponents of the circulant permutation matrix included in a submatrix (specifically submatrix B) of the parity check matrices, the exponent selection method of the present disclosure may be described as a method for determining a parity check matrix or a method for determining a submatrix included in a parity check matrix. Additionally, since the lifting size is closely related to the code length or TBS, all processes determined based on the lifting size among the embodiments disclosed in the present invention may be changed to a method determined based on the code length or TBS. Additionally, the lifting size *Zₖ* in the exponent selection example 1 through exponent selection example 6 is expressed as "*Zₖ = pₖ · 2^{Lₖ}, Lₖ* ≥ *0, pₖ* is odd" for convenience, but, generally, exponent selection method can be applied in the same way even if *pₖ* is not restricted to odd numbers, such as " *Zₖ = pₖ · 2^{Lₖ}, Lₖ* ≥ 0*, pₖ* is the smallest lifting size in the *k*-th lifting size set" as in [Table 7-1] or [Table 7-2].

As a specific example of the application of the J value in exponent selection example 4 through exponent selection example 6, if the system target BLER is determined to be high, the J value can be configured to be small as *J*₁, and if the system target BLER is determined to be low, the J value can be configured to be relatively large as *J*₂ (*J*₁ < *J*₂). Additionally, this method of selecting the exponent or the determination of the J value may also be made by considering the lifting size together. Generally, the reference BLER and/or lifting size can be configured as A and can be segmented to a total of (A+1) different J values. For example, if there is a first reference value, a second reference value, ..., etc., the J values can be subdivided as *J*₁ < *J*₂, *J*₁ < *J*₂ < *J*₃, ..., etc. Generally, J can also be configured to 0*,* in which case it becomes *P^{a} = P^{c}*, which refers to the existing method that allows for the simplest encoding without improving cycle characteristics.

For reference, the method for determining the target BLER in the terminal or base station can be applied in various ways depending on the system. For example, The system target BLER may be directly indicated from the higher layer signaling such as the configured RRC (radio resource control) information, the target BLER may be indirectly indicated according to the configured CQI table or MCS table, or the target BLER may be indirectly indicated according to the configured service scenario.

As an embodiment of the present disclosure, a method for improving the error floor performance of an LDPC code is proposed. In the present disclosure, when the submatrix B 1020 corresponding to the first parity bits in the first part of the parity check matrix composed of submatrix A 1010 and B 1020 in FIG. 10 is in the form of Equation 20 below, the algebraic properties that the first part of the parity check matrix must satisfy is proposed. [Equation 20] $\left[\begin{matrix}I & I \\ {P}^{a} + {P}^{b} & I\end{matrix}\right]$

The size of the submatrix B 1020 of the Equation 20 is *M*₁ × *M*₁ (or 2*Z* × 2*Z*) and corresponds to a base matrix or weight matrix of 2 × 2 size. Additionally, the first column block of submatrix B 1020 consists of one *Z* × *Z* circulant permutation matrix and one *Z* × *Z* circulant matrix in which two circulant permutation matrices are overlapped, and the second column block consists of two *Z* × *Z* identity matrices (or circulant permutation matrices). For convenience in this disclosure, the second column blocks are represented only when they consist of identity matrices, but generally, they do not need to be limited thereto. Additionally, matrices that can be transformed into a submatrix B 1020 of the form above through an appropriate invertible transform process can be considered as algebraically identical matrices.

Since *ϕ* matrix of *Z* × *Z* size used in the encoding process in the case of the submatrix B 1020 of Equation 20 becomes *I + P^{a} + P^{b},* efficient encoding becomes possible depending on the selection of the exponent, as in the previous embodiments. However, in order to remove a cycle of length 4 from the structure of the Equation 20, the conditions such *a, b*(mod *Z*) > 0, $a ≢ b \left(mod\frac{Z}{2}\right)$ (or $a - b ≢ \frac{Z}{2} \left(mod Z\right)$) must be satisfied. Since cycles of length 4 reduce the decoding performance of the code, it is desirable to remove them. Hereunder, an exponent selection method is described that enables efficient encoding by improving the cycle characteristics of the submatrix of Equation 20 and increasing the complexity of *ϕ*⁻¹ matrix-related operations required in the LDPC encoding process to a reasonable level. In the embodiments of the present disclosure, it is assumed that the condition for removing a cycle of length 4 is basically satisfied.

If, for a parity check matrix of a QC LDPC code, the lifting size *Z* is *Z = p ·* 2*^{L},* (where *p* is an odd number and *L* is an integer greater than or equal to 0), then the indices (or circular shift values) 0*, a, b* of the circulant permutation matrices constituting the first column block of the submatrix B 1020 are distinct integers and satisfy at least some or all of the following conditions:
**Exponent condition 3:** *a* is the smallest number among the divisors of *Z* that the greatest common divisor with the lifting size *Z* is 1 or greater than 1. (i.e., *a* is coprime to *Z* or has the least divisor of *Z* greater than 1 as its greatest common divisor.
**Exponent condition 4:** $\left|a-b\right| ≢ \frac{Z}{i} \left(mod Z\right)$ for an integer, *i*, that is 2 ≤ *i* < *l*₁
**Exponent condition 5:** 0 ≤ *i* < *l*₂ for an integer, *i*
   $i ⋅ a ≢ \left(i+1\right) b \left(mod Z\right) and \left(i+1\right) a ≢ i ⋅ b \left(mod Z\right)$
**Exponent condition** 6: $b = \frac{q ⋅ Z}{{2}^{J}} \left(0<J\leq L\right.$*, q* is an odd number)

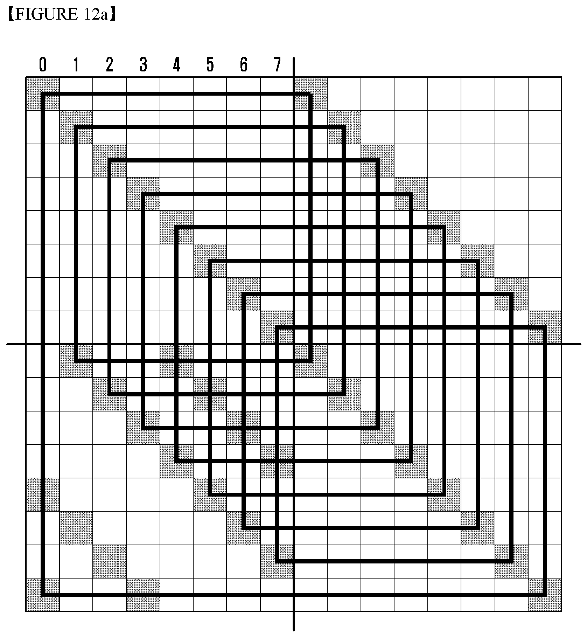

According to the exponent condition 3, if *a* is coprime to *Z*, the length of the cycle on the Tanner graph determined by $\left[\begin{matrix}I & I \\ {P}^{a} & I\end{matrix}\right]$ in the matrix of Equation 20 becomes 4*Z*. A simple example of the cycle characteristics according to exponent condition 3 is shown in FIG. 12a.

FIG. 12a is an example diagram illustrating cycle characteristics in a submatrix of a parity check matrix for an LDPC code satisfying the characteristics proposed in the present disclosure.

FIG. 12a illustrates a cycle of length 32 as an example of the cycle characteristics induced by $\left[\begin{matrix}I & I \\ {P}^{1} & I\end{matrix}\right]$ in $\left[\begin{matrix}I & I \\ {P}^{1} + {P}^{4} & I\end{matrix}\right]$ in the case of *Z* = 8. Generally, if the greatest common divisor of *a* and *Z* is *D,* the cycle length becomes 4*Z*/*D.* Therefore, as the *Z* value increases, the length of the cycle increases. If only the cycle characteristics are considered, it is desirable for *a* to be coprime to *Z*, but depending on the situation, an exponent can be selected so that other conditions may cause the greatest common divisor D to be small (to become the least divisor of Z greater than 1). For example, if a cannot satisfy the characteristic that it is coprime to Z, it is desirable to select an exponent so that the greatest common divisor *D* becomes small.

The exponent condition 4 is a condition for improving the characteristics of cycles on the Tanner graph determined by $\left[\begin{matrix}∗ & ∗ \\ {P}^{a} + {P}^{b} & ∗\end{matrix}\right]$ in the matrix of Equation 20. When exponent condition 4 is satisfied, since all cycles with a length less than or equal to 2(*l*₁ - 1) are removed from the structure, only cycles with a length greater than or equal to 2*l*₁ exist.

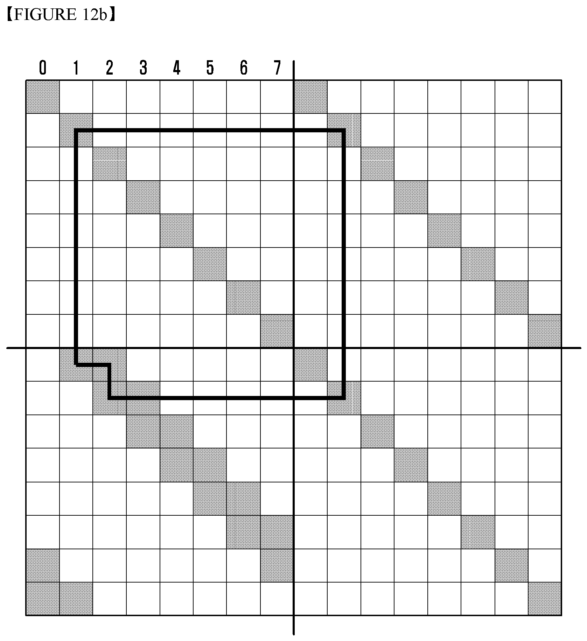

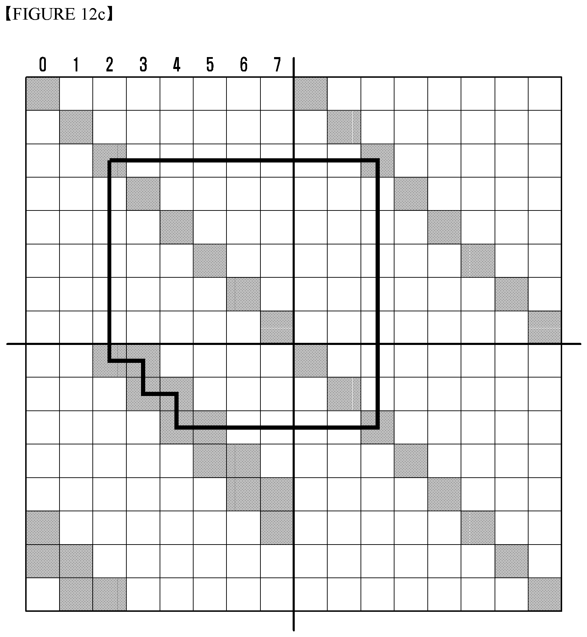

The exponent condition 5 is a condition for improving the characteristics of cycles on the Tanner graph determined by $\left[\begin{matrix}I & I \\ {P}^{a} + {P}^{b} & I\end{matrix}\right]$ in the matrix of Equation 20. When exponent condition 5 is satisfied, since all cycles with a length less than or equal to (4 + 2*i*) for an integer *i* which is 0 ≤ *i* < *l*₂ in the structure are removed, only cycles with a length greater than or equal to (4 + 2*l*₂) exist. A simple example of the cycle characteristics under exponent condition 5 is shown in FIG. 12b and FIG. 12c.

FIG. 12b is an example diagram illustrating cycle characteristics in a submatrix of a parity check matrix for an LDPC code satisfying the characteristics proposed in the present disclosure.

Specifically, FIG. 12b shows the cycle characteristics induced by $\left[\begin{matrix}I & I \\ {P}^{1} + {P}^{2} & I\end{matrix}\right]$ in the case where *Z* = 8. For *i* = 0
$0 ⋅ 1 ≢ 1 ⋅ 2 \left(mod 8\right) and 1 ⋅ 1 ≢ 0 ⋅ 2 \left(mod 8\right)$
is satisfied, but since this holds 2 · 1 ≡ 1 · 2 (mod 8) for *i* = 1, cycles of length 4 are eliminated, but cycles of length 6 can exist.

FIG. 12c is an example diagram illustrating cycle characteristics in a submatrix of a parity check matrix for an LDPC code satisfying the characteristics proposed in the present disclosure.

Specifically, FIG. 12c shows the cycle characteristics induced by $\left[\begin{matrix}I & I \\ {P}^{2} + {P}^{3} & I\end{matrix}\right]$ in the case where *Z* = 8. For *i* = 0 $0 ⋅ 2 ≢ 1 ⋅ 3 \left(mod 8\right) and 1 ⋅ 2 ≢ 0 ⋅ 3 \left(mod 8\right) ,$ $1 ⋅ 2 ≢ 2 ⋅ 3 \left(mod 8\right) and 2 ⋅ 2 ≢ 1 ⋅ 3 \left(mod 8\right)$ are satisfied, but since this holds 3 · 2 ≡ 2 · 3 (mod 8) for *i =* 2, cycles of length 4 and 6 are eliminated, but cycles of length 8 can exist.

The exponent condition 6 is a condition for simplifying the *ϕ*⁻¹ matrix as much as possible for efficient LDPC encoding. The *ϕ* matrix required in the process of performing LDPC encoding based on a parity check matrix containing the submatrix B of Equation 20 can be defined as *ϕ = I + P^{a}* + *P^{b}*. At this time, if it is configured as $b = \frac{Z}{{2}^{J}}$, since it becomes $ϕ = I + {P}^{a} + {P}^{\frac{qZ}{{2}^{J}}}$ *,* it becomes ${ϕ}^{{2}^{J}} = I + {P}^{{2}^{J} a} + {p}^{q ⋅ z} = {p}^{{2}^{J} a}$. Therefore, relatively efficient encoding is possible using a *ϕ*⁻¹ matrix. In the exponent condition 6, if the lifting size Zis odd, the *b* value cannot be an integer, so this embodiment can be applied only when all lifting sizes are even. That is, in *Z = p ·* 2*^{L}*, *L* is applicable only when it is an integer greater than or equal to 1. For example, as in [Table 9], the minimum lifting size in each set of lifting size sets must all be even.

**[Table 9]**

| ***Set index** (i _{LS)}* | ***Set of lifting sizes (Z)*** |
|---|---|
| 0 | {(8,) 16, 32, 64, 128, 256 (, 512)} |
| 1 | {(12,) 24, 48, 96, 192, 384 (, 768)} |
| 2 | {20, 40, 80, 160, 320 (, 640} } |
| 3 | {28, 56, 112, 224, 448(, 896)} |
| 4 | {(18,) 36, 72, 144, 288 (, 576)} |
| 5 | {(22,) 44, 88, 176, 352 (, 704}} |
| 6 | {(26,} 52, 104, 208, 416(, 832)} |
| 7 | {(30,) 60, 120, 240, 480(, 960)} |

As an embodiment of the present disclosure, a more specific example of constituting the submatrix B 1020 of FIG. 10 using the exponent conditions is described.

First, a communication or broadcasting system is considered in which a set of lifting sizes is defined as shown in Tables 3 through 9, such as 5G, and only the lifting sizes included in the set of lifting sizes can be applied. Additionally, a separate parity check matrix or exponent matrix may be defined for each set of lifting sizes. That is, in the case of Tables 3 through 9, a parity check matrix or exponent matrix, etc., may be defined for a total of 8 set indices.

In the submatrix B based on Equation 20, *a* and *b* are determined as follows. For convenience, this disclosure describes only the case where *a* = 1, but the value of *a* may be selected from among values that are coprime to *Z* or have a small greatest common divisor. Generally, it is expressed as *bₖ* because the exponent *b* values for the submatrix B of the parity check matrix corresponding to *i_{LS} = k* (*k* = 0, 1, 2, ...) may all be different. Additionally, *Zₖ* represents any lifting size belonging to the set of lifting size corresponding to *i_{LS} = k,* and can be expressed in the form of *Zₖ = pₖ ·* 2*^{Lₖ}* (*pₖ* is odd number or minimum lifting size, *Lₖ* ≥ 1).

**Exponent selection example 7** (*i_{LS} = k*)
- $\left[\begin{matrix}I & I \\ {P}^{1} + {P}^{{b}_{k}} & I\end{matrix}\right]$
- ${b}_{k} = \frac{{Z}_{k}}{{2}^{min \left(J, {L}_{k}\right)}} = {p}_{k} ⋅ {2}^{{L}_{k} - min \left(J, {L}_{k}\right)}$
(when $\frac{{Z}_{k}}{{2}^{min \left(J, {L}_{k}\right)}} > 1$, that is, *Zₖ* > 2^{min(*J*,*Lₖ*)} must be satisfied.)

In the exponent selection example 7, if the Z*ₖ* sizes of supported by the system are all multiples of 2*^{J}*, it can be simply expressed as ${b}_{k} = \frac{{Z}_{k}}{{2}^{J}} = {p}_{k} ⋅ {2}^{{L}_{k} - J}$ (when *Zₖ >* 2*^{J}* ). In this case, it means that the minimum lifting size in each set of lifting sizes as in [Table 9] is a multiple of 2*^{J}*. For example, when J is configured to 2, it means that the minimum lifting size is a multiple of 4, and when J is configured to 3, it means that the minimum lifting size is a multiple of 8. In the case of the form of *Zₖ* = 2*^{Lₖ}* like the sets of lifting sizes of *i_{LS} =* 0 in Table 3 through Table 9, the minimum lifting size to satisfy *Zₖ* > 2*^{J}* condition is 2^{*J*+1}. For example, when J is configured to 2 and 3, the minimum lifting sizes are 8 and 16, respectively. For convenience of explanation, this disclosure describes only cases where the minimum lifting size in each set of lifting sizes is a multiple of 2*^{J}*. Generally, even in cases where the minimum lifting size in each set of lifting sizes is a multiple of 2, but it is not a multiple of 2*^{J}*, the exponent selection method described in the present disclosure may be applied.

According to the exponent selection example 7, exponent condition 3 and exponent condition 6 hold.

Additionally, since $\left|a-b\right| = \frac{{Z}_{k}}{{2}^{J}} - 1$, according to exponent condition 4, there is no cycle of length 4 induced by $\left[\begin{matrix}∗ & ∗ \\ {P}^{a} + {P}^{b} & ∗\end{matrix}\right]$. If *Zₖ* does not have a prime factor of 3 (i.e., if *pₖ* is not an odd number that is a multiple of 3), since $\frac{Z}{3}$ cannot be an integer, a cycle of length 6 does not exist. If *Zₖ* has a prime factor of 3, since it means that it is the *Zₖ* = 3 · 2*^{Lₖ}* form, $\frac{Z}{3} - \left|a-b\right| = {2}^{{L}_{k}} - \left(3⋅{2}^{{L}_{k} - J}-1\right) = {2}^{{L}_{k} - J} \left({2}^{J}-3\right) + 1$. If J=2 and *Lₖ* ≥ 2, then $\frac{Z}{3} - \left|a-b\right| = {2}^{{L}_{k} - 2} + 1$ , and, 2^{*Lₖ*-2} + 1 ≢ 0 (mod 3 · 2*^{Lₖ}*), there is no cycle of length 6 for all lifting sizes. Additionally, if J=2, since $\left|a-b\right| ≢ \frac{{Z}_{k}}{4} \left(mod {Z}_{k}\right)$ is satisfied from $\left|a-b\right| = \frac{{Z}_{k}}{4} - 1$, there is no cycle of length 8 derived by $\left[\begin{matrix}∗ & ∗ \\ {P}^{a} + {P}^{b} & ∗\end{matrix}\right]$ either. Therefore, in the case where J is chosen as an integer greater than or equal to 2, the length of the cycle induced by $\left[\begin{matrix}∗ & ∗ \\ {P}^{a} + {P}^{b} & ∗\end{matrix}\right]$ is at least 10. As the value of J increases, the cycle characteristics can be further improved, but since this increases encoding complexity and imposes greater constraints on the lifting size, it is desirable to select an appropriate J value according to the system's requirements.

According to exponent selection example 7, $i ≢ \left(i+1\right) \frac{{Z}_{k}}{{2}^{J}} \left(mod {Z}_{k}\right)$ satisfies from 0 to relatively large integers *i,* but since it satisfies $\left(i+1\right) ≡ i ⋅ \frac{{Z}_{k}}{{2}^{J}} \left(mod {Z}_{k}\right)$ in the cases of *i* = 1 and 5*Zₖ* = 2^{*J*+1}, according to exponent condition 5, only cycles which have a length of 4 among the cycles induced by $\left[\begin{matrix}I & I \\ {P}^{1} + {P}^{{b}_{k}} & I\end{matrix}\right]$ as shown in FIG. 12b and FIG. 12c are removed. Therefore, to remove longer cycles, it is desirable to configure J to an integer greater than or equal to 2 and apply the exponent selection method to lifting sizes satisfying *Lₖ* ≥ *J* + 2. For example, in the case where J = 2, *Lₖ* = *J* + 2, $i ⋅ {b}_{k} - \left(i+1\right) = i ⋅ \frac{{Z}_{k}}{{2}^{2}} - \left(i+1\right) = i ⋅ {p}_{k} ⋅ {2}^{2} - \left(i+1\right) = \left(4{p}_{k}-1\right) i - 1$
- $i = 1 ; \left(4{p}_{k}-1\right) i - 1 = 4 {p}_{k} - 2 ≢ 0 \left(mod {p}_{k}{2}^{4}\right)$
- $i = 2 ; \left(4{p}_{k}-1\right) i - 1 = {2}^{3} {p}_{k} - 3 ≢ 0 \left(mod {p}_{k}{2}^{4}\right)$
- $i = 3 ; \left(4{p}_{k}-1\right) i - 1 = 12 {p}_{k} - 4 ≢ 0 \left(mod {p}_{k}{2}^{4}\right)$
- $i = 4 ; \left(4{p}_{k}-1\right) i - 1 = {2}^{4} {p}_{k} - 5 ≢ 0 \left(mod {p}_{k}{2}^{4}\right)$
can hold. Therefore, according to exponent condition 5, it can be seen that all cycles with a length of 12 or less among the cycles that can be induced by $\left[\begin{matrix}I & I \\ {P}^{1} + {P}^{{b}_{k}} & I\end{matrix}\right]$ as shown in FIG. 12b and FIG. 12c are removed.

Considering the characteristics of exponent condition 3 through exponent condition 6 and the exponent selection example 7, a method of selecting an exponent based on the minimum lifting size of a given set of lifting sizes can also be applied as follows.

**Exponent selection example 8** (*i_{LS} = k*)
- $\left[\begin{matrix}I & I \\ {P}^{1} + {P}^{{b}_{k}} & I\end{matrix}\right]$
- Lifting size set = {*pₖ*2^{*L*₁}, *pₖ*2^{*L*₂}, ... *, pₖ*2^{*L*ₘₐₓ}} corresponding to *i_{LS} = k*

However, *L*ₘᵢₙ = *L*₁ < *L*₂ < ... < *L*ₘₐₓ and *pₖ* does not necessarily have to be an odd number.
- ${b}_{k} = {p}_{k} ⋅ {2}^{{L}_{1} - J} , J \geq 2$

The exponent selection example 8 means a method of selecting an exponent based on the minimum lifting size *Z*ₘᵢₙ included in each lifting size set when a lifting size set is given. According to exponent selection example 8, it can also be expressed as ${b}_{k} = \frac{{Z}_{min}}{{2}^{J}} \left(={p}_{k}⋅{2}^{{L}_{min} - J}\right)$. As a specific example, in a system applying lifting size sets excluding the numbers in parentheses in [Table 9], when J = 2 is configured, the *bₖ* values for each set index are sequentially 4, 6, 5, 7, 9, 11, 13, and 15. If J = 3 is configured and the minimum lifting sizes of each lifting size set are 32, 48, 40, 56, 72, 88, 104, and 120, respectively, the *bₖ* values for each set index are sequentially 4, 6, 5, 7, 9, 11, 13, and 15.

As one embodiment of the present disclosure, the *bₖ* value may also be determined based on lifting sizes larger than a specific standard value. Specifically, let's assume that J = 2 and the reference value is configured to 64. If the exponent selection example 8 is applied only when the *bₖ* value is greater than or equal to the reference value, the *bₖ* values for each set index are sequentially 16, 24, 20, 28, 36, 44, 52, and 60. As another embodiment, the case is assumed where J = 3 and the reference value is configured to 64. If the exponent selection example 8 is applied only when the *bₖ* value is greater than or equal to the reference value, the *bₖ* values for each set index are sequentially 8, 12, 10, 14, 18, 22, 26, and 30. Meanwhile, since the method of selecting an exponent described throughout this disclosure means a method of selecting an exponent of a circulant permutation matrix included in a submatrix of a parity check matrix, the exponent selection method of the present disclosure may be described as a method for determining a parity check matrix or a method for determining a submatrix included in a parity check matrix.

The disclosures so far have proposed a method to improve error floor by improving cycle characteristics, while limiting the algebraic structure of FIG. 10 B 1020 to increase encoding complexity somewhat.

As an embodiment of the present disclosure, a method is proposed to limit conditions on the size of the base matrix or parity check matrix to improve the error floor performance of LDPC codes.

First, the base matrix or parity check matrix used in the terminal and base station has the structure of the base matrix or parity check matrix as shown in FIG. 10, and the sizes are *m_{b}* × *n_{b}* and *N* × (*M*₁ + *M*₂) respectively. Here *n_{b} = N*/*Z, m_{b}* = (*M*₁ *+ M*₂)/*Z,* and the number of columns corresponding to the information word bits is *k_{b}* = *K*/*Z = n_{b}* - *m_{b}* based on the base matrix and has a *K = N -* (*M*₁ *+ M*₂) *= N - M* value based on the criteria of the parity check matrix.

The size of the base matrix corresponding to the first part of the parity check matrix composed of submatrices A 1010 and B 1020 can be expressed as *m*_{*b*1} × (*k_{b}* + *m*_{*b*1}), *m*_{*b*1} *= M*₁/*Z.* In the present invention, the first part of the parity check matrix composed of submatrices A 1010 and B 1020 is referred to as the core matrix of the parity check matrix, and the base matrices corresponding to the submatrices A 1010 and B 1020 can be called the core matrices of the entire base matrix. Additionally, for convenience, they may also be called the core parity check matrix or the core base matrix, respectively.

In this embodiment, for convenience, only the case where the core parity check matrix or core base matrix corresponds to submatrices A 1010 and B 1020 is described, but generally, some rows corresponding to the submatrices C 1040, D 1050, and E 1060 may be included in the core parity check matrix or core base matrix. Here, the size of the submatrix C 1040 is *m*_{*b*2}*Z* × *k_{b}Z,* the size of submatrix D 1050 is *m*_{*b*2}*Z* × *m*_{*b*1}*Z*, and the size of submatrix E 1060 is *m*_{*b*2}*Z* × *m*_{*b*2}*Z*. The second part or single parity check extension part of the parity check matrix composed of matrices C 1040, D 1050 and E 1060 corresponds to a submatrix of $\left(\frac{{M}_{2}}{Z}\right) \times \left(\frac{K + {M}_{1} + {M}_{2}}{Z}\right)$ or *m*_{*b*2} × (*k_{b}* + *m*_{*b*1} + *m*_{*b*2}) = *m*_{*b*2} × *n_{b}* size in the entire base matrix or weight matrix of *m_{b}* × *n_{b}* size.

The decoding performance of the belief-propagation (BP) decoding algorithm commonly used for decoding LDPC codes is affected by the algebraic structures such as the cycle characteristics on the graph of the LDPC code and trapping sets. Additionally, the BP decoding performance of LDPC codes is also affected by the weights and weight distribution of the parity check matrix, and under the condition that there are no serious problems with the cycle characteristics on the graph, as the weight of the parity check matrix increases, the encoding gain in the high BLER region decreases slightly, while the error floor phenomenon is improved. When the received signal-to-noise ratio (SNR) in the system is low, the encoding gain tends to decrease, but as the SNR increases, the error correction capability improves rapidly, and there is a characteristic of error floor occurring in the lower BLER region. In particular, since the error probability of the bits is effectively improved as the BP decoding process is repeated when the column weight is at least 2, the cycle characteristics, weight, and weight distribution of the first part of the parity check matrix corresponding to the core matrix of the base matrix that does not include a column with a degree of 1 have a significant impact on the error floor phenomenon.

When designing a system with a relatively low target BLER as described above, it is desirable to improve the cycle and weight characteristics of the parity check matrix to improve LDPC decoding performance for any decoding method using the BP algorithm, and in particular, improving the cycle and weight characteristics of the core matrix is important to obtain low error floor characteristics.

The cycle and weight characteristics of a core matrix are closely related to the number of rows *m*_{*b*1} in the core matrix. For example, the weight of each column of the core matrix not only cannot be larger than *m*_{*b*1}, but also the cycle characteristics deteriorate if *m*_{*b*1} is very small, since a large number of entries 1 are inevitably distributed in a dense manner as the weight of the core matrix increases. Ultimately, when applying BP decoding, the error floor phenomenon cannot be effectively improved because the cycle characteristics deteriorate when the weight increases slightly to improve the error floor phenomenon. Conversely, reducing weight improves cycle characteristics, but, because of the low weight, it becomes difficult to improve the error floor phenomenon.

Therefore, when a terminal or base station device needs to support different BLERs depending on the situation, it is desirable to perform LDPC encoding and decoding based on base matrices with different numbers of rows in the core matrix. As a specific example, in the case of supporting the first target BLER and the second target BLER which is lower than the first target BLER in the terminal or base station, there may be a characteristic that the number ${m}_{b 1}^{\left(1\right)}$ of rows of the core matrix in the first base matrix related to the first target BLER is smaller than the number ${m}_{b 1}^{\left(2\right)}$ of rows of the core matrix in the second base matrix related to the second target BLER. Here, the number of columns corresponding to the information word bits and the total size are identical as *k_{b}* and *m_{b}* × *n_{b}*, respectively, and, in the first base matrix and the second base matrix, the lifting size can also be used for encoding and decoding in the same way.

The first Target BLER and the second target BLER that is lower than the first target BLER can be determined in a communication system according to different service scenarios or system configurations. Additionally, the first target BLER and the second target BLER that is lower than the first target BLER can be determined according to the used communication system if a single terminal and base station support different communication systems, such as 5G communication system and 6G communication. In other words, LDPC encoding and decoding can also be performed by selecting one of the first base matrix and the second base matrix according to the service scenario or system configurations in a communication system supported by a single terminal or base station, and LDPC encoding and decoding can also be performed by selecting one of the first base matrix and the second base matrix according to the communication system used among multiple different communication systems supported by a single terminal or base station.

The LDPC encoding and decoding may also be performed using one of the first base matrix and the second base matrix considering the backward compatibility with existing systems, decoding information throughput, stable error floor performance, etc., without a specific target BLER configured according to each of the service scenarios or communication systems, and LDPC encoding and decoding may also be performed using only the second base matrix which has superior error floor characteristic without the first base matrix. As a specific example, in a new system like the 6G system in the future, LDPC encoding and decoding for at least one of the first base matrix, the second base matrix, and the corresponding parity check matrices may be supported, but there may exist systems that support LDPC encoding and decoding for the second base matrix and the corresponding parity check matrix without the first base matrix. Here, the first base matrix may be at least one of the base matrices *M***(H_{BG2})** and *M*(**H_{BG1}**) used in existing 5G systems.

In this way, according to various implementation methods of a terminal or base station, the usage of the first base matrix and the second base matrix can be applied differently, and the possible application methods can be summarized as follows.

### (1) Conditions of base matrices or parity check matrices

The conditions of the base matrices or parity check matrices may include at least one of the following conditions.
- Each base matrix has a structure like that of FIG. 10.
- The size of the first base matrix and the second base matrix is the same as *m_{b}* × *n_{b}*. Therefore, if the lifting size is *Z,* it means that the size of the parity check matrix is *m_{b}Z* × *n_{b}Z.*
- The size of the core matrix of the first base matrix corresponding to submatrices A 1010 and B 1020 in FIG. 10 is ${m}_{b 1}^{\left(1\right)} \times \left({k}_{b}+{m}_{b 1}^{\left(1\right)}\right)$*,* the size of the core matrix of the second base matrix is ${m}_{b 1}^{\left(2\right)} \times \left({k}_{b}+{m}_{b 1}^{\left(2\right)}\right)$*,* and ${m}_{b 1}^{\left(1\right)} < {m}_{b 1}^{\left(2\right)}$*.* Therefore, the core matrix of the second base matrix has more rows and columns, respectively, than the first base matrix by matrix by $\left({m}_{b 1}^{\left(2\right)}-{m}_{b 1}^{\left(1\right)}\right) > 0$ . Additionally, if the lifting size is Z, it means that the size of the first part of the parity check matrix is ${m}_{b 1}^{\left(1\right)} Z \times \left({k}_{b}+{m}_{b 1}^{\left(1\right)}\right) Z$and ${m}_{b 1}^{\left(2\right)} Z \times \left({k}_{b}+{m}_{b 1}^{\left(2\right)}\right) Z$ respectively.

According to the above conditions, it may mean that the number of columns and rows corresponding to the parity bit with a degree of 1 in the second base matrix is fewer than the first base matrix by $\left({m}_{b 1}^{\left(2\right)}-{m}_{b 1}^{\left(1\right)}\right)$*.*

### (2) Method of applying the base matrices or parity check matrices

(2-1)
   In the terminal or base station, when supporting the first target BLER and the second target BLER, the terminal or base station may perform encoding and decoding based on the first base matrix related to the first target BLER and the corresponding parity check matrix. Additionally, the terminal or base station may perform encoding and decoding based on the second base matrix related to the second target BLER and the corresponding parity check matrix. Here, the first target BLER is higher than the second target BLER.
(2-2)
   When supporting two or more different systems in the terminal or base station, in the first system, the first base matrix can be used, and in the second system, the second base matrix can be used. At least one of the target BLERs of the second system may be smaller than the smallest value among the target BLERs of the first system. Additionally, the average value of the log10 values of the largest and smallest values among the target BLERs of the second system is smaller than the average of the log10 values of the largest and smallest values among the target BLERs of the first system. Additionally, the first system and the second system which are different each other may be supported through a single integrated modem or processor, or it may also be supported through different modems or processors.

### (3) Indication method

(3-1)
   As an operation corresponding to (2-1) ,
   - In the terminal or base station, a separate higher layer signaling in the system may be used to distinguish the first target BLER and the second target BLER.
   - For example, the target BLER can be distinguished by a CQI table or MCS table configured by higher layer signaling. That is, depending on the target BLER to be achieved, a CQI table or an MCS table can be configured, and according to the corresponding configurations, it can be decided which of the first base matrix and the second base matrix is used to perform LDPC encoding or decoding. Additionally, further considering not only the configured CQI table or MCS table, but also the CQI index or MCS index indicated according to the table, the base matrix (or the parity check matrix to be used among the first parity check matrix or the second parity check matrix) to use among the first base matrix and the second base matrix can be determined.
(3-2)
   As an operation corresponding to (2-2),
   - In the terminal or base station, the first system and the second system can also be distinguished through an appropriate preamble signal or higher layer signaling, and accordingly, it is possible to determine which one of the first base matrix or the second base matrix is used to perform LDPC encoding and decoding. In the case where the first system and the second system are independent and unrelated to each other, the base matrix (or parity check matrix) to be used by the terminal can be appropriately determined using only the appropriate preamble signal without higher layer signaling.
   - If the first system is used, the LDPC encoding or decoding based on the first base matrix is performed, and when the second system is used, the LDPC encoding or decoding based on the second base matrix can be performed. However, even if the second system is used, the LDPC encoding and decoding may be performed by determining one of the first base matrix or the second base matrix according to the configuration of the CQI table or MCS table in combination with the method of (3-1). In a similar manner, even if the second system is used, depending on the version of the second system, one of the first base matrix or the second base matrix can be determined.
   - In the above examples, the first system may be a 5G system, and the second may be a 6G system.
(3-3)
   The maximum value of the first target BLER in (2) may be 10⁻¹, the minimum value of the first target BLER may be 10⁻⁵, and the minimum value of the second target BLER may be a value smaller than 10⁻⁵, for example, 10⁻⁶ or 10⁻⁷ or a value smaller than that. The base matrix to be used can be determined by directly specifying such a target BLER, but the base matrix to be used can also be determined by utilizing various configurations or service scenarios of the system corresponding to the target BLER.

### (4) Examples of base matrices

- The size of the first base matrix and the second base matrix may be *m_{b}* = 42, *n_{b}* = 52. Additionally, it may be *m_{b}* = 46, *n_{b}* = 58. Additionally, the first base matrix may be at least one of the base matrices *M***(H_{BG2})** and *M*(**H_{BG1}**) used in the existing 5G systems.
- The size of the core matrix of the first base matrix in (1) may correspond to ${m}_{b 1}^{\left(1\right)} = 4$, *k_{b}* = 10 or ${m}_{b 1}^{\left(1\right)} = 4$, *k_{b} =* 22. Additionally, the size of the core matrix of the second base matrix may correspond to a value greater than 4, such as ${m}_{b 1}^{\left(2\right)} = 5$ or ${m}_{b 1}^{\left(2\right)} = 6$. In other words, it means that if ${m}_{b 1}^{\left(2\right)} = 5$, the size of the second base matrix is 5 × (*k_{b}* + 5), and if ${m}_{b 1}^{\left(2\right)} = 6$, the size of the second base matrix is 6 × (*k_{b}* + 6).
- The second base matrix may also have additional constraints on the column weights of the core matrix. For example, the core matrix of *M***(H_{BG2})** has three columns with a column weight of 2 and the information word bits corresponding to such columns with a column weight of 2 have a disadvantage that decoding convergence is slow in performing BP decoding. Therefore, in situations where high data throughput is required, it is desirable to exclude columns with a degree of 2 from the core matrix as much as possible. Therefore, depending on the target BLER of the system, it may be desirable to limit the weight of the columns corresponding to the information word bits in the core matrix to 3 or more, or limit the number of columns with a weight of 2 to one or less. Additionally, the number of columns with a degree of 4 in the core matrix of the second base matrix may be configured to be equal to or greater than the number of columns with a degree of 4 in the core matrix of the first base matrix.
- In the case where the base matrix is at least one of the base matrices *M***(H_{BG2})** and *M*(**H_{BG1}**) used in the 5G system, the second base matrix may have the same size as *M*(**H_{BG1}**) and the size of the core matrix may also be the same, and may have the same size as *M*(**H_{BG2}**), and the size of the core matrix may also be the same. However, it does not satisfy this at the same time, and the second base matrix has the total size being the same for at least one of *M*(**H_{BG1}**) or *M*(**H_{BG2}**), but the size of the core matrix must be different.
- For example, since *M***(H_{BG2})** that is used with relatively small TBS and low code rates in 5G system is more sensitive to error floor phenomenon, in situations where new systems such as 6G systems or relatively lower target BLER are to be supported, the second base matrix corresponding to *M*(**H_{BG1}**) should have the same size and a core matrix of the same size, but the second base matrix corresponding to *M***(H_{BG2})** may have the same size as *M*(**H_{BG2}**), but may include a larger core matrix.

In the (4) examples of base matrices, if the base matrix is *M*(**H_{BG2}**), in the 5G system, the number of columns of the base matrix or column blocks of the parity check matrix that perform zero padding (or filler bit insertion) in LDPC encoding can be determined according to the range of the number of input bits (B) (i.e., The number of columns of the base matrix or column blocks of the parity check matrix that perform zero padding may change depending on the range of the number of input bits.) As explained earlier, if *B* > 640, LDPC encoding is performed using *K_{b}* = 10 columns or column blocks, if 560 < *B* ≤ 640, LDPC encoding is performed using *K_{b}* = 9 columns or column blocks, and appropriate filler bits are inserted into the LDPC information word bits corresponding to the remaining 1 column or column block. (Basically, the bit-0 value is inserted. However, the embodiments of the present invention are not limited thereto, and based on the bits agreed upon by the transmitting and receiving devices, a non-zero bit may be used as a filler bit.) Additionally, if 192 < *B* ≤ 560, LDPC encoding is performed using *K_{b}* = 8 columns or column blocks, and appropriate filler bits are inserted into the LDPC information word bits corresponding to the remaining two columns or column blocks, and if *B* ≤ 192, LDPC encoding is performed using *K_{b}* = 6 columns or column blocks, and appropriate filler bits are inserted into the LDPC information word bits corresponding to the remaining 4 columns or column blocks.

In this way, when the columns or column blocks used are variable because of the application of a shortening method based on the length of the input bits, the remaining columns or column blocks containing filler bits do not affect the performance of the code; therefore, it is identical to changing the size of the base matrix or the corresponding parity check matrix. Additionally, the weight distribution (or degree distribution) of the columns and rows of the base matrix and the corresponding parity check matrix can also be considered as modified. Accordingly, in this way, when performing LDPC encoding by variably using columns of the base matrix or corresponding block of columns of the parity check matrix according to the length of the input bits, it is desirable to appropriately arrange the weight of each column by considering the columns used. In the present disclosure, arranging the weights of columns may mean determining the weight (or degree) of each column of the base matrix and determining each column (or determining the base matrix) based on the weight of each column, considering the arrangement of the weights of columns of the base matrix. Additionally, arranging the weights of the columns may mean determining the weight (or degree) of each column block of the parity check matrix and on configuring each column block (or determining the parity check matrix) based on this, considering the arrangement of the weights of column blocks of the parity check matrix. In particular, in the (4) examples of base matrices, to achieve a lower target BLER like the second base matrix, the weight arrangement has to be made considering the shortening method since the performance of the sign is more affected by the weight distribution.

For example, it is explained based on the (4) examples of base matrices.
- In the case where there is one column with a degree of 4 or higher in the core matrix of the second base matrix, columns with a degree of 4 or higher in the core matrix of the second base matrix are arranged in columns corresponding to the punctured information word bits. That is, if there is one column with a degree of 4 or higher in the core matrix of the second base matrix, one of the columns corresponding to the punctured bits may have a degree of 4 or higher. When puncturing is applied starting from the information word bit corresponding to the preceding column, a column with a degree of 4 or higher is arranged in one of the columns from the 0th column to the (*K*_{*b*,min} - 1)-th column.
- In the case where there are two columns with a degree of 4 or higher in the core matrix of the second base matrix, at least one of the columns with a degree of 4 or higher is arranged in the column corresponding to the punctured information word bits. That is, if there are two columns with a degree of 4 or higher in the core matrix of the second base matrix, at least one of the columns corresponding to the punctured bits may have a degree of 4 or higher. Additionally, if the number of columns corresponding to the punctured information word bits is two or more, both of the two columns with a degree of 4 may correspond to the punctured information word bits. Generally, when puncturing is applied starting from the information word bits corresponding to the preceding column, two columns with a degree of 4 or higher are arranged among the columns from the Oth column to the (*K*_{*b*,min} - 1)-th column, or one column with a degree of 4 or higher is arranged among the columns from the 0th column to the (*K*_{*b*,min} - 1)-th column, and one column with a degree of 4 or higher is arranged in the *K*_{*b*,min}-th column.
- In the case where there are three or more columns with a degree of 4 or higher in the core matrix of the second base matrix, at least one of the columns with a degree of 4 or higher is arranged in a column corresponding to the punctured information word bits, and at least another one is arranged in the *K*_{*b*,min}-th column. That is, if there are three or more columns with a degree of 4 or higher in the core matrix of the second base matrix, the degree of one of the columns corresponding to the punctured is 4 or more, and the degree of the *K*_{*b*,min}-th column can be 4. Additionally, if the number of columns corresponding to the punctured information word bits is two or more, at least two of the columns with the degree of 4 can correspond to the punctured information word bits, and at least one can correspond to the *K*_{*b*,min}-th column.

*K*_{*b*,min} means the lowest value among the number *K_{b}* of columns of the base matrix actually used in the LDPC encoding process, and, in the case of a 5G system, *K*_{*b*,min} = 6 since the smallest *K_{b}* value is 6 when applying LDPC encoding using *M*(**H_{BG2}**).

As a specific example, when the first base matrix is *M*(**H_{BG2}**), the core matrix of the second base matrix consists of ${m}_{b 1}^{\left(2\right)}$ rows and $\left(10+{m}_{b 1}^{\left(2\right)}\right)$ columns, and if there are 3 columns with a weight of 4 or more, all or some of the following conditions may be satisfied:
- The submatrix corresponding to parity is Equation 15 (e.g., if ${m}_{b 1}^{\left(2\right)} = 5$, *M*(*B*₃))
- At least the weight of the 0th, 1st, and 6th columns is 4 or more,
- The remaining columns corresponding to the information word bit (or input bit) each have a weight of at least 3 or and less than the maximum column weight.
- The 0th column and 1st column can correspond to a punctured information word bit. In this case at least one of the 0th column and 1st column has a weight less than $t {m}_{b 1}^{\left(2\right)}$. (e.g., if ${m}_{b 1}^{\left(2\right)} = 5$ , at least one column weight is 4.)
- If the weights of the 0th and 1st columns are less than $e {m}_{b 1}^{\left(2\right)}$, the position of the row in each column where entry 1 is not present, i.e., at least one of the row positions containing entry 0 can be different. (e.g., if ${m}_{b 1}^{\left(2\right)} = 5$, the weight of both columns is 4, and the rows containing entry 0 are different.)

In this invention, a method and device for performing encoding and decoding based on a base matrix or a parity check matrix satisfying various algebraic properties are proposed. For convenience of explanation, embodiments of the invention based on a base matrix or parity check matrix satisfying only some of the algebraic properties may be described depending on the case. Although algebraic properties may each be satisfied separately, algebraic properties that are not contradictory to one another can be appropriately combined and satisfied simultaneously.

Meanwhile, in the present invention, for convenience, embodiments of the invention may be described by selecting either a base matrix or a parity check matrix, but generally, since the base matrix and the parity check matrix have a corresponding relationship based on the lifting size or exponent matrix, etc., the columns or rows of the base matrix can be considered as column blocks or row blocks of the parity check matrix even without special mention, and so the present invention can be implemented similarly. All embodiments of the present invention are not limited to either a base matrix or a parity check matrix.

Meanwhile, the electronic device according to the various embodiments disclosed in this document may be a device of various forms. The electronic device may include, for example, at least one of a portable communication device (e.g., a smartphone), a TV, a computer device, a portable multimedia device, a portable medical device, a camera, a wearable device, or a consumer electronics device. The electronic device according to the embodiments of this document is not limited to the aforementioned devices. Furthermore, the operation of transmitting a frame may not only mean transmission through a wireless channel, but may also mean that various electronic devices include an interface for outputting a frame for transmission. For example, a processor may output a frame to an RF front end for transmission through a bus interface. Similarly, the operation of receiving a frame from another device may mean that various electronic devices have an interface for obtaining a frame received from another device. For example, it means that a processor may receive or obtain a frame from an RF front end through a bus interface.

The various embodiments of this document and the terms used therein are not intended to limit the technology described in this document to specific embodiments and should be understood to include various modifications, equivalents, and/or substitutions of the embodiments.

With reference to the description of the drawings, similar reference numerals may be used for similar components. A singular expression may include a plural expression unless the context clearly indicates otherwise. In this document, expressions such as "A or B," "at least one of A and/or B," "A, B or C," or "at least one of A, B and/or C" may include all possible combinations of items listed together. Expressions such as "first," "second," "primary," or "secondary" may modify the components, regardless of order or importance, and are used only to distinguish one component from another and do not limit the components. When it is stated that one (e.g., the first) component is "(functionally or communicationally) connected" or "connected" to another (e.g., the second) component, the one component may be directly connected to the other component or connected through another component (e.g., the third component).

Additionally, the word " determining " can encompass various meanings, and depending on the situation, it may refer to various operations such as identifying, calculating or computing, processing, deriving, investigating, estimating, looking up (e.g., from a database or other data structure), and ascertaining.

Meanwhile, the order of description in the drawings illustrating the method of the present disclosure does not necessarily correspond to the order of execution, and the order of execution may be changed or executed in parallel.

Alternatively, drawings describing the method of the present disclosure may omit some components and include only some components to the extent that the essence of the present disclosure is not impaired.

Additionally, the method of the present disclosure may be implemented by combining some or all of the contents included in each embodiment to the extent that it does not impair the essence of the invention.

Although the present disclosure has been described with reference to preferred embodiments, various changes and modifications may be presented to those skilled in the art. Such changes and modifications are intended to be included in the appended claims. Furthermore, it is obvious that operations represented by different blocks for convenience of explanation in the operation flowcharts of the present disclosure may be implemented by being separated into multiple processors in an actual system, or may be implemented by being integrated into a single processor.

## Claims

1. A method performed by a transmitter in a communication system, the method comprising:
determining a number of input bits;
determining a base matrix;
determining a lifting size (Z) based on at least one of the number of the input bits or the base matrix;
determining a parity check matrix based on at least one of the base matrix or the lifting size (Z); and
determining an encoded bit by performing encoding based on the parity check matrix and the input bits,
wherein the base matrix is one of a plurality of base matrices, the plurality of base matrices having a same size,
wherein a first base matrix and a second base matrix included in the plurality of base matrices have core matrices of different sizes, and
wherein the core matrices include a submatrix corresponding to the input bits and a matrix corresponding to a part of parity bits in the base matrix.

2. The method of claim 1, wherein a column weight of the submatrix corresponding to the input bits in the second base matrix is 3 or more, and
wherein a number of columns with a weight of 4 in the second base matrix is greater than a number of columns with a weight of 4 in the first base matrix.

3. The method of claim 1, wherein the base matrix is identified based on a configured channel quality indicator (CQI) or modulation and coding scheme (MCS) table.

4. The method of claim 1, wherein the first base matrix is related to a first target block error rate (BLER) and the second base matrix is related to a second target BLER, and
wherein the second target BLER is smaller than the first target BLER.

5. A method performed by a receiver in a communication system, the method comprising:
receiving a signal corresponding to input bits;
demodulating the signal to determine values for decoding;
identifying a number of the input bits based on the signal;
determining a base matrix;
determining a lifting size (Z) based on at least one of the number of the input bits or the base matrix;
determining a parity check matrix based on at least one of the base matrix or the lifting size (Z); and
performing decoding based on the parity check matrix and the values,
wherein the base matrix is one of a plurality of base matrices, the plurality of base matrices having a same size,
wherein a first base matrix and a second base matrix included in the plurality of base matrices have core matrices of different sizes, and
wherein the core matrices include a submatrix corresponding to the input bits and a matrix corresponding to a part of the parity bits in the base matrix.

6. The method of claim 5, wherein a column weight of the submatrix corresponding to the input bits in the second base matrix is 3 or more, and
wherein a number of columns with a weight of 4 in the second base matrix is greater than a number of columns with a weight of 4 in the first base matrix.

7. The method of claim 5, wherein the base matrix is identified based on a configured channel quality indicator (CQI) or modulation and coding scheme (MCS) table.

8. The method of claim 5, wherein the first base matrix is related to a first target block error rate (BLER) and the second base matrix is related to a second target BLER, and
wherein the second target BLER is smaller than the first target BLER.

9. A transmitter in a communication system comprising:
a transceiver; and
a controller coupled with the transceiver and configured to:
determine the number of input bits;
determine a base matrix;
determine a lifting size (Z) based on at least one of a number of the input bits or the base matrix;
determine a parity check matrix based on at least one of the base matrix or the lifting size (Z); and
determine an encoded bit by performing encoding based on the parity check matrix and the input bits,
wherein the base matrix is one of a plurality of base matrices, the plurality of base matrices having a same size,
wherein a first base matrix and a second base matrix included in the plurality of base matrices have core matrices of different sizes, and
wherein the core matrices include a submatrix corresponding to the input bits and a matrix corresponding to a part of parity bits in the base matrix.

10. The transmitter of claim 9, wherein a column weight of the submatrix corresponding to the input bits in the second base matrix is 3 or more, and
wherein a number of columns with a weight of 4 in the second base matrix is greater than a number of columns with a weight of 4 in the first base matrix.

11. The transmitter of claim 9, wherein the base matrix is identified based on a configured channel quality indicator (CQI) or modulation and coding scheme (MCS) table.

12. The transmitter of claim 9, wherein the first base matrix is related to a first target block error rate (BLER) and the second base matrix is related to a second target BLER, and
wherein the second target BLER is smaller than the first target BLER.

13. A receiver in a communication system comprising:
a transceiver; and
a controller coupled with the transceiver and configured to:
receive a signal corresponding to input bits;
demodulate the signal to determine values for decoding;
identify a number of the input bits based on the signal;
determine a base matrix;
determine a lifting size (Z) based on at least one of the number of the input bits or the base matrix;
determine a parity check matrix based on at least one of the base matrix or the lifting size (Z); and
perform decoding based on the parity check matrix and the values,
wherein the base matrix is one of a plurality of base matrices, the plurality of base matrices having a same size,
wherein a first base matrix and a second matrix included in the multiple elementary matrices have include core matrices of different sizes, and
wherein the core matrices include a submatrix corresponding to the input bits and a matrix corresponding to a part of parity bits in the base matrix.

14. The receiver of claim 13, wherein a column weight of the submatrix corresponding to the input bits in the second base matrix is 3 or more, and
wherein a number of columns with a weight of 4 in the second base matrix is greater than a number of columns with a weight of 4 in the first base matrix.

15. The receiver of claim 13,
wherein the base matrix is identified based on a configured channel quality indicator (CQI) or modulation and coding scheme (MCS) table,
wherein the first base matrix is related to a first target block error rate (BLER) and the second base matrix is related to a second target BLER, and
wherein the second target BLER is smaller than the first target BLER.
